(19) **Europäisches Patentamt**
**European Patent Office**
**Office européen des brevets**

(11) **EP 1 671 525 B1**

(12) **EUROPEAN PATENT SPECIFICATION**

(45) Date of publication and mention
of the grant of the patent:
**24.01.2007 Bulletin 2007/04**

(51) Int Cl.:
***H05K 13/04*** *(2006.01)*

(21) Application number: **05750066.2**

(22) Date of filing: **02.06.2005**

(86) International application number:
**PCT/JP2005/010530**

(87) International publication number:
**WO 2005/120147 (15.12.2005 Gazette 2005/50)**

(54) **COMPONENT MOUNTING METHOD AND APPARATUS**

VERFAHREN UND VORRICHTUNG ZUM MONTIEREN VON BAUELEMENTEN

PROCEDE ET APPAREIL DE MONTAGE D'UN COMPOSANT

(84) Designated Contracting States:
**DE GB**

(30) Priority: **03.06.2004 JP 2004165976**

(43) Date of publication of application:
**21.06.2006 Bulletin 2006/25**

(73) Proprietor: **Matsushita Electric Industrial Co., Ltd.
Osaka
571-8501 (JP)**

(72) Inventors:
• **OKUDA, Osamu
c/oMatsushita El. Ind.Co.Ltd.Int.Prop
Chuo-ku, Osaka-shi, Osaka 540-6319 (JP)**

• **KAWASE, Takeyuki
c/oMatsushita El. Ind. Co.Ltd
Chuo-ku, Osaka-shi, Osaka 540-6319 (JP)**
• **YOSHIDOMI, Kazuyuki
c/o Matsushita Electr.Ind.Co.
Chuo-ku, Osaka-shi, Osaka 540-6319 (JP)**

(74) Representative: **Eisenführ, Speiser & Partner
Patentanwälte Rechtsanwälte
Postfach 10 60 78
28060 Bremen (DE)**

(56) References cited:
**EP-A- 1 077 594          EP-A- 1 182 919
US-A- 4 494 139**

**EP 1 671 525 B1**

## Description

Technical Field

The present invention relates to a component mounting apparatus and method for placing components on a board with high accuracy.

Background Art

Although component mounting process including suction of a component by the nozzle of a component suction head, recognition of the sucked component by the camera and its mounting onto the board has been carried out by moving the component suction head in the X- and Y-directions by driving an X-Y robot, it has not been able to achieve high mounting accuracy due to the distortion of the component mounting apparatus itself no matter how the component recognition accuracy has been improved. The distortion of the component mounting apparatus itself is attributed to poor machining accuracy or poor assembling accuracy of the X-Y robot of the component mounting apparatus.

The impossibility of high-accuracy component placing onto the board during the placing process due to the distortion of the X-Y robot attributed to the factors of machining accuracy and the like as described above is analyzed more concretely. Displacements in the X- and Y-directions are caused by yawing (rolling in the direction perpendicular to a traveling direction of the head moving on the X-Y robot), pitching (poor linearity in a transfer pathway of the head), and rolling (pitching in a direction at an angle of ninety degrees different from the above rolling) and the like of the guide members of the X-Y robot.

Accordingly, the component mounting has conventionally been made accurate by carrying out camera calibration, recognizing a reference mark of a reference board by means of a board recognition camera fixed to the X-Y robot, calculating an amount of displacement between a target position where the reference mark should properly be located and an actual position of the reference mark, and carrying out correction by adding the calculated amount of displacement as a placing position offset value to each position (see, e.g., Japanese unexamined patent publication No. H06-126671).

In this case, the camera calibration of the board recognition camera is to make the board recognition camera recognize a jig whose position coordinate is previously known in order to detect any installation error of the board recognition camera, calculate the installation error of the board recognition camera by a difference between the position coordinate calculated on the basis of the recognition result and the previously known position coordinate, and carry out positional correction. During the camera calibration, not only the positional correction of the board recognition camera but also the positional correction of the component recognition camera and the nozzle are additionally carried out.

Disclosure of Invention

However, according to the method of carrying out the correction in each of the positions, it is possible that the position of the reference board is displaced by, for example, almost 1 mm between the first-time positioning and the second-time positioning of the reference board. Furthermore, the reference board is very expensive since the reference board is required to have very high accuracy, and its positioning is achieved by stopping the reference board in an approximate X-direction position without using a board stopper from the viewpoint of damage prevention. In addition, a board conveyor, which has a gap slightly smaller than 1 mm also in the Y-direction for conveyance, therefore has no reproducibility of the positioning of the reference board in the board holding section of the component mounting apparatus, and this becomes a factor that reduces the mounting accuracy.

As described above, the amounts of relative displacement between the individual positions of the robot are determined by positioning the reference board to an approximate position and thereafter recognizing the reference mark of the reference board, and the amounts of displacement are reflected in the placing position data of the mounting board during the mounting process. This therefore is a factor that reduces the mounting accuracy.

On the other hand, in a case where the correction is carried out by recognizing a glass reference board provided with a grid in a matrix form, it is conceivable to measure the grid of the reference board on the assumption that the reference board is accurately positioned, and then use the measured data as a correction value without modification.

However, it is very difficult to accurately hold the reference board on the micrometer order in the board holding section as described above, and a special positioning device for accurately holding the board in the board holding section of the component mounting apparatus is necessitated. Eventually, if the measured data is used directly as a correction value, it is impossible to accurately correct the X-Y robot unless the reference board is accurately positioned with high reproducibility.

If the component placing region of the component mounting apparatus is totally taken into consideration, there has been an issue that the mounting accuracy cannot be secured due to insufficient correction only by the conventional camera calibration and the placing position offset value for the reason that the distortion of the head operation due to

**2**

the distortion of the X-Y robot changes depending on the position where positioning is carried out.

Even if the reference board itself on which a lot of reference marks are arranged at equal intervals in a grid form is manufactured with high precision, it is impossible to provide an absolute parallel between the X-Y robot and the reference board. Furthermore, the absolute perpendicularity of the X-Y robot itself is not guaranteed so that there is no reference. Therefore, since the X-Y robot, on which the head having the board recognition camera for recognizing the reference board placed in the component placing region of the component mounting apparatus has been supported, is distorted, it has been impossible to use the position obtained from the reference board as a reference, and it has been unsuccessful to improve the placing accuracy (e.g., to increase the robot accuracy to about $\pm2$ $\mu$m or increase the total accuracy of the mounting apparatus to about $\pm20$ $\mu$m).

Accordingly, the present invention is made to solve the aforementioned issues and has an object to provide a component mounting method and apparatus capable of improving the mounting accuracy by obtaining an optimum offset value in accordance with the size of the board.

In order to achieve the above object, the present invention has the following constitution.

According to a first aspect of the present invention, there is provided a component mounting method for placing a component held by a component holding member included in a component placing head, which is movable relative to a board holding device, onto a component placing position of a component mounting board held by the board holding device, the method comprising:

recognizing respective reference marks arranged at specified intervals on a reference-mark-recognizing reference board by a first board recognition device included in the component placing head, with the reference board held on the board holding device and positioned in a component placing region, and recognizing respective differed-reference marks each of which is correspondingly different from each of the foregoing reference marks and positioned individually within a visual field of a second board recognition device provided at a position different from a position of the first board recognition device by the second board recognition device during the recognition of the reference marks by the first board recognition device, and then determining position coordinates of the reference marks and the differed-reference marks, respectively;

calculating inclination of the component placing head with respect to a direction for the movement of the head at each recognition position for the reference marks and the differed-reference marks, by using the individual position coordinates of the reference marks recognized by the first board recognition device and the individual position coordinates of the differed-reference marks recognized by the second board recognition device;

determining a position correction value of the component holding member from the inclination of the component placing head; and

performing a correction of a movement position of the component holding member toward the component placing position by using the position correction value, and then placing the component onto the component placing position at the corrected movement position.

According to a second aspect of the present invention, there is provided the component mounting method as defined in the first aspect, further comprising:

recognizing at least two of the reference marks on the reference-mark-recognizing reference board by the first board recognition device after positioning the reference board in the component placing region, and then determining position coordinates of the two reference marks; and

calculating an inclination of positioning posture for the reference board by NC coordinates of the two reference marks and the position coordinates;

wherein, in the step of calculation for the inclination of the component placing head, inclination of the head at each recognition position is calculated by using the individual position coordinates of the reference marks recognized by the first board recognition device, the individual position coordinates of the differed-reference marks recognized by the second board recognition device, and the inclination of positioning posture of the reference board.

According to a third aspect of the present invention, there is provided the component mounting method as defined in the first aspect, further comprising:

determining differences between the position coordinates of the individual reference marks recognized by the first board recognition device and the individual NC coordinates as correction values, respectively;

obtaining respective NC coordinates of at least two board-reference-position calculation marks of the component mounting board;

selecting respective reference marks located near to the two board-reference-position calculation marks from among the recognized reference marks;

determining respective offset values at the individual selected reference marks by performing coordinate transformation of the selected position coordinates of the reference marks so that the correction values for the selected reference marks become zero or substantially zero;

recognizing at least two board-reference-position calculation marks on the component mounting board by the first board recognition device, and then determining respective position coordinates of the two board-reference-position calculation marks, in a state that the component mounting board is held on the board holding device and positioned in the component placing region instead of the reference-mark-recognizing reference board;

correcting the NC coordinates of the two board-reference-position calculation marks based on the position coordinates of the two board-reference-position calculation marks, respectively; and

correcting position coordinates of the component placing position based on the offset value of the reference mark nearest to the first component recognition device and the position correction value of the component holding member derived from the inclination of the component placing head at the position of the relevant reference mark when the component held by the component holding member of the component placing head is positioned above each component placing position of the component mounting board, and then performing the placing of the component to the each component placing position based on the corrected position coordinates of the component placing position.

According to a fourth aspect of the present invention, there is provided the component mounting method as defined in the third aspect, wherein

in the step of determining offset values at the individual selected reference marks located near to the two board-reference-position calculation marks, by performing coordinate transformation of the position coordinates of the selected reference marks so that the correction values for the selected reference marks become zero or substantially zero,

the offset values at the individual selected reference marks located near to the two board-reference-position calculation marks are determined, by performing coordinate transformation of .the position coordinates of the selected reference marks by rotating and shifting a graph derived from interconnection of the selected reference marks so that the correction values for the selected reference marks become zero or substantially zero.

According to a fifth aspect of the present invention, there is provided the component mounting method as defined in the third aspect, wherein

in the step of determining offset values at the individual selected reference marks located near to the two board-reference-position calculation marks, by performing coordinate transformation of the position coordinates of the selected reference marks so that the correction values for the selected reference marks become zero or substantially zero,

the offset values at the individual selected reference marks located near to the two board-reference-position calculation marks are determined, by calculating correction values of at least one direction out of an X-direction and a Y-direction orthogonal to the X-direction of the board holding device from the selected reference marks, by determining an inclination of the reference board, and by performing coordinate transformation of the position coordinates of the selected reference marks so that the correction values for the selected reference marks become zero or substantially zero.

According to a sixth aspect of the present invention, there is provided the component mounting method as defined in any one of the first aspect to fifth aspect, further comprising:

recognizing at least two of the reference marks of the reference-mark-recognizing reference board by the first board recognition device after the positioning of the reference board to the board holding device, and then determining position coordinates of the two reference marks,

determining differences between NC coordinates of the two reference marks and the position coordinates thereof, and performing coordinate transformation of the NC coordinates of the individual reference marks on the reference board by rotating or shifting a graph derived from interconnection of the two reference marks so that the individual differences become zero or substantially zero;

thereafter, performing alignment between the first board recognition device and the individual reference marks based on the coordinate-transformed NC coordinates of the individual reference marks, and then determining position coordinates of the individual reference marks and the individual differed-reference marks by performing recognition of the individual marks; and

determining an inclination of the component placing head at each recognition positions with respect to the movement direction by calculating differences between the position coordinates of the individual reference marks and the individual differed-reference marks.

According to a seventh aspect of the present invention, there is provided a component mounting apparatus for mounting a component held by a component holding member included in a component placing head, which is movable relative to a board holding device, onto a component placing position of a component mounting board held by the board holding device, the apparatus comprising:

a first board recognition device and a second board recognition device both of which are included in the component placing head and both of which serve for, with a reference-mark-recognizing reference board held on the board holding device and positioned in a component placing region, recognizing position coordinates of reference marks arranged at specified intervals on the reference board; and

a control unit for determining position coordinates of the reference marks recognized by the first board recognition device from recognition results of the reference marks, determining position coordinates of respective differed-reference marks recognized by the second board recognition device from recognition results of the differed-reference marks at positions of the component placing head where the recognition of the reference mark by the first board recognition device is performed, calculating inclination of the component placing head with respect to a direction of the movement of the head at each recognition position by using the individual position coordinates of the reference marks recognized by the first board recognition device and the individual position coordinates of the differed-reference marks recognized by the second board recognition device, determining a position correction value of the component holding member included in the head from the calculated inclination of the head, performing correction of a movement position of the component holding member to the component placing position by using the determined position correction value, and then placing the component onto the component placing position at the corrected movement position.

According to an eight aspect of the present invention, there is provided the component mounting apparatus as defined in the seventh aspect, wherein the component placing head includes a plurality of component holding members arranged between the first board recognition device and the second board recognition device.

According to a ninth aspect of the present invention, there is provided the component mounting apparatus as defined in the eight aspect, wherein

the first board recognition device and the second board recognition device are operable to obtain image-picking ups of the reference marks on the reference-mark-recognizing reference board along optical axes thereof so that position coordinates of the reference mark can be recognized, and

in the component placing head, the optical axis of the first board recognition device, the optical axis of the second board recognition device, and up/down optical axes of the individual component holding members are arrayed in a generally identical straight line.

According to a tenth aspect of the present invention, there is provided the component mounting apparatus as defined in the seventh aspect, further comprising:

an X-Y robot for moving the component placing head back and forth along an X-axis direction or a Y-axis direction, these directions being ones extending roughly along a surface of the component mounting board held by the component holding member and generally orthogonal to each other,

wherein an inclination of the component placing head includes an inclination of posture of the component placing head with respect to the X-axis direction or the Y-axis direction caused by movement of the component placing head along the X-axis direction or the Y-axis direction by the X-Y robot.

According to an eleventh aspect of the present invention, there is provided the component mounting apparatus as defined in the seventh, wherein

after positioning of the reference-mark-recognizing reference board to the board holding device, the control unit is operable to perform operations for recognizing at least two of the reference marks of the reference board by the first board recognition device to determine position coordinates of the two reference marks, calculating an inclination of positioning posture of the reference board by NC coordinates of the two reference marks and the position coordinates, and calculating inclination of the head at each recognition position by using the individual position coordinates of the reference marks recognized by the first board recognition device, the individual position coordinates of the differed-reference marks recognized by the second board recognition device, and the inclination of positioning posture of the reference board.

According to a twelfth aspect of the present invention, there is provided the component mounting apparatus as defined in the seventh, wherein

the control unit is operable to perform operations for determining differences between position coordinates of the individual reference marks recognized by the first board recognition device and the individual NC coordinates as correction values, obtaining NC coordinates of at least two board-reference-position calculation marks of the component mounting board; selecting reference marks located near to the two board-reference-position calculation marks from among the recognized reference marks, determining respective offset values at the individual selected reference marks by performing coordinate transformation of the position coordinates of the selected reference marks so that the correction values for the selected reference marks become zero or substantially zero; recognizing the at least two board-reference-position calculation marks of the component mounting board by the first board recognition device, to determine respective position coordinates of the two board-reference-position calculation marks, in a state that the component mounting board is held on the board holding device and positioned in the component placing region instead of the reference-mark-recognizing reference board, correcting the NC coordinates of the two board-reference-position calculation marks based on the position coordinates of the two board-reference-position calculation marks, and correcting position coordinates of the component placing position based on the offset value of the reference mark nearest to the first component recognition device and the position correction value of the component holding member derived from the inclination of the component placing head at the position of the relevant reference mark when the component held by the component holding member of the component placing head is positioned above each component mounting position of the component mounting board, and then performing the placing of the component to the component placing position based on the corrected position coordinates of the component placing position.

According to a thirteenth aspect of the present invention, there is provided the component mounting apparatus as defined in any one of the seventh aspect to twelfth aspect, wherein

the control unit is operable to perform operations for recognizing at least two of the reference marks of the reference-mark-recognizing reference board by the first board recognition device to determine position coordinates of the two reference marks after the positioning of the reference board to the board holding device, determining differences between NC coordinates of the two reference marks and the position coordinates thereof, performing coordinate transformation of the NC coordinates of the individual reference marks on the reference board by rotating or shifting a graph derived from interconnection of the two reference marks so that the individual differences become zero or substantially zero, performing alignment between the first board recognition device and the individual reference marks based on the coordinate-transformed NC coordinates of the individual reference marks and performing recognition of the individual reference marks and their correspondingly differed-reference marks to determine the position coordinates thereof, and determining differences between the position coordinates of the individual reference marks and the correspondingly differed-reference marks, thereby an inclination of the component placing head at each of the recognition positions with respect to the movement direction is calculated.

According to the present invention, with respect to displacement of the component holding member due to an inclination of the component placing head, position coordinates of a reference mark and another reference mark (differed-reference mark which is correspondingly different from the foregoing reference mark) on the reference-mark-recognizing reference board are recognized with the use of two recognition devices, the first board recognition device and the second board recognition device, making it possible to calculate an inclination amount of the component placing head and correct the displacement by using the calculated inclination amount. Therefore, correction operation for displacement due to an inclination of the component placing head can be carried out, so that high-accuracy component mounting can be achieved.

Also, since it becomes possible to correct any displacement due to such an inclination of the component placing head, for example, an inclination due to the machining accuracy of the supporting guide member (e.g., linear guide) of a head moving device (the X-Y robot) for moving the component placing head, high mounting position accuracy can be obtained in the component mounting without increasing the machining accuracy of such supporting guide members. Thus, the component mounting apparatus capable of obtaining high mounting position accuracy can be reduced in manufacturing cost, so that low cost and high accuracy can be satisfied at the same time.

Further, in the process of calculating the inclination of the component placing head from the result of the generally simultaneous recognition of position coordinates of the reference mark and the other reference mark by the first board recognition device and the second board recognition device as described above, an actual inclination of the component placing head can reliably be calculated without displacement involved in the reference-mark-recognizing reference board by taking into account the displacement (parallel deviation and inclination) of the position for the positioning of the reference-mark-recognizing reference board on which the individual reference marks are formed.

Furthermore, by performing correction of a displacement amount due to distortion of operation of the X-Y robot in addition to the above-described correction of a displacement amount due to an inclination of the component placing head, positioning of even higher accuracy can be achieved. That is, in a state in which the reference-mark-recognizing reference board is held on the board holding device and positioned in the component placing region, the position coordinates of the reference marks arranged at regular intervals on the reference board held by the board holding device to obtain the position coordinates of the recognized reference marks, and the differences between the NC coordinates and the position coordinates of the reference marks are obtained as correction values. The NC (Numerical Control) coordinates of the position coordinates of at least two board-reference-position calculation marks of the component mounting board are obtained, and the reference marks located near to the two board-reference-position calculation marks are extracted from among the recognized reference marks. The position coordinates of the extracted reference marks are subjected to coordinate transformation so that the correction values of the extracted reference marks become zero or substantially zero, and the offset values of the respective reference marks are obtained. Subsequently, in the state in which the component mounting board is held by the board holding device and positioned in the component placing region in place of the reference-mark-recognizing reference board, at least two board-reference-position calculation marks of the component mounting board held by the board holding device are recognized to obtain the position coordinates of the recognized two board-reference-position calculation marks, and the NC coordinates of the two board-reference-position calculation marks are corrected based on the position coordinates of the obtained two board-reference-position calculation marks. When the component held by the component placing head is positioned above each component placing position of the component mounting board, the position coordinate of the component placing position is corrected on the basis of the offset value of the reference mark located nearest to the recognition device provided for the component placing head, and thereafter, the component is placed in the component placing position based on the position coordinate of the corrected component placing position. Consequently, the reference marks arranged at regular intervals on the reference-mark-recognizing reference board are recognized, and numerical values for the correction of the position coordinates of each area corresponding to the board size are determined as offset values based on the recognition results. The corresponding offset values of the movement positions of the component placing head are to be used during the placing position correction, the mark recognition and correction, the placing position offset value measurement operation or any one of those operations. As a result, the deviation factor due to the distortion of the X-Y robot operation is absorbed, and the optimum offset values corresponding to the size of the board are obtained, allowing the highly accurate placing (e.g., placing under the conditions of the positioning accuracy on the $\pm 0.005$ mm level in the mounting stage) to be achieved.

Moreover, by reflecting the corresponding offset values of the movement positions of the component placing head as the numerical values for the correction also in recognition of the reference mark, the deviation factor due to the distortion of the X-Y robot operation is absorbed, and the optimum offset values corresponding to the size of the board are obtained, allowing the placing to be achieved with higher accuracy.

Brief Description of Drawings

These and other objects and features of the present invention will become apparent from the following description taken in conjunction with preferred embodiments of the invention with reference to the accompanying drawings, in which:

Fig. 1 is a plan view of a component mounting apparatus for implementing a component mounting method according to a first embodiment of the present invention;

Fig. 2 is a front view of the component mounting apparatus shown in Fig. 1;

Fig. 3 is a right side view of the component mounting apparatus shown in Fig. 1;

Fig. 4 is a conceptual diagram of a chassis and an X-Y robot included in the component mounting apparatus shown in Fig. 1;

Fig. 5 is a front view of a component placing head of the X-axis robot included in the component mounting apparatus shown in Fig. 1;

Fig. 6 is a block diagram showing the relation between the constituents of the component mounting apparatus shown in Fig. 1 and a control unit;

Fig. 7 is an explanatory view showing the relation between the distortion of the X-axis robot and the component placing head for explaining the fact that the positioning accuracy of the component placing head is largely influenced by the distortion of the X-Y robot;

Fig. 8 is an explanatory view showing the relation between the distortion of the Y-axis robot and the component placing head for explaining the fact that the positioning accuracy of the component placing head is largely influenced by the distortion of the X-Y robot;

Fig. 9 is an explanatory view for explaining the concept of an offset value of the component mounting method according to the first embodiment of the present invention;

Fig. 10 is a plan view showing a concrete example of a glass board used in the component mounting method according to the first embodiment of the present invention;

Fig. 11 is a flow chart showing a procedure for obtaining and using the offset value of the component mounting method according to the first embodiment of the present invention;

Fig. 12 is a plan view showing reference marks on the glass board used in the component mounting method according to the first embodiment of the present invention;

Fig. 13 is an explanatory view for explaining how to recognize the reference marks on the glass board used in the component mounting method according to the first embodiment of the present invention;

Fig. 14 is an explanatory view showing the fact that reference marks are recognized in positions displaced from center positions $O_1$, $O_2$ in a visual field of a board recognition camera in the component mounting method according to the first embodiment of the present invention;

Fig. 15 is an explanatory view showing results when two board-reference-position calculation marks are recognized in the component mounting method according to the first embodiment of the present invention;

Fig. 16 is a graph in which the vertical axis represents the amount of displacement and the horizontal axis represents the position in the X-direction, the upper graphic line represents $\Delta X$, i.e., a displacement in the X-direction, and the lower graphic line represents ∆Y, i.e., a displacement in the Y-direction;

Fig. 17 is an explanatory view showing a state in which the reference mark position is displaced in the X-direction and the Y-direction from the center position of a rectangular visual field region located at the proper position;

Fig. 18 is a graph showing a state in which a placing position is relocated through coordinate transformation by rotating and shifting the graph so that the correction values of the reference marks located in the vicinity of two board-reference-position calculation marks on a comparatively small board to be subjected to mounting becomes zero or substantially zero;

Fig. 19 is a plan view showing the two board-reference-position calculation marks on the comparatively small board to be subjected to mounting of Fig. 18;

Fig. 20 is a graph showing a state in which the placing position is relocated through coordinate transformation by rotating and shifting the graph so that the correction values of the reference marks located in the vicinity of two board-reference-position calculation marks on a comparatively large board to be subjected to mounting becomes zero or substantially zero;

Fig. 21 is a plan view showing the two board-reference-position calculation marks on the comparatively large board to be subjected to mounting of Fig. 20;

Fig. 22 is an explanatory view showing reference marks on the glass board, the marks being located nearest to the board-reference-position calculation marks of the board to be subjected to mounting;

Fig. 23 is an explanatory view showing a state in which a region P surrounded by four reference marks is allocated as one area when there are reference marks of M-columns in the vertical direction and N-rows in the horizontal direction on the board to be subjected to mounting;

Fig. 24 is a flowchart for reference mark recognition operation in a more concrete example of the component mounting method according to the first embodiment;

Fig. 25 is a flowchart for type selection operation in a more concrete example of the component mounting method according to the first embodiment;

Fig. 26 is a flowchart for reference mark recognition operation and component placing operation in a more concrete example of the component mounting method according to the first embodiment;

Fig. 27 is an explanatory view in a case where data (1) for the position coordinates of the reference marks measured in the normal position of the board and data (2) for the position coordinates of the reference marks measured in the position moved leftward by 350 mm are combined with each other;

Fig. 28 is a graph showing the relation between the position in the X-direction and the amount of displacement in the X-direction when the head is moving in the X-direction at 10-mm pitches over the board of Fig. 27;

Fig. 29 is a graph showing the relation between the position in the Y-direction and the amount of displacement in the Y-direction when the head is moving in the Y-direction at 10-mm pitches over the board of Fig. 27;

Fig. 30 is a graph showing the placing accuracy when 400 ceramic capacitors of chip components of a size of 1.6 mm × 0.8 mm are placed on a board of a size of 428 mm × 250 mm, the offset value according to the first embodiment is not applied, where the vertical axis represents the amount of placing displacement in the Y-direction and the horizontal axis represents the amount of placing displacement in the X-direction;

Fig. 31 is a graph showing the placing accuracy when 400 ceramic capacitors of chip components of a size of 1.6 mm × 0.8 mm are mounted on a board of a size of 428 mm × 250 mm, the offset value according to the first embodiment is applied, where the vertical axis represents the amount of placing displacement in the Y-direction and the horizontal axis represents the amount of placing displacement in the X-direction;

Fig. 32 is a graph showing the placing accuracy when numbers of QFP components are mounted on a board of a size of 428 mm × 250 mm and the offset value according to the first embodiment is not applied, where the vertical axis represents the amount of placing displacement in the Y-direction and the horizontal axis represents the amount of placing displacement in the X-direction;

Fig. 33 is a graph showing the placing accuracy when numbers of QFP components are mounted on a board of a size of 428 mm × 250 mm and the offset value according to the first embodiment is applied, where the vertical axis represents the amount of placing displacement in the Y-direction and the horizontal axis represents the amount of placing displacement in the X-direction;

Fig. 34 is an explanatory view showing the amount of displacement of a reference mark in the X-direction and the Y-direction from the visual field center of the board recognition camera;

Fig. 35 is a flowchart showing operation for reflecting a contained area offset value due to the distortion of X-Y robot operation in a nozzle pitch and a board camera offset value as an application example of the first embodiment;

Fig. 36 is a flowchart showing a procedure for carrying out the component placing operation by reflecting the area offset value in the measurement position of the nozzle pitch;

Fig. 37A, 37B and 37C are views showing the positional relation between the nozzle, the component recognition camera and the board recognition camera during measurement, where Fig. 37A shows a state that position measurement of the first nozzle is in progress, Fig. 37B shows a state that the position measurement of the n-th nozzle is in progress and Fig. 37C shows a state that position measurement of the board camera is in progress;

Fig. 38 is a view for explaining the offset value of the board camera and the nozzle pitch;

Fig. 39 is a schematic explanatory view showing a moving posture of the component placing head in the component mounting apparatus of the first embodiment, where the component placing head has no inclination;

Fig. 40 is a schematic explanatory view showing a moving posture of the component placing head, where the component placing head has an inclination;

Fig. 41 is a schematic view showing the construction of the component mounting apparatus according to a second embodiment of the invention;

Fig. 42 is a side view of the component placing head included in the component mounting apparatus of Fig. 41;

Fig. 43 is a control block diagram showing the construction of the control unit included in the component mounting apparatus of Fig. 41;

Fig. 44 is a schematic plan view of a glass board to be used in the correction method of the second embodiment;

Fig. 45 is a schematic explanatory view for explaining the operation of correcting an amount of displacement due to an inclination of the component placing head in the correction method of the second embodiment;

Fig. 46 is a flowchart showing a procedure for calibration process;

Fig. 47 is a flowchart showing a procedure for production preparation process;

Fig. 48 is a flowchart showing a procedure for production process; and

Fig. 49 is a flowchart showing a procedure for calibration process according to a modification example of the second embodiment.

Best Mode for Carrying Out the Invention

Before the description of the present invention proceeds, it is to be noted that like parts are designated by like reference numerals throughout the accompanying drawings.

(First Embodiment)

Hereinbelow, a first embodiment according to the present invention will be described in detail with reference to the accompanying drawings.

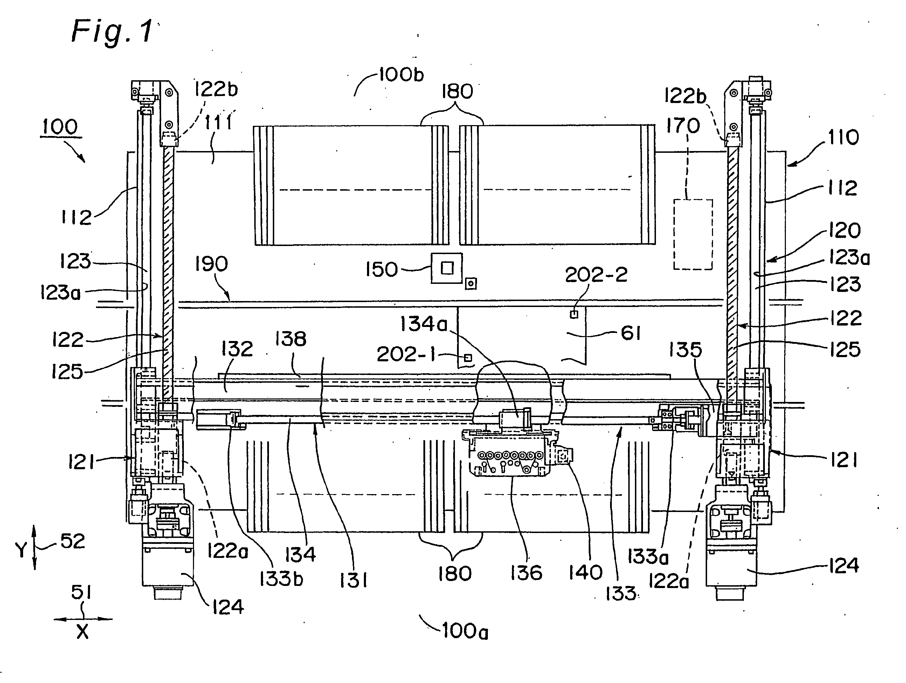

As shown in Figs. 1 through 4, a component mounting apparatus 100 capable of carrying out the component mounting method according to the first embodiment includes a chassis 110, an X-Y robot 120, a board recognition camera 140 which is an example of a board recognition device for recognizing a recognition object on a board, a component recognition camera 150, a control unit 170, component feeding units 180, and a board conveyance unit 190, as the basic constituent elements.

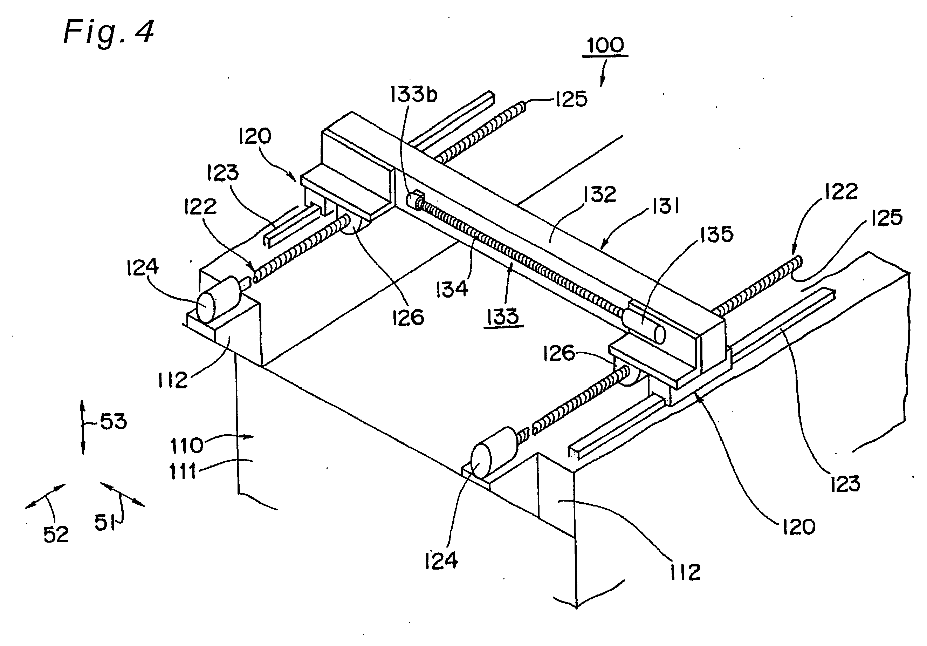

The chassis 110 is a base on which the X-Y robot 120, the component recognition camera 150, the control unit 170, the component feeding unit 180, and the board conveyance unit 190 are installed, and is constructed of a rectangular parallelepiped base section 111 and Y-axis robot leg sections 112. The base section 111 and the Y-axis robot leg sections 112, i.e., the chassis 110 is formed into an integrated structure by casting. The Y-axis robot leg sections 112 protrude from the base section 111 at both end portions of the base section 111 in the X-axis direction 51 and extend along the Y-axis direction 52 perpendicular to the X-axis direction 51. On each of the Y-axis robot leg sections 112 is installed a linear guide 123 or the like at the Y-axis robot 121, which constitutes the X-Y robot 120 and is described in detail later. Each linear guide 123 that serves as the guide support member of the nut section 126 of Fig. 4 is installed on the Y-axis robot leg section 112 along a linear guide installation surface 123a formed at each Y-axis robot leg portion 112 along the Y-axis direction 52, and as described above, the Y-axis robot leg portions 112 are molded into a structure integrated with the base section 111 by casting.

The X-Y robot 120 has two Y-axis robots 121 arranged parallel along the Y-axis direction 52 and one X-axis robot 131 arranged on the two Y-axis robots 121 along the X-axis direction 51 perpendicular to the Y-axis direction 52 on the Y-axis robot leg portions 112, i.e., on the chassis 110 molded into the integrated structure by casting.

Each of the Y-axis robots 121 has a Y-axis ball screw structure 122 and the linear guide 123. The Y-axis ball screw structure 122 linearly expands and contracts only in the Y-axis direction 52 due to heat with its one end 122a served as a fixed end and the other end 122b served as a support end, and moves the X-axis robot 131 in the Y-axis direction 52. If a detailed description is made, as shown in Figs. 1 and 4, a motor 124 that is fixed to the Y-axis robot leg section 112 and serves as the driving source of the ball screw 125 is provided at the one end 122a of the Y-axis ball screw structure 122 and connected to the ball screw 125. The other end 122b supports the ball screw 125 rotatably in its circumferential direction and extendibly in the axial direction, i.e., in the Y-axis direction 52 and is fastened to the Y-axis robot leg section 112.

When the Y-axis robot 121 constructed as above is continuously operated, the portions that generate heat are the ball screw 125 and the motor 124, and the other end 122b permits the expansion and contraction of the ball screw 125 in the Y-axis direction 52 due to heat. Moreover, since the motor 124 is fixed to the chassis 110 of the integrated structure as described above, the expansion and contraction of each Y-axis robot 121 due to heat, i.e., the thermal expansion and contraction can be made linear only in the Y-axis direction 52. Moreover, since the two Y-axis robots 121 operate the same, the amounts of thermal expansion and contraction of the Y-axis robots 121 in the Y-axis direction 52 become equalized.

Moreover, a nut section 126 is attached around the ball screw 125 of each Y-axis robot 121 as shown in Fig. 4, and the nut sections 126 move in the Y-axis direction 52 by the rotation of the respective ball screws 125. The X-axis robot 131, which constitutes the X-Y robot 120, is arranged between the nut sections 126 along the X-axis direction 51. Since the amounts of expansion and contraction of the Y-axis robots 121 in the Y-axis direction 52 are the same as described above, the X-axis robot 131 arranged between the nut sections 126 can be moved in the Y-axis direction 52 parallel to the X-axis.

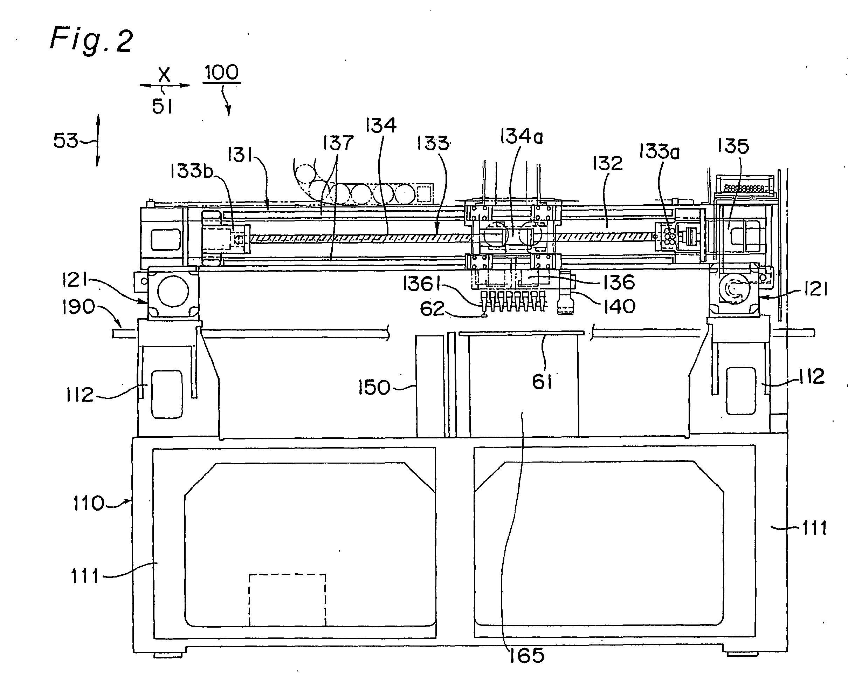

It is to be noted that Fig. 4 is a view conceptually showing the structures of the chassis 110 and the X-Y robots 120, and the component placing head described later is not shown. Moreover, the component feeding units 180 are not shown in Figs. 2 through 4.

The X-axis robot 131 has an X-axis frame 132 and an X-ball screw structure 133. The X-axis frame 132 has both ends fixed to the nut sections 126 of the respective ball screw structures 122 of the Y-axis robots 121 and extends in the X-axis direction 51 as described above. The X-ball screw structure 133 is formed on the X-axis frame 132 and expands and contracts linearly only in the X-axis direction 51 due to heat with its one end 133a served as a fixed end and the other end 133b served as a support end. A component placing head 136 that serves as one example of the component placing head is further attached to move the component placing head 136 in the X-axis direction 51.

The X-axis frame 132 is a member made of aluminum into an almost square pillar configuration, and both ends are fixed to the nut sections 126 as described above. A motor 135, which serves as a driving source of the ball screw 134 and is fixed to the X-axis frame 132 as shown in Fig. 4 and so on, is provided at the one end 133a of the X-ball screw structure 133 formed on a side surface of the X-axis frame 132 and connected to the ball screw 134. The other end 133b is fastened to the X-axis frame 132 while supporting the ball screw 134 rotatably in the circumferential direction thereof and extendibly in the axial direction thereof, i.e., in the X-axis direction 51. When the X-axis robot 131 is continuously operated, the portions that generate heat are the ball screw 134 and the motor 135, and the other end 133b permits the expansion and contraction of the ball screw 134 in the X-axis direction 51 due to heat.

Moreover, as shown in Fig. 1, a nut section 134a for fastening the component placing head 136 is attached around the ball screw 134, and the nut section 134a, i.e., the component placing head 136 moves in the X-axis direction 51 by the rotation of the ball screw 134.

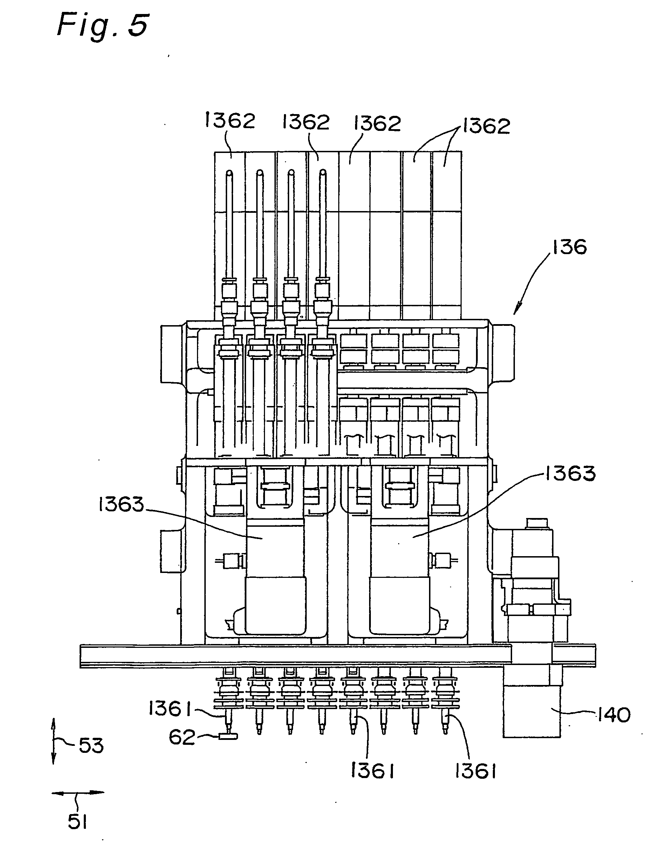

The component placing head 136 has component suction nozzles 1361 as one example that produce the function of the component holding members for holding electronic components 62, and a board recognition camera 140 for image-picking up board-reference-position calculation marks 202-1 and 202-2 that are located on the circuit board 61 to confirm the displacement of a circuit board 61 that is loaded and placed and image-picking up reference marks 201 arranged at specified intervals of a reference-mark-recognizing reference board 200 described later in the first embodiment. As shown in detail in Fig. 5, with regard to the component suction nozzles 1361, eight component suction nozzles 1361 are provided in a straight line along the X-axis direction 51 in the first embodiment. It is to be noted that the electronic component 62 is a small component of a chip component or the like, or a large component of QFP or the like; or the like. Therefore, the component suction nozzles 1361 of optimum sizes and configurations are attached in correspondence with various components to be sucked. As described above, the board recognition camera 140 is arranged so that the image-picking up center of the board recognition camera 140 is located coaxially with a straight line that extends through the center of the component suction nozzles 1361 arranged along the X-axis direction 51. Moreover, a rotary motor 1363 for rotating each of the component suction nozzles 1361 in the circumferential direction of its axis is further provided for the component placing head 136.

Each of the component suction nozzles 1361 needs to move in the axial direction of the component suction nozzle 1361, i.e., along the Z-axis direction 53 in order to suck the electronic component 62 from the component feeding unit 180 and mount the sucked electronic component 62 on the circuit board 61 that serves as one example of the component mounting board. In the first embodiment, a moving motor 1362, which serves as one example and that functions as a driving source for moving the component holding member, is provided for each component suction nozzle 1361 to move the component suction nozzle 1361 that serves as one example of the component holding member at the component placing head 136. Therefore, a low power motor can be used and the amount of heat generation from the motor can be suppressed in comparison with the conventional case where all of the plurality of component suction nozzles have been driven by one high power motor. As one working example, the moving motor 1362 has an output of 20 W, and scarce heat is generated from the moving motor 1362. Furthermore, in the conventional case where the high power motor with large amount of heat generation is singly provided, a temperature gradient in accordance with the distance from the high power motor occurs in the conventional component placing head, and distances between the component suction nozzles are disadvantageously varied in the direction of the array due to the difference in the thermal expansion and contraction. In contrast to this, by virtue of the provision of the moving motor 1362 for each of the component suction nozzles 1361 in the embodiment, scarce heat is generated from each moving motor 1362, and if heat generation occurs, there occurs no such a temperature gradient that exerts influence on the component mounting accuracy at the component placing head 136. Therefore, even if the component placing head 136 is continuously operated, the distances between the component suction nozzles 1361 can be maintained equal or almost equal in the X-axis direction 51. It is to be noted that the almost equal state means the extent that no influence is exerted on the component mounting accuracy.

Moreover, since there occurs no such a temperature gradient that exerts influence on the component mounting accuracy at the component placing head 136 as described above, the relative position between each of the component suction nozzles 1361 and the board recognition camera 140, i.e., the distance between each of the component suction nozzles 1361 and the board recognition camera 140 can be made immovable. In this case, the above-mentioned "immovable" means that the expansion and contraction to the extent that influence is exerted on the component mounting accuracy is not caused by heat with regard to the distance between each of the component suction nozzles 1361 and the board recognition camera 140.

The component feeding unit 180 is the so-called cassette type component feeding unit that has a plurality of reels around which tapes accommodating the electronic components 62 are wound, and there are provided two sets of the units arranged on the front side 100a and the rear side 100b, in the component mounting apparatus 100 of the first embodiment.

The board conveyance unit 190 is an unit that performs loading, suction and holding, and unloading of the circuit board 61 in the placing position of the circuit board 61 in the component placing region in the component mounting apparatus 100, and, as shown in Fig. 1 and other figures, the unit is arranged along the X-axis direction 51 at an approximate center portion of the component mounting apparatus 100. The board conveyance unit 190 has a conveyance table 165 that serves as one example of the board holding device in the placing position, allowing the loaded circuit board 61 to be sucked and held and allowing the circuit board 61 to be unloaded by releasing the suction and holding.

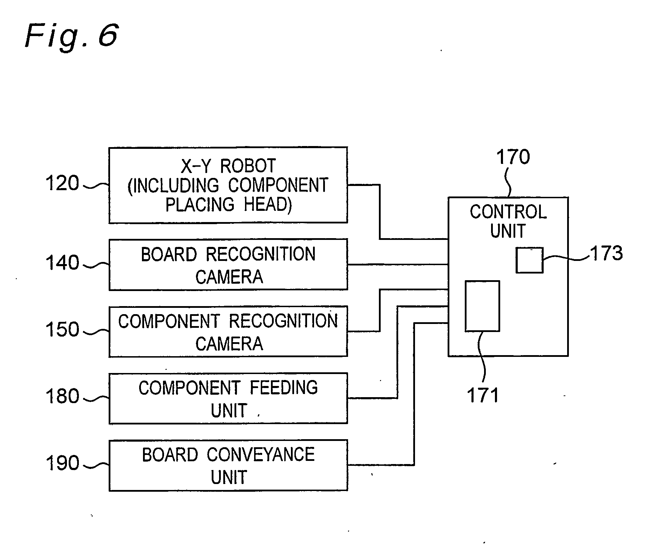

As shown in Fig. 6, the control unit 170 is connected to the X-Y robot 120, the board recognition camera 140, the component recognition camera 150, the component feeding units 180, and the board conveyance unit 190, which are the constituents described above, and controls the mounting operation of the electronic components 62 on the circuit board 61 by controlling the operation of them. The control unit 170 includes a storage section 173 for storing mounting information such as programs and mounting data (such as respective movement position coordinate data of the component placing head 136 during the mounting operation, placing position coordinate data of the components, data of information of relations between the movement positions of the component placing head 136 and the placing positions of the components, and so on, data of the size of the reference-mark-recognizing reference board and position coordinate data of the reference marks, data of the size of the board to be subjected to mounting and position coordinate data of the board-reference-position calculation marks, data of the components, data of nozzle size, and so on, component feed data of the component feeding units 180, and so on); recognition information by means of the board recognition camera 140; calculation results in the calculation section 171 described later necessary; and so on, and includes the calculation section 171 for executing various operations of, for example, calculating parallel deviation, inclination, expansion rate, and so on based on recognition information (e.g., recognition information of the reference marks 201A and 201B by means of the board recognition camera 140, recognition information of the reference marks 201 by means of the board recognition camera 140, and recognition information of the board-reference-position calculation marks 202-1 and 202-2 by means of the board recognition camera 140, and so on) by means of the board recognition camera 140 and obtaining by calculating an error at each placing position based on the recognition information and the placing position data of the mounting information stored in the storage section 173. The control unit 170 is made to execute the component mounting operation on the basis of the data and information stored in the storage section 173. The component mounting operation by the control unit 170 constructed as above, and in particular, correction operation will be described in detail below.

The operation of the component mounting apparatus 100 constructed as described above, i.e., the component mounting method carried out by the component mounting apparatus 100 will be described more in detail. The conveyance operation of the circuit board 61 by the circuit board conveyance unit 190 as well as operations from the component suction from the component feeding units 180 to the component mounting on the circuit board 61 by the X-Y robot 120 including the component placing head 136 basically resembles the operation carried out in the conventional component mounting apparatus, and therefore, the operations will be simply described below.

That is, the component placing head 136 is moved to the component feeding unit 180 by the X-Y robot 120. Next, one or a plurality of electronic components 62 is sucked and held from the component feeding unit 180 by one or a plurality of component suction nozzles 1361 of the component placing head 136. Next, the component placing head 136 is moved over the component recognition camera 150 by the X-Y robot 120 to recognize the posture(s) and so on of the electronic component(s) 62 sucked and held by the nozzle(s) 1361 by means of the component recognition camera 150, and thereafter, the head is bound for the placing position(s) of the circuit board 61. The electronic component 62, which is sucked and held by one nozzle 1361 of the component placing head 136, is positioned above the corresponding placing position by the X-Y robot 120, and thereafter, the nozzle 1361 is moved down to place the electronic component 62 in the placing position. At this time, the mounting operation is carried out by rotating the nozzle 1361 around its axis and the like based on the component posture recognition result by means of the component recognition camera 150, correcting the position of the component placing head 136 in consideration of an offset value described later, and thereafter carrying out the placing operation. All the components 62 to be mounted on the circuit board 61 are subjected to the series of mounting operation.

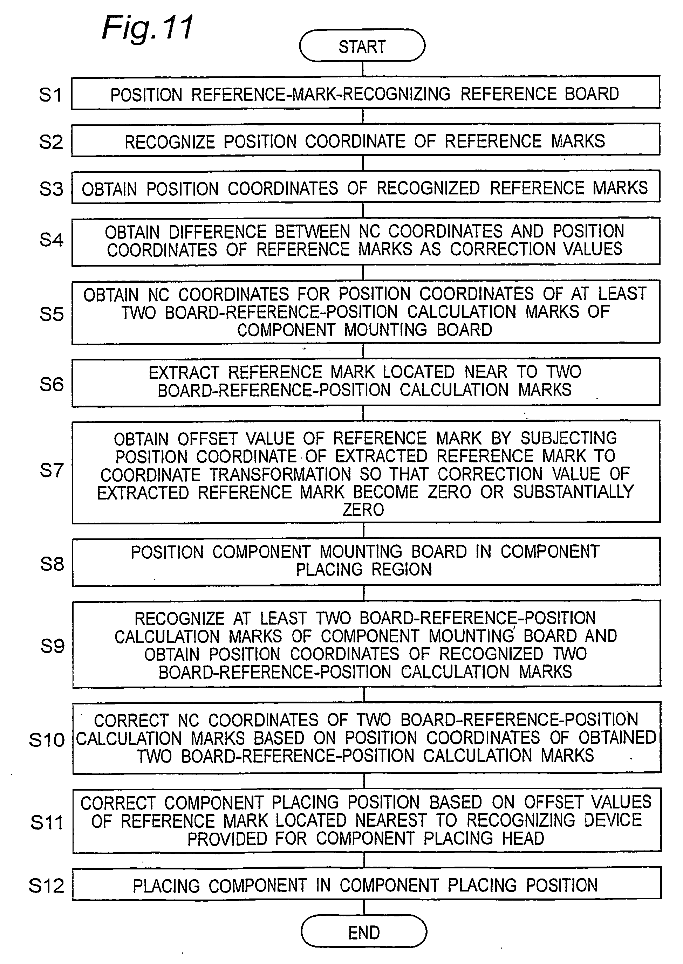

The component mounting method according to the first embodiment is characterized by the positional correction operation of the component placing head 136 during the mounting operation in consideration of the offset value, and this will be described in detail below with reference to Fig. 11.

That is, the component mounting method of the embodiment recognizes the reference marks 201 arranged at specified intervals on a glass board 200 that serves as one example of the reference-mark-recognizing reference board, obtains the position coordinates (coordinates constituted of an X-coordinate value in the X-direction and a Y-coordinate value in the Y-direction perpendicular to the X-direction in the plane of the glass board 200 for indicating the position of the reference mark) of the reference marks recognized as above, obtains a difference between the NC coordinates (predetermined design numerical position coordinates of the reference marks) of each of the reference marks and the position coordinates as a correction value, obtains the NC coordinates of the position coordinates of at least two board-reference-position calculation marks of the component mounting board, extracts reference marks respectively located near to the two board-reference-position calculation marks among the recognized reference marks, and obtains offset values of the reference marks by respectively subjecting the position coordinates of the extracted reference marks to coordinate transformation so that correction value of the extracted reference marks become zero or substantially zero. Then, at least two board-reference-position calculation marks of the component mounting circuit board held by the board holding device are respectively recognized in a state in which the component mounting board is held by the board holding device and positioned in the component placing region in place of the reference-mark-recognizing reference board, the position coordinates of the recognized two board-reference-position calculation marks are obtained, and the NC coordinates of the two board-reference-position calculation marks are respectively corrected on the basis of the position coordinates of the obtained two board-reference-position calculation marks. When each component placing head 136 is moved to each of the movement positions during placing position correction, mark recognition and correction, and placing position offset measurement, or any one of the operations, the position coordinate of the movement position are corrected based on the offset value of the reference mark located nearest to the recognition device provided for the component placing head, allowing highly accurate placing to be achieved.

In this case, the offset value means a numerical value for correcting the position coordinates of the reference mark obtained by subjecting the extracted position coordinates of the reference mark to coordinate transformation so that the correction values of the reference marks extracted as the reference marks respectively located near to the two board-reference-position calculation marks of the component mounting board become zero or substantially zero as described later.

Moreover, the correction value means a difference between the NC coordinate of each of the reference marks arranged at specified intervals on the reference board and the recognized position coordinate.

The outline of a method for obtaining the offset value will be described first.

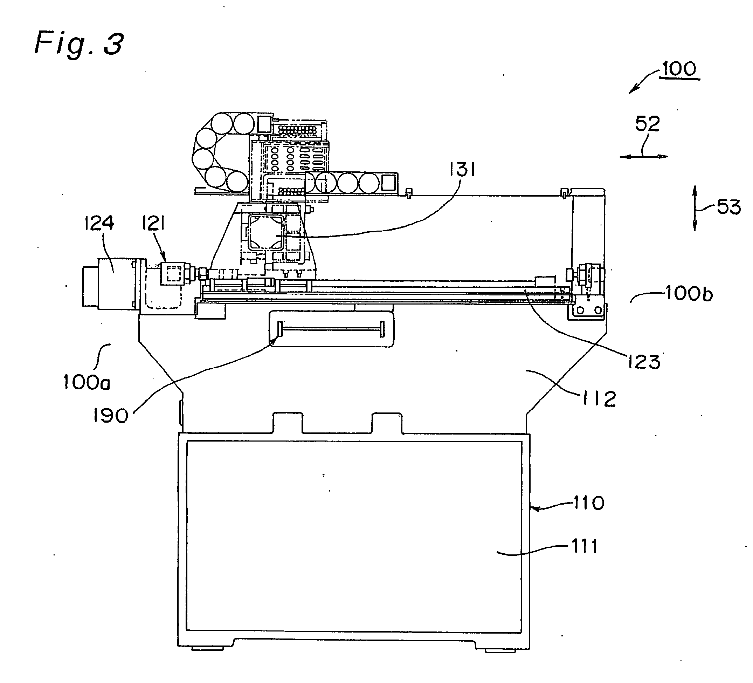

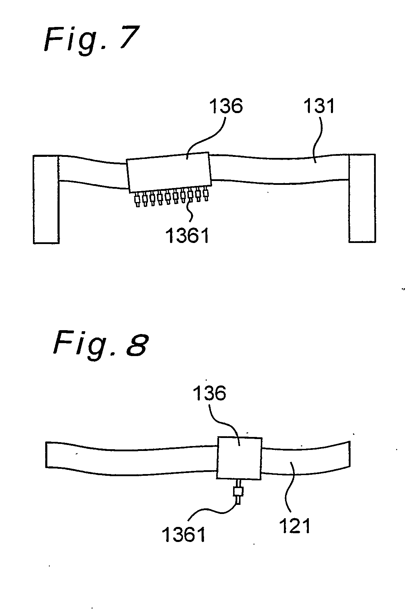

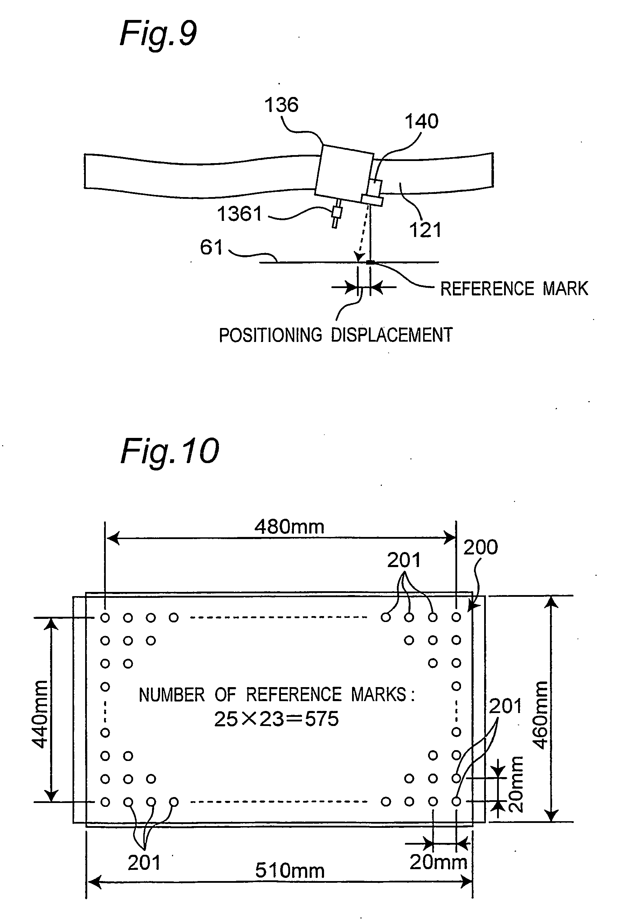

The positioning accuracy of the component placing head 136 is largely influenced by the distortion of the X-Y robot 120 (see Figs. 7 and 3), and a positioning error is generated. For example, Fig. 7 is a view showing the relation between the distortion of the X-axis robot and the component placing head 136, and Fig. 8 is a view showing the relation between the distortion of the Y-axis robot and the component placing head 136. This positioning error is changed by the position in which the component placing head 136 moves and exerts influence on the placing accuracy. Accordingly, as shown in Fig. 9, when the X-Y robot 120 moves the head 136 to an arbitrary NC coordinate position, the offset value (in other words, the offset value for correcting the area where the NC coordinate position exists) in the reference mark position located nearest to the NC coordinate position is used as a numerical value for the correction to remove the error of the positioning of the X-Y robot 120 and so on generated by the above movement. That is, the offset value used as the numerical value for the correction to correct the error of the positioning and so on is obtained by using the reference-mark-recognizing reference board within a maximum component placing region (a region including the boards to be produced, the boards having, for example, an XL size of 510 mm × 460 mm and an M size of 330 mm × 250 mm).

In concrete, first of all, in step S1 of Fig. 11, à glass board 200 that serves as one example of the reference-mark-recognizing reference board is held by the conveyance table 165 that serves as one example of the board holding device and positioned in the component placing region.

Next, in step S2 of Fig. 11, the position coordinates of all the reference marks 201 arranged at specified intervals on the glass board 200 held by the conveyance table 165 are recognized by the board recognition camera 140 of the component placing head 136. More concrete recognition of the reference marks for the measurement of the correction value is carried out as follows. During the measurement of the correction value, a special glass board (hereinafter referred to as a glass board) on which the reference marks (circles of a diameter of 1 mm) are formed in a grid (grating) form in a printing or a similar manner is used for the glass board 200 of the XL size of 510 mm × 460 mm (M size: 330 mm × 250 mm) that serves as one example of the reference-mark-recognizing reference board of the measurement board. That is, as one example of the glass board 200, as shown in Fig. 10, one on which the circular reference marks (of a diameter of 1 mm) 201 constituted of 44 rows in the Y-direction and 49 columns in the X-direction arranged at 10-mm pitches are printed on a glass plate of a size of 510 mm × 460 mm is used for the XL size. Therefore, the reference marks used for the measurement are located at 2156 points. For the measurement of the M size, one on which the circular reference marks (of a diameter of 1 mm) 201 constituted of 22 rows in the Y-direction and 39 columns in the X-direction at 10-mm pitches are printed on a glass plate of a size of 410 mm × 240 mm is used. Therefore, the reference marks used for the measurement are located at 858 points.

The size of the reference-mark-recognizing reference board may principally be of any size so long as the size is larger than the maximum component placing region of the component mounting apparatus. However, as described later, in the case of a size smaller than the maximum component placing region, the size may be virtually made greater than the size of the maximum component placing region by using a synthesis method. Although the accuracy is increased if the intervals between the reference marks are made finer, the data obtaining time becomes long, and the amount of storage data increases. Accordingly, it is economically sufficient to set the pitch to about 1/4 to 1/5 of the lead of the ball screw of the ball screw structure of the X-Y robot. As a concrete example, the reference mark pitch can be set to 10 mm with respect to the lead of 40 mm.

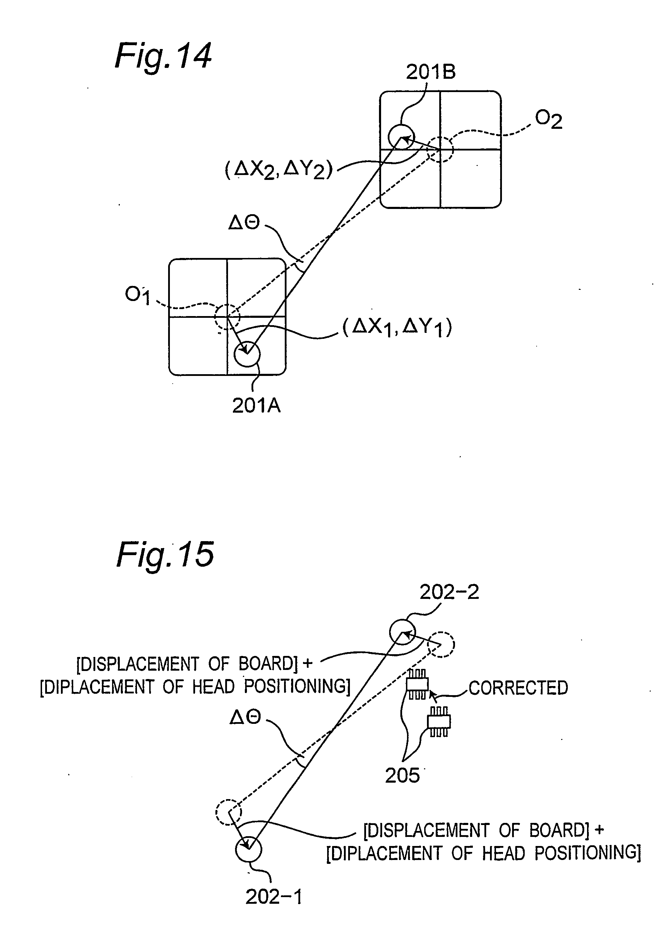

Next, in step S3 of Fig. 11, the position coordinates of the recognized reference marks 201 are obtained by the operation unit 171 on the basis of the recognition results and then stored in the storage section 173. That is, as shown in, for example, Fig. 13, all the reference marks 201 are recognized by moving the board recognition camera 140 of the head 136 from the reference mark 201 at the left end of the lowermost row to the reference mark 201 at the right end of the same row parallel to the board conveyance direction of the board conveyance unit 190 in order to reduce the displacement to sequentially recognize all the reference marks 201 of the row, obtaining the position coordinates by the operation unit 171 on the basis of the recognition results, and storing the results in the storage section 173. Next, after reversely moving the camera obliquely to the left, the board recognition camera 140 of the head 136 is moved from the reference mark 201 at the left end of the row located upwardly next to the lowermost row to the reference mark 201 at the right end of the same row to sequentially recognize all the reference marks 201 of the row, the position coordinates are obtained by the operation unit 171 on the basis of the recognition results, and the results are stored in the storage section 173. Next, after reversely moving the camera obliquely to the left, the board recognition camera 140 of the head 136 is moved from the reference mark 201 at the left end of the row located upwardly next but one to the lowermost row to the reference mark 201 at the right end of the same row to sequentially recognize all the reference marks 201 of the row, the position coordinates are obtained by the operation unit 171 on the basis of the recognition results, and the results are stored in the storage section 173. The reference marks 201 of all the rows are recognized according to the above sequence, the position coordinates are obtained by the operation unit 171 on the basis of the recognition results, and the results are stored in the storage section 173. It is to be noted that the lower side of the glass board 200 of Fig. 13 corresponds to the front side of the component mounting apparatus, i.e., this side of the operator.

In order to improve the recognition accuracy of the reference marks 201, the recognition processing of the reference marks 201 may be repetitively carried out a plurality of times. In the above case, the mean values of the position coordinates obtained by the recognition results of the corresponding frequency are calculated by the operation unit 171 and stored as the position coordinates of the corresponding reference marks 201 in the storage section 173. The frequency is preferably arbitrarily changeable on the operation screen of the component mounting apparatus.

As described above, the position coordinates of all the reference marks 201 are stored in the storage section 173.

Next, in step S4 of Fig. 11, differences between the NC coordinates of the reference marks 201 and the respective position coordinates are obtained as correction values by the operation unit 171 and then stored in the storage section 173. The correction values are numerical values for correcting the deviation in holding the glass board 200 during the suction and holding of the glass board 200 by the conveyance table 165, the deviation during recognition, the positioning error of the X-Y robot, and so on.

Next, in step S5 of Fig. 11, the NC coordinates of the position coordinates of at least two board-reference-position calculation marks 202-1 and 202-2 of the component mounting circuit board 61 are obtained by the operation unit 171.

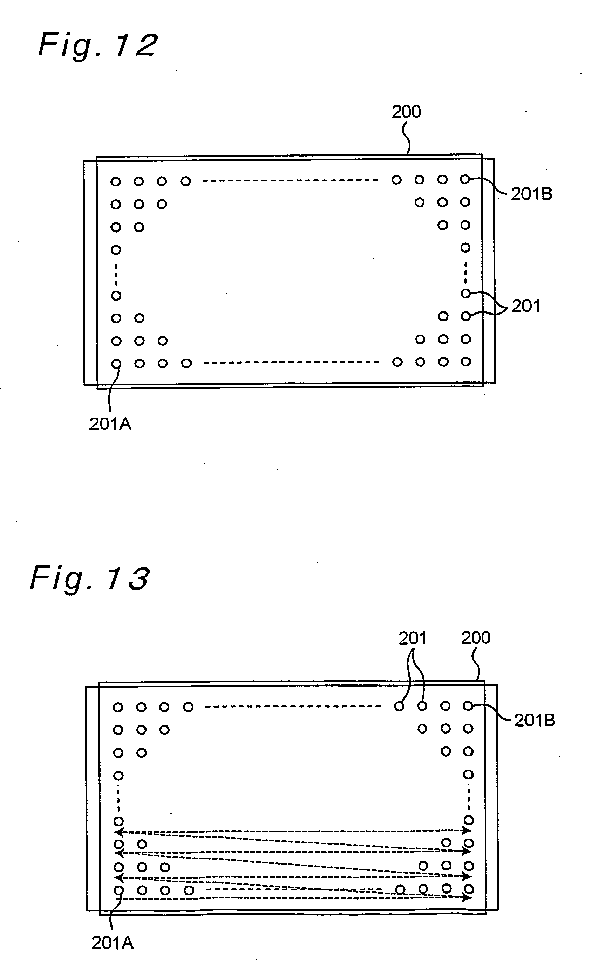

Next, in step S6 of Fig. 11, on the basis of the two NC coordinates of the position coordinates of the two board-reference-position calculation marks 202-1 and 202-2, the reference marks 201 respectively located near to the two board-reference-position calculation marks 202-1 and 202-2 of the component mounting board 61 are extracted by the operation unit 171 from among the recognized reference marks 201 of the glass board 200. Concretely, in Fig. 12, the reference marks 201A and 201B at the two points located diagonally at the upper right and the lower left, as examples, on the glass board 200 near to the two board-reference-position calculation marks 202-1 and 202-2 are recognized by the board recognition camera 140 while moving the head 136 by means of the X-Y robot 120. That is, it is difficult to hold the glass board 200 by the conveyance table 165 completely parallel to the board conveyance direction of the board conveyance unit 190, and a displacement is occurring. In order to correct the displacement when this glass board is held, the reference marks 201 located at the lower left corner and the upper right corner of the glass board 200 are first recognized as the reference marks 201A and 201B.

Next, in step S7 of Fig. 11, the position coordinates of the extracted reference marks 201A and 201B are subjected to coordinate transformation (coordinate transformation in consideration of parallel deviation, inclination, and expansion/contraction rate) so that the correction values of the extracted reference marks 201A and 201B become zero or substantially zero, and the offset values at the reference marks 201A and 201B are obtained. That is, the parallel deviation and the inclination of the glass board 200 are obtained by the operation unit 171 from the position coordinates of the recognition results of the reference marks 201A and 201B at the two points obtained in step S3 of Fig. 11. Equations for obtaining the parallel deviation and the inclination will be described later. The parallel deviation means the displacement in the X-direction and/or the Y-direction. The inclination means the rotational deviation as a consequence of the rotation of the board in the X-direction and the Y-direction of the direction perpendicular to the X-direction when the board is stopped by the board stopper in the placing position of the conveyance table 165. At this time, the expansion/contraction rate is obtained since it is required to consider the expansion and contraction of the board due to heat. In this case, the expansion/contraction rate means the ratio of expansion and contraction due to heat of the board itself.

Next, a graphic line for connecting the reference marks 201A and 201B at the two points is rotated and shifted for coordinate transformation on the basis of the correction value (parallel deviation and inclination) obtained by the operation unit 171 so that the correction values of the reference marks 201A and 201B at the two points become zero (in other words, so as to make coincidence with the data of the NC coordinates of the reference marks 201A and 201B at the two points) or become substantially zero (e.g., within a range of $\pm 5$ $\mu$m). Then the offset values at the position coordinates of all the reference marks 201 are obtained and stored in the storage section 173. As a result, the offset value of each area (rectangular area obtained by dividing the reference board every unit area based on the reference marks (e.g., surrounded by reference marks at four points)) corresponding to the size of the reference-mark-recognizing reference board can be determined. By carrying out positional correction using the offset values of every area as numerical values for the correction of the movement position of the component placing head existing in each area during the recognition operation of the reference marks of the reference-mark-recognizing reference board, the component mounting operation on the board to be subjected to placing and so on, the mounting accuracy can be improved.

The positioning error and so on peculiar to the X-Y robot 120 can be perceived as the relative displacement between placing positions by the offset values obtained through the steps S1 through S7 of Fig. 11 in the processes. Moreover, by using the thus obtained offset values as numerical values for correction for the correction of the position coordinates in the head positioning position calculation during the reference mark recognition operation, the component placing operation, the placing offset value measurement operation, or any one of those operations, the deviation factor due to the distortion of the X-Y robot operation can be absorbed, and the placing accuracy can be improved.

In this case, the reason why the correction based on the deviation of the reference-mark-recognizing reference board is added to the position coordinates of all the reference marks 201 is that the positioning error of the X-Y robot 120 is disadvantageously contained during the reference mark recognition in the correction value measurement. An error is originally included in every positioning operation of the X-Y robot 120, and even if the glass board 200 can be produced with the desired high accuracy, accurate positioning in the placing position of the component mounting apparatus cannot be achieved. Then, since no absolute reference exists, it is impossible to accurately measure the positioning error of the X-Y robot 120.

Assuming herein that Fig. 14, which shows the fact that the reference marks 201A and 201B are recognized in the positions displaced from the visual field center positions $O_1$ and $O_2$ of the board recognition camera 140, illustrates the recognition results of the reference marks 201A and 201B during the reference mark recognition, then position coordinate deviations ($\Delta X_1$, $\Delta Y_1$) obtained from the recognition result of the reference mark 201A at the first point and position coordinate deviations ($\Delta X_2$, $\Delta Y_2$) obtained from the recognition result of the reference mark 201B at the second point can be obtained as position coordinate deviations obtained from the reference mark recognition results.

It is of course ideal that the deviation factor included in the position coordinate deviations obtained from the recognition results becomes only the amount of parallel deviation when the glass board 200 is held by the conveyance table 165. However, the recognition process error and the positioning error of the X-Y robot 120 are actually contained. Therefore, the position coordinate deviations obtained from the recognition results of the reference marks 201A and 201B become as follows:

(position coordinate deviation of recognition results) = (deviation in holding board) + (deviation in recognition) + (X-Y robot positioning error),

and assuming that the amount of board parallel deviations of the reference marks 201A and 210B are $(X_{pcb1}, Y_{pcb1})$ and $(X_{pcb2}, Y_{pcb2})$, the recognition errors of the reference marks 201A and 210B are $(X_{rec1}, Y_{rec1})$ and $(X_{rec2}, Y_{rec2})$, and the amounts of positioning errors of the X-Y robot 120 at the reference marks 201A and 210B are $(X_{e1}, Y_{e1})$ and $(X_{e2}, Y_{e2})$, then the position coordinate deviations $(\Delta X_1, \Delta Y_1)$ and $(\Delta X_2, \Delta Y_2)$ obtained from the recognition results are expressed by the following Equations (1).

Eq. (1):

$$\Delta X_1 = X_{pcb1} + X_{rec1} + X_{e1}$$

$$\Delta Y_1 = Y_{pcb1} + Y_{rec1} + Y_{e1}$$

$$\Delta X_2 = X_{pcb2} + X_{rec2} + X_{e2}$$

$$\Delta Y_2 = Y_{pcb2} + Y_{rec2} + Y_{e2}$$

That is, the position coordinates of the reference marks of which the position coordinate deviations of the glass board 200 are corrected with respect to the position coordinates of the reference marks 201 by using the recognition results do not become the coordinates where the reference marks 201 actually exist. The above is because the deviation factor due to the positioning error of the X-Y robot 120 has disadvantageously been contained in the position coordinates of the corrected reference marks.

If it is postulated that the recognition errors $(X_{rec1}, Y_{rec1})$ and $(X_{rec2}, Y_{rec2})$ of the reference marks 201A and 201B are zero, assuming that the NC coordinate of the reference mark 201 obtained through correction is $(X_{mnc}, Y_{mnc})$ and the NC coordinates of the reference marks 201A and 210B are $(X_{nc1}, Y_{nc1})$ and $(X_{nc2}, Y_{nc2})$, then the position coordinates $(X_m, Y_m)$ of the reference mark obtained through correction are expressed by the following Equations (2) and (3).

Eq. (2):

$$X_m = (X_{mnc} - X_{nc1})\cos\Delta\theta - (Y_{mnc} - Y_{nc1})\sin\Delta\theta + \Delta X_1$$

$$= (X_{mnc} - X_{nc1})\cos\Delta\theta - (Y_{mnc} - Y_{nc1})\sin\Delta\theta + X_{pcb1} + X_{e1}$$

$$\ldots[1]$$

Eq. (3):

$$Y_m = (X_{mnc} - X_{nc1})\sin\Delta\theta + (Y_{mnc} - Y_{nc1})\cos\theta + \Delta Y_1$$

$$= (X_{mnc} - X_{nc1})\sin\Delta\theta + (Y_{mnc} - Y_{nc1})\cos\theta + Y_{pcb1} + Y_{e1}$$

$$\ldots[2]$$

With regard to this, assuming that the position coordinate where the actual reference mark 201 exists is $(X_t, Y_t)$, then the following Equations (4) hold.

Eq. (4):

$$X_t = (X_{mnc} - X_{nc1}) \cos\Delta\theta - (Y_{mnc} - Y_{nc1}) \sin\Delta\theta + X_{pcb1}$$

$$...[1]'$$

$$Y_t = (X_{mnc} - X_{nc1}) \sin\Delta\theta + (Y_{mnc} - Y_{nc1}) \cos\theta + Y_{pcb1}$$

$$...[2]'$$

In this case, the NC coordinates as the results of correction must properly correspond to the position coordinates of the actual reference marks ([1] = [1]', [2] = [2]'). However, if the above equations are compared, then the following Equations (5) hold.

Eq. (5):

$$X_m - X_t = X_{e1} \neq 0$$

$$Y_m - Y_t = Y_{e1} \neq 0$$

In the equations, the NC coordinates as the results of correction do not correspond to the position coordinates of the actual reference mark. For the reason that the head 136 cannot be positioned in the position coordinates of the actual reference mark, the position coordinate deviation obtained from the recognition results obtained cannot be used for positional correction since it disadvantageously leads to a correction value containing a positioning error.

As described above, the positioning error is always contained in the X-Y robot operation of the component mounting apparatus. If the correction value is measured on the basis of the glass board 200, it does not become a true value, and there is no absolute reference.

Accordingly, in order to adjust this error unlimitedly to zero (in other words, to make the data of the position coordinates of the reference mark 201 coincide with the data of the NC coordinates), the correction value obtained above is subjected to the processing as follows.

During the actual component mounting operation in the component mounting apparatus, the component mounting apparatus recognizes all the reference marks as described above in order to correct the deviation of holding on the conveyance table 165 of the board to be produced (board to be subjected to mounting) and corrects each placing position by the results. The results of the recognition of the two board-reference-position calculation marks 202-1 and 202-2 at this time become as shown in Fig. 15. In this case, the positioning errors in the positions of the two board-reference-position calculation marks 202-1 and 202-2 are contained in the position coordinate deviation obtained from the recognition results of the two board-reference-position calculation marks 202-1 and 202-2 in addition to the deviation of holding.

In actually placing the component 62 in the mounting position 205 of the board 61 to be subjected to mounting, the parallel deviation, the inclination, and the expansion/contraction rate are obtained from the recognition results of the board-reference-position calculation marks, and each placing position 205 is corrected by the obtained result for use. Concretely, the correction is carried out by relocating all the placing positions 205 so that the amounts of deviation (deviation of holding + positioning error) in the positions of the reference marks near the two board-reference-position calculation marks 202-1 and 202-2 become zero (in other words, the position coordinate data of the two board-reference-position calculation marks 202-1 and 202-2 are made to coincide with the data of the NC coordinates).

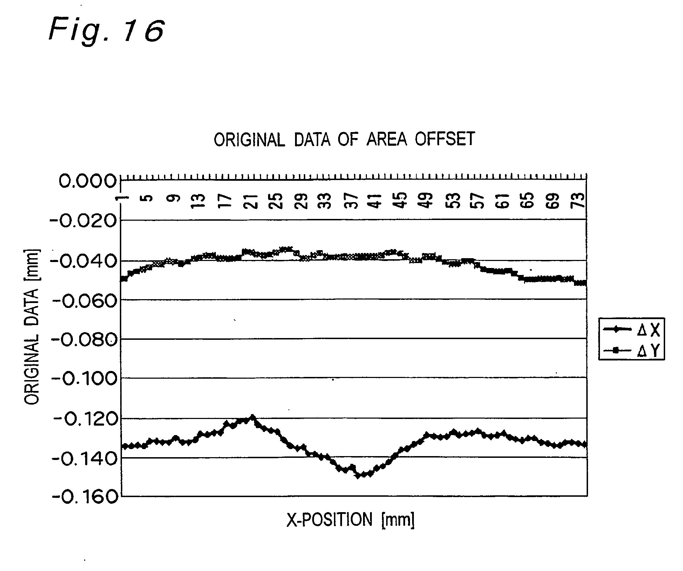

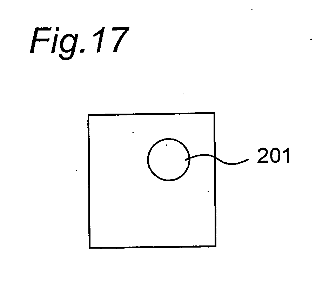

Concretely, as shown in Fig. 16, the position of the reference mark of the original data of the correction value is not zero since the position is displaced from the proper position (the center position of the rectangular visual field region in Fig. 17) in the X-direction and the Y-direction as shown in Fig. 17. In Fig. 16, the vertical axis represents the amount of displacement, and the horizontal axis represents the position in the X-direction. The upper graphic line indicates $\Delta X$, i.e., the displacement in the X-direction, and the lower graphic line indicates $\Delta Y$, i.e., the displacement in the Y-direction.

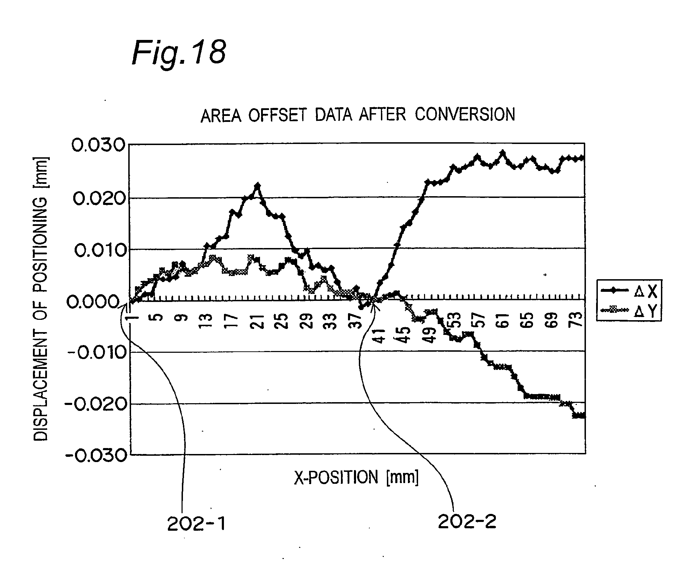

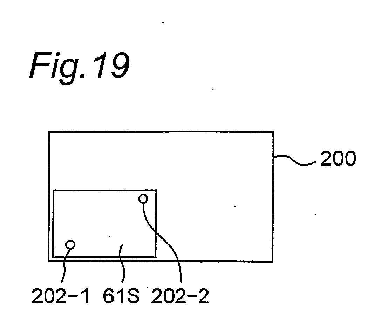

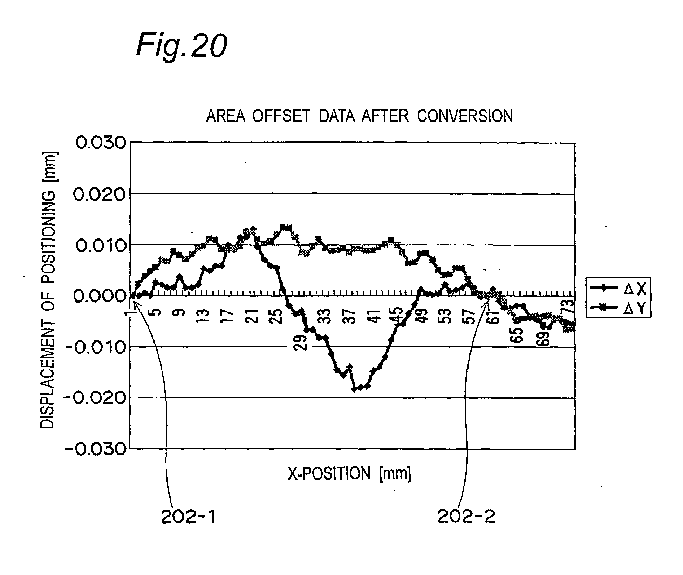

Accordingly, as shown in Figs. 18 and 19, all the placing positions are relocated through coordinate transformation by rotating and shifting the graphic line that connects the board reference marks 201a and 201b at two points so that the correction values of the reference marks 201a and 201b in the vicinity of the two marks 202-1 and 202-2 of a comparatively small board 61S to be subjected to mounting become zero or substantially zero (e.g., within the range of $\pm 5$ $\mu$m). In the graph of Fig. 18, although the reference marks 202-1 and 202-2 (diagonally located) are plotted on the same graph, the data themselves are obtained by measuring the X-coordinate at intervals of 10 mm with the Y-coordinate made constant. Therefore, the data indicated as "202-2" on the graph are the data of the reference mark of which the Y-coordinate data are identical to those of the reference mark 202-1 and the X-coordinate data are identical to those of the reference mark 202-2. This holds same also in Fig. 20.

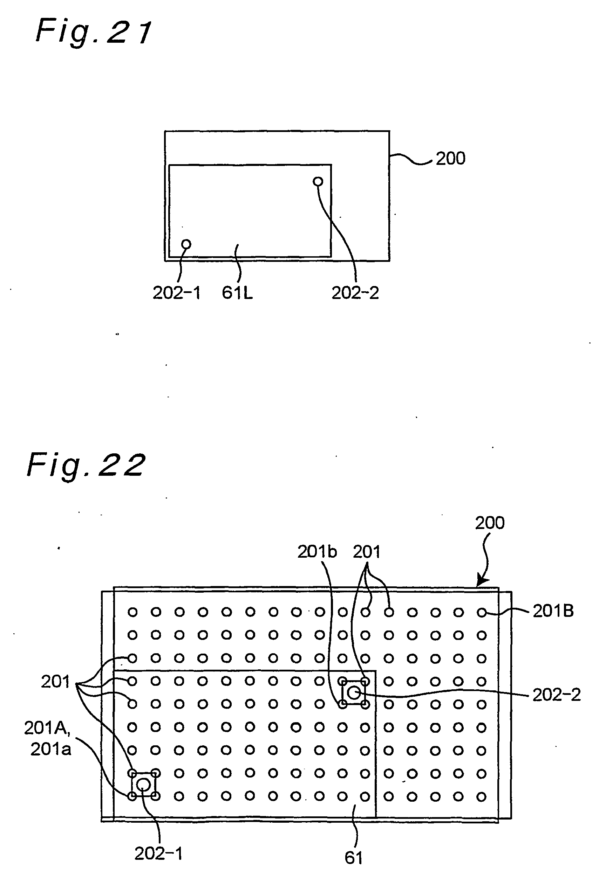

Moreover, as shown in Figs. 20 and 21, all the placing, positions are relocated through coordinate transformation by rotating and shifting the graphic line so that the correction values of the reference marks 201 in the vicinity of the two board-reference-position calculation marks 202-1 and 202-2 of a comparatively large board 61L to be subjected to mounting become zero or substantially zero (e.g., within the range of $\pm 5$ $\mu$m). As described above, the data actually used for the correction values largely differs depending on the board to be subjected to mounting.

Since there is no absolute reference through the processes of obtaining the X-Y robot positioning error, the amounts of the X-Y robot positioning errors of each measured area agree with the board 61 to be subjected to mounting during the production only in the positions of the two mark board-reference-position calculation marks 202-1 and 202-2 of the board 61 to be subjected to mounting. Accordingly, by using the correction values of the reference marks near to the two board-reference-position calculation marks 202-1 and 202-2 of the board 61 to be produced, relocation is achieved by carrying out the coordinate transformation so that the correction values of the two points become zero or substantially zero (e.g., within the range of $\pm 5$ $\mu$m). As the processing at this time, the parallel deviation, the inclination, the expansion/contraction rate, and so on are obtained, and all the placing positions 205 are relocated by the results, similarly to the correction operation of the two board-reference-position calculation marks 202-1 and 202-2.

In Fig. 22, on the basis of the amount of the X-Y robot positioning errors at the reference marks 201a and 201b on the glass board 200 located nearest to the board-reference-position calculation marks 202-1 and 202-2 of the board 61 to be produced, the amounts of X-Y robot positioning errors at all the reference mark positions are subjected to coordinate transformation (coordinate transformation in consideration of parallel deviation, inclination, and expansion/contraction rate) in the operation unit 171 and then stored in the storage section 173.

The coordinate transformation is carried out when board types selected, and the offset values obtained through the transformation are added as numerical values for the correction to the respective movement positions during the mark recognition operation, the component placing operation, and the placing offset measurement operation by the control unit 170. By thus using the offset values, the errors peculiar to the robot can be perceived as the relative displacements between the positions.

Next, the subsequent steps, i.e., steps S8 through S12 of Fig. 11 are the processes for correcting the position, inclination, and contraction of the component mounting circuit board 61 during mounting. That is, the following processes are carried out to correct the position, inclination, and contraction of the component mounting circuit board 61 during mounting.

Concretely, in step S8 of Fig. 11, the component mounting circuit board 61 is held by the conveyance table 165 and positioned in the component placing region.

Next in step S9 of Fig. 11, at least two board-reference-position calculation marks 202-1 and 202-2 of the component mounting circuit board 61 held by the conveyance table 165 are recognized, and the position coordinates of the recognized two board-reference-position calculation marks 202-1 and 202-2 are obtained.

Next, in step S10 of Fig. 11, on the basis of the position coordinates of the obtained two board-reference-position calculation marks 202-1 and 202-2, the NC coordinates of the two board-reference-position calculation marks 202-1 and 202-2 are corrected. That is, on the basis of a difference between the position coordinates of the two board-reference-position calculation marks 202-1 and 202-2 and the NC coordinates of the two board-reference-position calculation marks 202-1 and 202-2, the NC coordinates of the two board-reference-position calculation marks 202-1 and 202-2 are corrected to the position coordinates of the two board-reference-position calculation marks 202-1 and 202-2.

Next, in step S11 of Fig. 11, when the component 62 held by the component placing head 136 is positioned above each component placing position 205 of the component mounting circuit board 61, the component placing position 205 is corrected on the basis of the offset value of the reference mark 201 located nearest to the board recognition camera 140 that serves as one example of the recognition camera provided for the component placing head 136 (in other words, the offset value of the area that includes the reference mark 201 located nearest to the board recognition camera 140). Concretely, a nozzle (e.g., the nozzle located at the left end of Fig. 5) 1361, which becomes the reference of the plurality of nozzles 1361 of the head 136, is positioned at the NC coordinates of each reference mark 201 on the glass board 200 that serves as one example of the reference-mark-recognizing reference board. The offset value of the reference mark 201 located nearest to the board recognition camera 140 fixed to the head 136 is read from the storage section 173 using the camera 140, and the component placing position 205 is corrected on the basis of the read offset value.

Next, in step S12 of Fig. 11, the placing of the component 62 in the corrected component placing position 205 is carried out.

Although the offset value has been utilized in step S11 according to the above description, it is acceptable to move the board recognition camera by adding the offset value to the NC coordinate data of the board-reference-position calculation mark in step S9 and obtain the position away from the visual field center of the recognition camera.

The above is the outline of the placing position correction operation based on the measurement and the measurement results of the correction values for obtaining the offset value of each area.

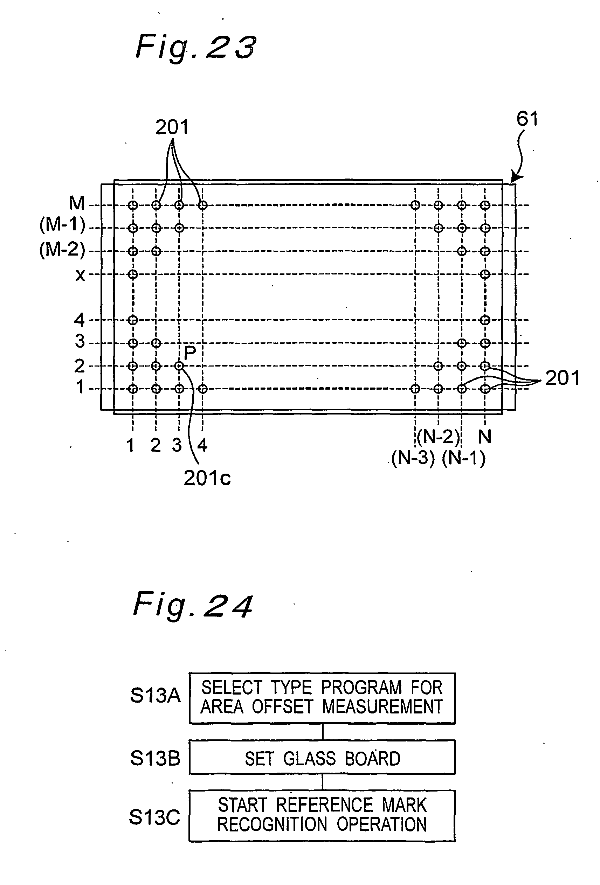

A more concrete example of the component mounting method according to the embodiment will be described below with reference to Figs. 24 through 26.

(1) First of all, for example, the reference mark recognition operation is carried out before the shipping of the component mounting apparatus from the component mounting apparatus manufacturing factory toward the user. It is to be noted that the following reference mark recognition operation is similarly carried out at the time of overhauling after the apparatus is handed over to the user.

That is, as shown in Fig. 24, the operator is urged to select the reference-mark-recognizing reference board type program for the correction value measurement for obtaining the offset value of each area on the operation screen of the component mounting apparatus in step S13A of Fig. 24. The reference-mark-recognizing reference board type program is associated with the type and size of the glass board 200 that serves as one example of the reference-mark-recognizing reference board and the data of the NC coordinate of the position of each reference mark 201 on the glass board 200. By selecting the board type, the glass board 200 is specified, and the data of the NC coordinate at the position of each reference mark 201 on the glass board 200 is transferred from the storage section 173 to the control unit 170.

As one more concrete example, when 858 reference marks constituted of 22 longitudinal rows by 39 transverse columns are arranged longitudinally and transversely at intervals of 10 mm on a glass board of a size of 410 mm × 240 mm, the coordinate of the first reference mark are (10, 10), the coordinate of the second reference mark is (20, 10), and this coordinate plotting continues to the coordinate (390, 220) of the 858-th reference mark. As another concrete example, when 2156 reference marks constituted of 44 longitudinal rows by 49 transverse columns are arranged longitudinally and transversely at intervals of 10 mm on a glass board of a size of 510 mm × 460 mm, the coordinate of the first reference mark is (10, 10), the coordinate of the second reference mark is (20, 10), and this coordinate plotting continues to the coordinate (490, 440) of the 2156-th reference mark. These are the examples of the data of the NC coordinates.

Next, while or after the data of the NC coordinates are transferred from the storage section 173 to the control unit 170, the glass board 200 on which the reference marks 201 are arranged at equal intervals in a grid form as shown in Fig. 10 is positioned in the component placing region by the conveyance table 165 of the board conveyance unit 190 in step S13B of Fig. 24 (refer to step S1 of Fig. 11).

Next, after the glass board 200 is positioned in the component placing region, the X-Y robot 120 is driven to move the head 136 in step S13C of Fig. 24 on the basis of the data of the NC coordinates at the positions of the reference marks 201 transferred from the storage section 173 and then move the board recognition camera 140 to the positions of the reference marks 201 to recognize all the reference marks 201 on the glass board 200 (refer to step S2 of Fig. 11). The position coordinate deviation (ΔX, ΔY) obtained from each recognition result of all the reference marks 201 or position coordinate (X+ΔX, Y+ΔY) that contains the deviation are stored into the storage section 173 (refer to step S3 of Fig. 11). At this time, it is acceptable to obtain the coordinate of the position of each reference mark 201 with higher accuracy by subjecting the position coordinates of each reference mark 201 to the recognition process a plurality of times.

The respective positions of the reference marks 201 are stored in the storage section 173 and managed as the respective movement positions of the component placing head 136. Therefore, according to the positioning position of the component placing head 136 during the reference mark recognition operation, the component placing operation, the placing offset value measurement operation (particularly, the placing offset value measurement operation during the placing of a chip component or a QFP component) or any one of those operations in component mounting production, it is determined by the control unit 170 which area's offset value is reflected. For example, a concrete practice has the processes of allocating a region surrounded by reference marks 201 at four points as one area, adopting the offset value of the position of any one reference mark 201 among the reference marks 201 at the four points as an area offset value of the placing position of the component 62 to be mounted within the area, and adding the offset value as the area offset value of the area to the position coordinate of the placing position to carry out the correction.

In the case of the glass board of the size of 410 mm × 240 mm of the concrete example, position coordinate deviation (-0.132, -0.051) obtained from the recognition result of the first reference mark or position coordinate (10-0.132, 10-0.051) containing the deviation is stored in the storage section 173. Moreover, position coordinate deviation (-0.132, -0.051) obtained from the recognition result of the second reference mark or position coordinate (20-0.132, 10-0.051) containing the deviation is stored in the storage section 173. Moreover, position coordinate deviation (-0.139, -0.050) obtained from the recognition result of the third reference mark or position coordinate (20-0.139, 20-0.050) containing the deviation is stored in the storage section 173. Moreover, position coordinate deviation (-0.139, -0.049) obtained from the recognition result of the fourth reference mark or position coordinate (10-0.139, 20-0.050) containing the deviation is stored in the storage section 173. The position coordinate deviation (-0.132, -0.051) of the first reference mark is adopted as the area offset value. Moreover, as another example, position coordinate deviation (-0.132, -0.051) obtained from the recognition result of the 51st reference mark or the position coordinate (210-0.132, 100-0.051) containing the deviation is stored in the storage section 173. Moreover, position coordinate deviation (-0.130, -0.067) obtained from the recognition result of the 52nd reference mark or position coordinate (220-0.130, 100-0.067) containing the deviation is stored in the storage section 173. Moreover, position coordinate deviation (-0.139, - 0.050) obtained from the recognition result of the 53rd reference mark or position coordinate (220-0.139, 110-0.050) containing the deviation is stored in the storage section 173. Moreover, position coordinate deviation (-0.139, -0.049) obtained from the recognition result of the 54th reference mark or position coordinate (210-0.139, 110-0.050) containing the deviation is stored in the storage section 173. The position coordinate deviation (-0.132, - 0.051) of the 51st reference mark is adopted as the area offset value. The operation is similarly carried out for other reference marks.

(2) Next, the production board type is selected.

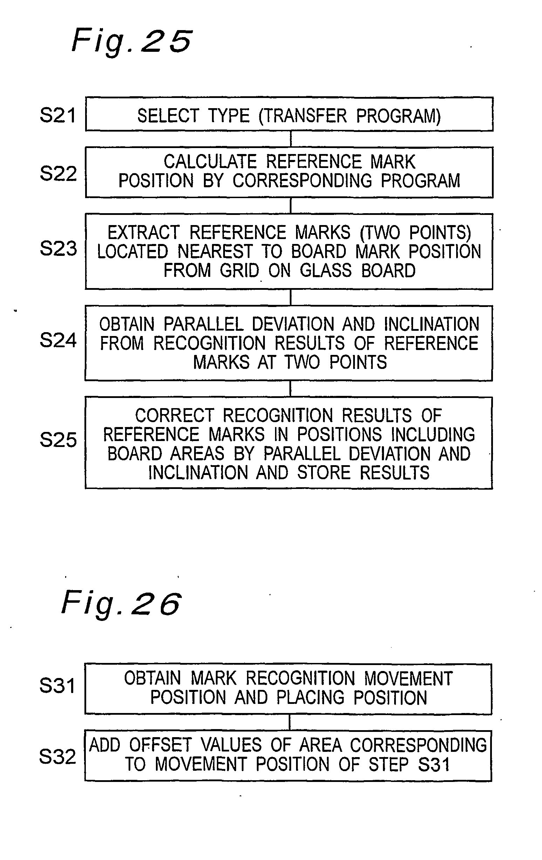

First of all, as shown in Fig. 25, in step S21, the board type selection program is transferred from the storage section 173 to the control unit 170, urging the operator to select the board type of the board 61 to be produced (subjected to mounting) on the operation screen of the component mounting apparatus. If the board type is selected by the operator, then the data of the size of the selected board and the NC coordinates of the position coordinates of the reference marks 201 are read from the storage section 173 by the control unit 170.

Next, in step S22, the position coordinates of two board-reference-position calculation marks 202-1 and 202-2 of the board 61 of the selected board type are extracted from the data of the NC coordinates read in accordance with the selected board type by the control unit 170.

In the case of the glass board of the size of 410 mm $\times$ 240 mm of the concrete example, (15, 18) and (215, 111) are extracted as the position coordinates of the board-reference-position calculation marks 202-1 and 202-2.

Next, in step S23, through the operation by the operation unit 171 on the basis of the data stored in the storage section 173, the reference marks 201 on the glass board 200 located nearest to the two board-reference-position calculation marks 202-1 and 202-2 are extracted one for each. For example, in Fig. 22, the first reference mark 201a located at the lower left is extracted for the first board-reference-position calculation mark 202-1, and the 52nd reference mark 201b located at the lower right is extracted for the second board-reference-position calculation mark 202-2.

In the case of the glass board of the size of 410 mm $\times$ 240 mm of the concrete example, the position coordinate (10, 10) of the first reference mark 201a at the lower left is extracted for the position coordinate (15, 18) of the first board-reference-position calculation mark 202-1, and the position coordinate (210, 110) of the 52nd reference mark 201b at the lower right is extracted for the position coordinate (215, 111) of the second board-reference-position calculation mark 202-2.

Next, in step S24, the parallel deviation, the inclination, and the expansion/contraction rate are obtained through the operation by the operation unit 171 from the recognition results of the first reference mark 201a and the 52nd reference mark 201b of the extracted two points.

Concretely, among the first reference mark 201a and the 52nd reference mark 201b of the two points, the parallel deviation is considered with the first reference mark 201a served as a reference.

Therefore, assuming that the offset value of the first reference mark 201a is ($\Delta X_a$, $\Delta Y_a$), then the amount of parallel deviation ($\Delta X_{ab}$, $\Delta Y_{ab}$) can be expressed by the following Equations (6).

Eq. (6):

$$\Delta X_{ab} = \Delta X_a$$

$$\Delta Y_{ab} = \Delta Y_a$$

In the case of the glass board of the size of 410 mm $\times$ 240 mm of the concrete example, assuming that the area offset value of the first reference mark 201a is (-0.132, - 0.051), then the amount of parallel deviation becomes (-0.132, -0.051) according to the Equations (6).

On the other hand, the inclination of the glass board 200 is expressed by an angle made between a straight line that connects the NC coordinates of the first reference mark 201a and the 52nd reference mark 201b and a straight line that connects the coordinates obtained by adding the respective offset values to the NC coordinates of the first reference mark 201a and the 52nd reference mark 201b.

Assuming that the NC coordinates of the first reference mark 201a and the 52nd reference mark 201b are $(X_a, Y_a)$ and $(X_b, Y_b)$, and the offset values of the first reference mark 201a and the 52nd reference mark 201b are $(\Delta X_a, \Delta Y_a)$ and $(\Delta x_b, \Delta Y_b)$, respectively, then an inclination $\Delta\theta_{ab}$ of the first reference mark 201a and the 52nd reference mark 201b can be expressed by the following Equations (7).

Eq. (7):

$$\Delta\theta_{ab} = \tan^{-1}\{(Y_b - Y_a)/(X_b - X_a)\} - \tan^{-1}[\{(Y_b + \Delta Y_b) - (Y_a + \Delta Y_a)\}/\{(X_b + \Delta X_b) - (X_a + \Delta X_a)\}]$$

In the case of the glass board of the size of 410 mm $\times$ 240 mm of the concrete example, assuming that the NC coordinates of the first reference mark 201a and the 52nd reference mark 201b are (10, 10) and (210, 110), and the offset values of the first reference mark 201a and the 52nd reference mark 201b are (-0.132, -0.051) and (-0.130, - 0.067), respectively, then, according to the Equations (7), the inclination $\Delta\theta_{ab}$ of the first reference mark 201a and the 52nd reference mark 201b becomes expressed by the following Equations (8).

Eq. (8):

$$\Delta\theta_{ab} = \tan^{-1}\{(110 - 10)/(210 - 10)\} - \tan^{-1}[\{(110 - 0.067) - (10 - 0.051)\}/\{(210 - 0.130) - (10 - 0.132)\}]$$

$$= -0.004125°$$

Next, in step S25, the position coordinates of the positions of all the reference marks 201, which have been stored in step S3 of Fig. 11 and correspond to the regions of the board 61 to be subjected to mounting, are corrected through calculation by the parallel deviation and the inclination (and the expansion/contraction rate) in the operation unit 171, and the position coordinates of the reference marks 201 after the correction are stored in the storage section 173. Concretely, the correction values of the reference marks 201 are to be corrected in consideration of the parallel deviations, the inclination, and the expansion/contraction rate of the first reference mark 201a and the 52nd reference mark 201b, and thereafter stored as offset values in the storage section 173. Assuming herein that the parallel deviation is $(\Delta X_{ab}, \Delta Y_{ab})$, the inclination is $\Delta\theta_{ab}$, the expansion/contraction rate is E and the NC coordinate of the first reference mark 201a is $(X_a, Y_a)$, the NC coordinate of an arbitrary reference mark 201 of the object to be corrected is $(X_{nc}, Y_{nc})$ and the offset value is $(\Delta X_R, \Delta Y_R)$, then the offset value $(\Delta X_{off}, \Delta Y_{off})$ of each reference mark 201 after the correction can be expressed by the following equations (9).

Eq. (9):

$$X_{off} = E\{((X_{nc} + \Delta X_R) - X_a)\}\cos\Delta\theta_{ab} - ((Y_{nc} + \Delta Y_R) - Y_a)\sin\Delta\theta_{ab}\} - (X_{nc} - X_a) + \Delta X_{ab}$$

$$Y_{off} = E\{((X_{nc} + \Delta X_R) - X_a)\}\sin\Delta\theta_{ab} + ((Y_{nc} + \Delta Y_R) - Y_a)\cos\Delta\theta_{ab}\} - (Y_{nc} - Y_a) + \Delta Y_{ab}$$

In the case of the glass board of the size of 410 mm $\times$ 240 mm of the concrete example, assuming that the parallel deviation is (-0.132, -0.050), the inclination $\Delta\theta_{ab}$ is 0.004125°, the expansion/contraction rate E is 1.000026, the NC coordinate of the first reference mark 201a is (10, 10) and the offset value is (-0.132, -0.050), then the offset value ($\Delta X_{off}$, $\Delta Y_{off}$) of the first reference mark 201 after the correction becomes (0, 0). Likewise, assuming that the NC coordinate of the reference mark 201 of the 15-row and 8-column of the object to be corrected is (150, 80) and the offset value is (-0.132, -0.060), then the offset value ($\Delta X_{off}$, $\Delta Y_{off}$) of the reference mark 201 after the correction becomes (-0.001, -0.015).

(3) Next, the reference mark recognition and the component placing operation are carried out.

First of all, as shown in Fig. 26, in step S31, the control unit 170 reads the position, to which the head 136 should move for the reference mark recognition operation or the component placing operation or the placing offset value measurement operation, from the mounting data in the storage section 173 and obtains the recognition position or the placing position.

At this time, for example, during the component placing operation, when the head 136 is moved by the X-Y robot 120 and stopped in a certain movement position and a certain component 62 sucked and held by a certain nozzle 1361 of the head 136 is positioned above the placing position after the correction of the component 62 on the board 61 to be ready for the placing operation, the reference mark 201 located nearest to the visual field center of the board recognition camera 140 of the head 136 at the time is regarded as the reference mark 201 for the component 62.

Likewise, during the reference mark recognition operation, when the head 136 is moved by the X-Y robot 120 and stopped in a certain movement position and a certain nozzle 1361 of the head 136 is positioned above a certain reference mark 201 after the correction of the reference-mark-recognizing reference board 200, the reference mark 201 located nearest to the visual field center of the board recognition camera 140 of the head 136 at the time is regarded as the reference mark 201 for the certain reference mark 201.

Moreover, similarly, during the placing offset value measurement operation, the head 136 is moved by the X-Y robot 120 and stopped in a certain movement position and a certain nozzle 1361 of the head 136 is positioned above a certain board-reference-position calculation mark 202-1 or 202-2 after the correction of the reference-mark-recognizing reference board 200, the reference mark 201 located nearest to the visual field center of the board recognition camera 140 of the head 136 at the time is regarded as the reference mark 201 for the board-reference-position calculation mark 202-1 or 202-2.

Next, in step S32, the offset value of the area corresponding to the movement position of the head 136 in step S31 is added to the position coordinate of the movement position of the head 136 by the operation unit 171. Concretely, as shown in Fig. 23, when there are reference marks 201 constituted of M rows in the longitudinal direction by N columns in the transverse direction of the board 61 to be subjected to mounting (accordingly, a total of M $\times$ N reference marks 201), a region (the region indicated by P in Fig. 23) surrounded by the reference marks 201 at four points is allocated as one area. Correction is carried out by adopting the offset value of any one of the reference marks 201 at the four points or, for example, the position of a reference mark 201c located at the lower left as the area offset value for the position coordinate in the placing position of the component 62 to be mounted in the area (or the position coordinate of an individual mark that becomes a criterion of the placing position) and adding the offset value as the area offset value to the position coordinate in the mounting position (or the position coordinate of the individual mark that becomes the criterion of the placing position).

Next, by moving the head 136 to the corrected position coordinates, highly accurate positioning can be secured, and the reference mark recognition operation or the component placing operation or the placing offset value measurement operation can be carried out with high accuracy. Particularly, during the component placing operation, the area offset values can be used as numerical values for correcting individual marks for discrete components such as IC components (BGA components, etc.) that require high placing accuracy (e.g., the X-Y robot positioning accuracy is about $\pm 2$ $\mu$m, and the total accuracy of the mounting apparatus is about $\pm 20$ $\mu$m).

When the position coordinate (position coordinate) of the recognized reference mark 201 are stored in the storage section 173 in step S3 of Fig. 11, the following corrections may be further added. That is, the position coordinate of each reference mark 201 is calculated by recognizing the reference marks 201A and 201B at two points located at the lower left and the upper right of the glass board 200 as shown in Fig. 12, obtaining the parallel deviation and the inclination of the glass board 200 with respect to the conveyance table 165, and calculating the recognition positions of all the reference marks 201 to be measured in the operation unit 171 in consideration of the obtained correction values. Also, the expansion/contraction rate E is assumed to be one for such calculations of the recognition positions of the individual reference marks 201 in consideration of the parallel deviation and inclination of the glass board 200.

The parallel deviation of the glass board 200 is considered on the basis of the reference mark 201A used as a reference out of the reference marks 201A and 201B at the two points. Moreover, the center of the board recognition camera 140 is moved to the position of the reference mark 201 in the NC coordinates when the reference marks 201A and 201B are recognized. Therefore, the amount of parallel deviation ($\Delta X$, $\Delta Y$) becomes position coordinate deviation (the amount of deviation from the center of the recognition visual field of the board recognition camera 140) obtained from the recognition results of the reference mark recognition.

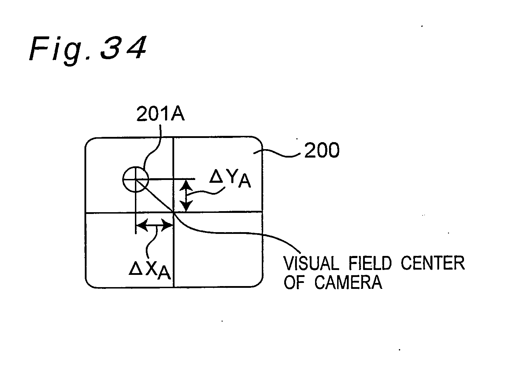

Therefore, assuming that the position coordinate deviation obtained from the recognition result of the reference mark 201A is ($\Delta X_A$, $\Delta Y_A$) (see Fig. 34), then the amount of parallel deviation ($\Delta X_g$, $\Delta Y_g$) of the glass board 200 can be expressed by the following equations (10).

$$\text{Eq. (10):}$$

$$\Delta X_g = \Delta X_A$$

$$\Delta Y_g = \Delta Y_A$$

It is to be noted that coordinate transformation from the position coordinate system to the NC coordinate system is carried out.

Moreover, the inclination of the glass board 200 is assumed to have an angle $\Delta\theta$ made between a straight line that connects the reference mark 201A and the reference mark 201B on the NC coordinates and a straight line that connects the recognized reference mark 201A' and reference mark 201B'.

That is, assuming that the NC coordinates of the reference marks 201A and 201B are $(X_A, Y_A)$ and $(X_B, Y_B)$ and the position coordinate deviations (the amounts of deviations from the visual field center) obtained from the recognition results when the reference marks 201A and 201B are recognized are $(\Delta X_A, \Delta Y_A)$, $(\Delta X_B, \Delta Y_B)$, then the board inclination $\Delta\theta_g$ can be expressed by the following equations (11).

$$\text{Eq. (11):}$$

$$\Delta\theta_g = \tan^{-1}\{(Y_B - Y_A)/(X_B - X_A)\} - \tan^{-1}[\{(Y_B + (-\Delta Y_B)) - (Y_A + (-\Delta Y_A))\}/\{(X_B + \Delta X_B) - (X_A + \Delta X_A)\}]$$

$$= \tan^{-1}\{(Y_B - Y_A)/(X_B - X_A)\} - \tan^{-1}[\{(Y_B - \Delta Y_B) - (Y_A - \Delta Y_A)\}/\{(X_B + \Delta X_B) - (X_A + \Delta X_A)\}]$$

It is to be noted that coordinate deformation from the position coordinate system to the NC coordinate system is carried out.

Therefore, the position coordinate of each recognized reference mark 201 is calculated by the operation unit 171 in consideration of the parallel deviation and the inclination of the glass board 200. In this case, assuming that the parallel deviation is ($\Delta X_g$, $\Delta Y_g$), the inclination is $\Delta\theta_g$, the NC coordinate of the reference mark 201A is $(X_A, Y_A)$ and the NC coordinate of the reference mark N located in an arbitrary position on the glass board 200 is $(X_N, Y_N)$, then the recognition position ($X_{RN}$, $Y_{RN}$) of the reference mark N in an arbitrary position is expressed by the equations (12).

$$\text{Eq. (12):}$$

$$X_{RN} = (X_n - X_A)\cos\theta - (Y_m - Y_A)\sin\theta + \Delta X_g$$

$$Y_{RN} = (X_n - X_A)\sin\theta + (Y_m - Y_A)\cos\theta + \Delta Y_g$$

Therefore, the recognition position of the thus obtained reference mark N may be stored as the position coordinate (position coordinate) of the recognized reference mark 201 into the storage section 173 in step S3 of Fig. 11. By performing such a process of obtaining the recognition position of each reference mark in consideration of parallel deviation and inclination of the glass board 200, i.e. the coordinate transformation process, as shown above, each reference mark can reliably be positioned within the visual field of the board recognition camera 140 so that occurrence of recognition errors can be prevented beforehand.

According to the first embodiment, by recognizing the reference marks 201 arranged at specified intervals on the glass board 200 that serves as one example of the reference-mark-recognizing reference board, determining the offset value of each area corresponding to the board size as the area offset value from the recognition results, and reflecting the corresponding area offset values of the movement positions of the component placing head 136 as the numerical values for correction during the placing position correction, mark recognition and correction, and the placing position offset value measurement operation, or any one of those operations, the deviation factor due to the distortion of the X-Y robot operation is absorbed, and optimum offset values corresponding to the board size are obtained, allowing the placing to be achieved with high accuracy.

Moreover, by reflecting the area offset values corresponding to the movement positions of the component placing head 136 as the numerical values for correction also when the reference mark is recognized, the deviation factor due to the distortion of the X-Y robot operation is absorbed, and optimum offset values corresponding to the board size are obtained, allowing the placing to be achieved with higher accuracy.

It is to be noted that the present invention is not limited to the embodiment but allowed to be implemented in various forms.

For example, the two of the first and 52nd reference marks 201a and 201b or 201A and 201B or 202-1 and 202-2 are merely required to be located at different positions diagonally separated on the reference-mark-recognizing reference board or the board to be subjected to mounting or different positions along either one of the X- and Y-directions, or in other words, two arbitrary different points other than an identical point.

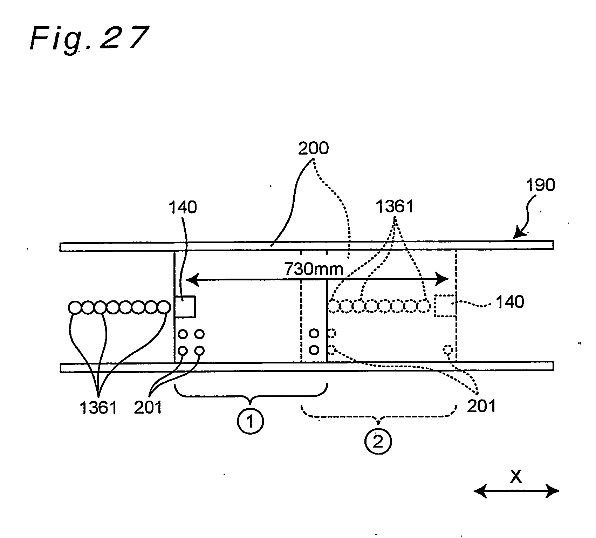

Moreover, when the reference-mark-recognizing reference board 200 is smaller than the board 61 to be subjected to mounting, it is proper to manage the data by recognizing and obtaining the position coordinates of the reference marks 201 in a state in which the reference-mark-recognizing reference board 200 is positioned in either one end of the component placing region of the board 61 to be subjected to mounting, thereafter recognizing and obtaining again the position coordinates of the reference marks 201 by moving the reference-mark-recognizing reference board 200 to the other end of the component placing region of the board 61 to be subjected to mounting, and recognizing and obtaining the position coordinates of the reference marks 201 by means of one large virtual reference-mark-recognizing reference board 200 as if common portions were overlapped. For example, concretely as shown in Fig. 27, data (1) of the position coordinates of the reference marks 201 measured in the normal position of the board and data (2) of the position coordinates of the reference marks 201 measured in a position moved leftward by 350 mm are combined with each other. The data (1) and data (2) are subjected to only rotational and shifting corrections so that they have common portions coinciding with each other. Since the common portions do not coincide with each other when the expansion/ contraction rate is added, the rate is not considered.

(Working Examples)

There are shown examples of a change in the amount of deviation and a change in the component placing accuracy between when the offset values of the areas according to the first embodiment are not effected and when the values are effected.

The offset values of the areas were measured by using the reference marks 201 of the board of a size of 428 mm $\times$ 250 mm shown in Fig. 27.

In Fig. 27, when the reference marks 201 are recognized, the visual field center of the board recognition camera 140 is located in a position 60 mm apart from the center of the nozzle 1361 located at the right end in the X-direction (i.e., in the rightward direction in Fig. 27) in terms of the arrangement of the head 136. Therefore, in order to allow all the nozzles 1361 including the nozzle located at the left end and the nozzle located at the right end to be positioned in every region on the board 61, the board recognition camera 140 is required to be moved in the X-direction (i.e., in the rightward direction in Fig. 27) by 720.5 mm (XL = board width 510 mm + 60 mm + distance 150.5 mm between both end nozzles) from the position of the board stopper that is brought into contact with the left end of the board 61 and positions the board 61 in the placing position of the conveyance table 165.

However, in the case where the reference-mark-recognizing reference board used in recognizing the reference mark 201 is located within a range of 410 mm in the X-direction from the position of the board stopper, the range of the entire region (0 mm to 720.5 mm) of the board 61 can be covered by recognizing twice the reference marks 201 with the reference-mark-recognizing reference board shifted in the X-direction.

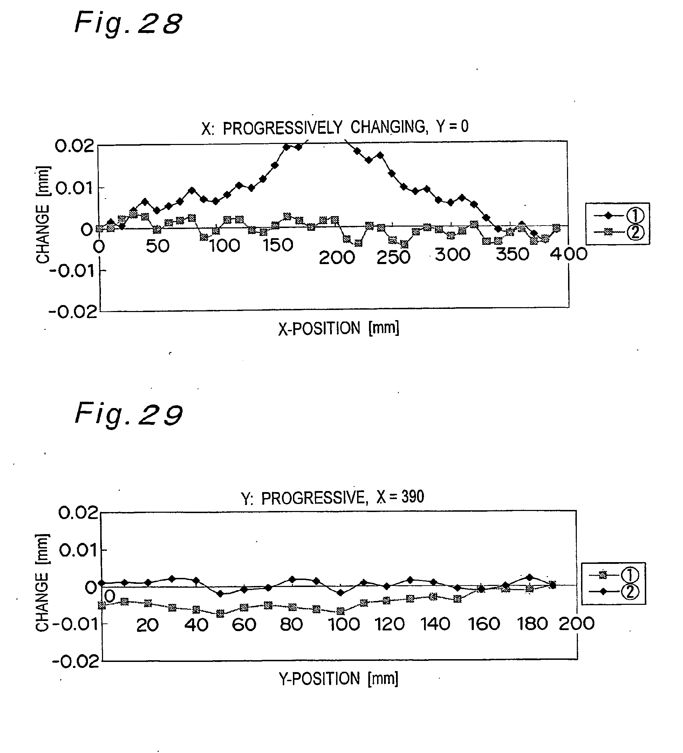

In the graphs shown in Figs. 28 and 29, output data of the position coordinate deviation obtained from the recognition results when the offset values of the areas are used are plotted. The two graphic lines of Fig. 28 show the relation between the position in the X-direction and the amount of deviation in the X-direction when the head 136 is moving in the X-direction at 10-mm pitches. The graphic line (1) indicates the relation before the use of the offset values of the areas, and the line (2) indicates the relation after the use of the offset values of the areas. The two graphic lines of Fig. 29 show the relation between the position in the Y-direction and the amount of deviation in the Y-direction when the head 136 is moving in the Y-direction at 10-mm pitches. The graph line (1) indicates the relation before the use of the offset values of the areas, and the line (2) indicates the relation after the use of the offset values of the areas.

In Fig. 28, with regard to the graphic line (1), in the X-direction, before the use of the offset values of the areas, a maximum of 20 $\mu$m of an error occurs in the position where the board stopper is moved by 200 mm exhibiting an upwardly protruding configuration before the use of the offset values of the areas. In contrast to this, the graphic line (2) after the correction exhibits a transition at almost zero level.

According to the graph of Fig. 29, in the Y-direction, the graphic line (1) of the relation before the use of the offset values of the areas exhibit a transition with slight inclinations, whereas the graphic line (2) after the use of the offset values of the areas exhibits a transition at almost zero level similarly to the X-direction.

The graphic lines (2) after the use of the offset values of the areas in Figs. 28 and 29 have errors falling within a range of $\pm 5$ $\mu$m in each of the X-direction and the Y-direction.

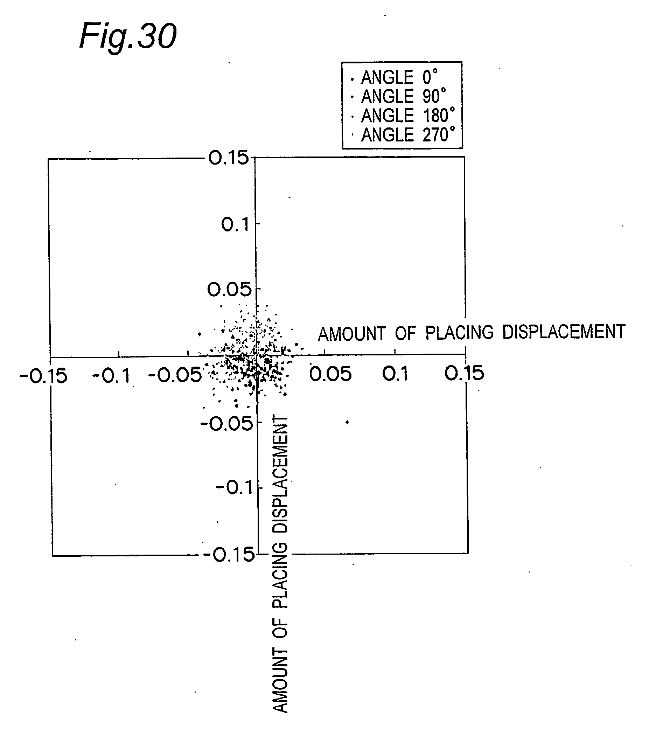

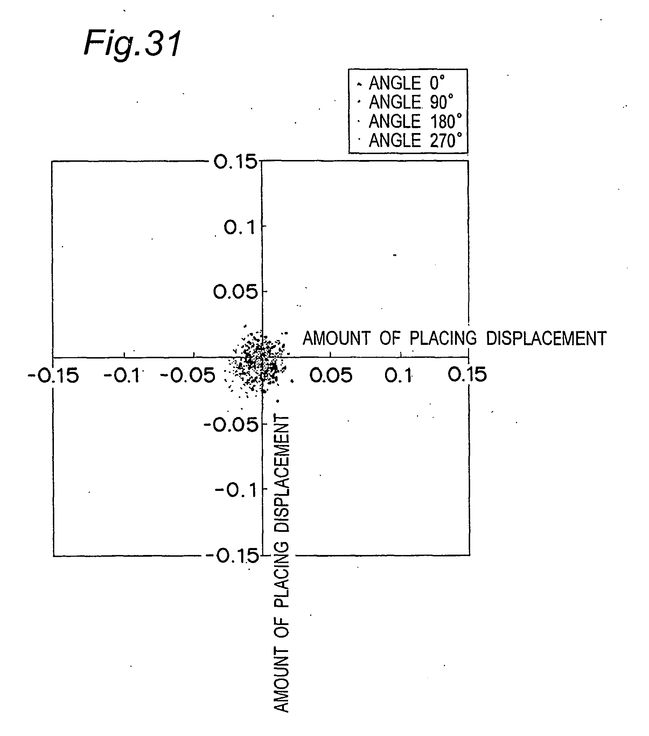

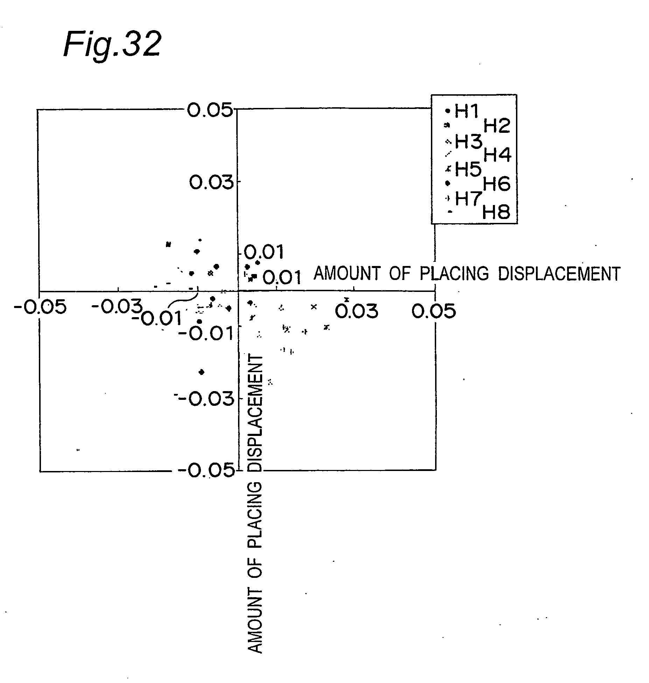

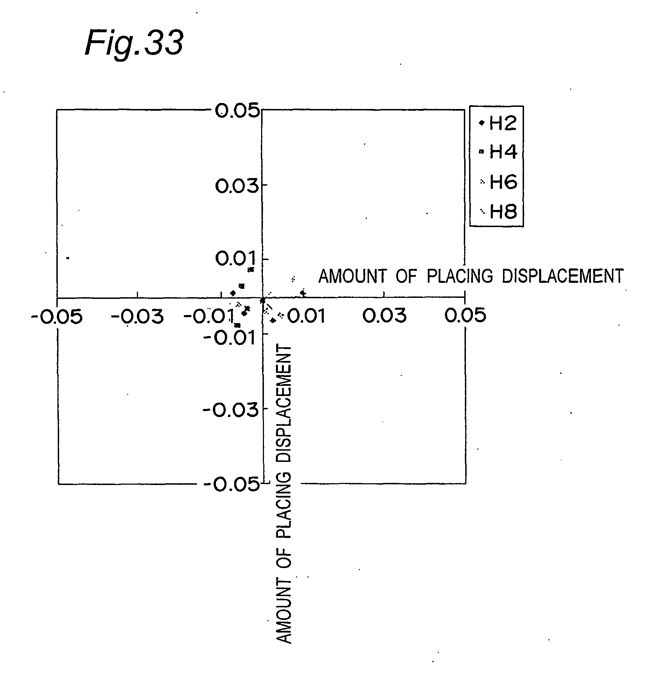

Next, with regard to a change in the component placing accuracy, Fig. 30 shows the placing accuracy in a case where the offset values of the areas according to the embodiment are not used when 400 ceramic capacitors, each of which is a chip component having a size of 1.6 mm $\times$ 0.8 mm, are placed on a board of a size of 428 mm $\times$ 250 mm, while Fig. 31 shows the placing accuracy in a case where the offset values of the areas of the embodiment according to the embodiment are used. Moreover, in a case where numbers of QFP components are placed on a board, Fig. 32 shows the placing accuracy when the offset values of the areas according to the embodiment are not used, while Fig. 33 shows the mounting accuracy when the offset values of the areas according to the embodiment are used. The dimensional values are each on the millimeter order in the figures.

According to the above results, a tendency of improvement in the placing accuracy in the X-direction and the Y-direction are observed as shown in Figs. 31 and 33. That is, it can be understood that the amount of deviation between the corrected placing position data and the true placing position data is reduced also numerically in comparison with the case where the offset values of the areas according to the embodiment are not used.

As a concrete numerical value in one example, the correction value is about 10 $\mu$m to 30 $\mu$m. When a board of 400 mm $\times$ 250 mm, which serves as one example of the small board, is subjected to coordinate transformation, the expansion/contraction rate is about 1.000025. When a board of 600 mm $\times$ 250 mm, which serves as one example of the large board, is subjected to coordinate transformation, the expansion/contraction rate is about 1.00005. Besides the boards, this method is effective also for a small board of a size of 100 $\times$ 100 mm.

The present invention is applicable to the mounting of almost all the electronic components to be placed and applicable to, for example, rectangular chip capacitors, rectangular chip resistors, small components such as transistors, ICs of the objectives of fine pitch mounting such as QFP or BGA.

It is also possible to measure the movement position of the board camera section by means of a laser scale (laser measuring instrument) instead of measuring the reference-mark-recognizing reference board by means of the camera (in this case, the reference-mark-recognizing reference board becomes unnecessary).

In addition to the correction by means of the area offset values, the accuracy can be further improved by reflecting the area offset values in the measurement positions of "board camera offset value" and the "nozzle pitch" during the camera calibration on the "board camera offset value" and the "nozzle pitch" used for the head movement position calculation during the operations of the mark recognition operation (board mark recognition, individual mark recognition corresponding to IC components, pattern mark recognition indicated on the individual boards of multiple printed board, recognition of group mark indicated every component group, recognition of bad mark indicating defectiveness), component placing operation, placing offset value measurement operation, and reference mark recognition.

Although the offset values of the board recognition camera 140 and the nozzle pitch (distance between the nozzles of a plurality of nozzles) are obtained during the camera calibration, the correction values of each area for correcting the distortion of the X-Y robot are not reflected in the process of obtaining them. Therefore, by reflecting the correction values in the offset values of the board recognition camera 140 and the nozzle pitch used in obtaining the head movement position during the mark recognition and the component placing operation and/or the placing offset value measurement operation, placing can be achieved with higher accuracy. The offset values of the board recognition camera 140 and the nozzle pitch are given as distances from the first nozzle 1361-1. Therefore, when the correction values are reflected in the offset values of the board recognition camera 140 and the nozzle pitch used in obtaining the head movement position during the mark recognition and the component placing operation and/or the placing offset value measurement operation, differences between the board camera offset values or the area offset values during the nozzle pitch measurement and the area offset values during the measurement of the position of the first nozzle 1361-1 are reflected in each operation.

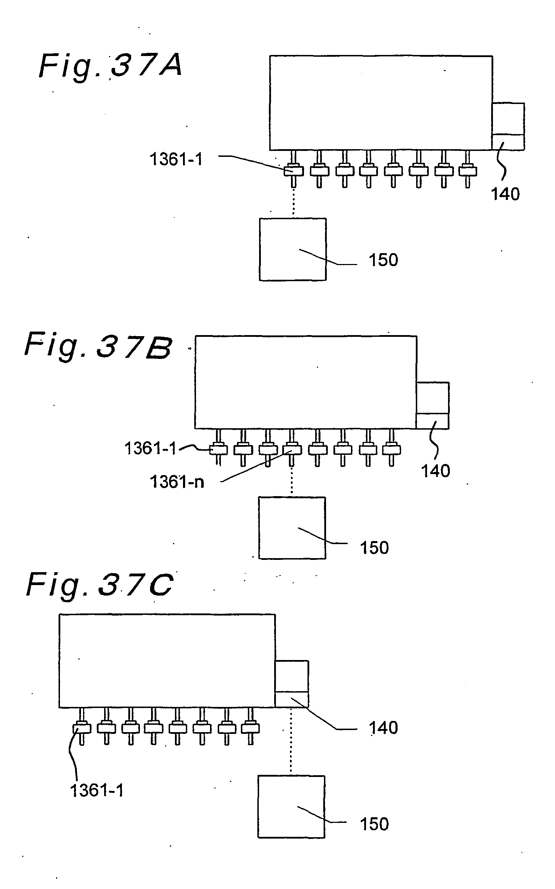

Reference is made below to Figs. 37A, 37B and 37C that show the positional relation between the nozzle, the component recognition camera 150, and the board recognition camera during measurement.

When the position of the first nozzle (assumed to be a reference nozzle) 1361-1 is measured as shown in Fig. 37A, the first nozzle 1361-1 is positioned above the component recognition camera 150, and the position of the first nozzle 1361-1 is measured. The value of the position of the first nozzle 1361-1 obtained through the measurement in this state is assumed to be an area offset value (X1, Y1).

Subsequently, when measuring the nozzle pitch to the n-th nozzle 1361-n as shown in Fig. 37B, the n-th nozzle 1361-n is positioned above the component recognition camera 150, and the position of the n-th nozzle 1361-n is measured. The value of the position of the n-th nozzle 1361-n measured in this state is assumed to be an area offset value (Xn, Yn). The head shown in Figs. 37A through 37C has a total of eight nozzles, and therefore, the measurement is successively carried out for the number n from 2 to 8, setting the results as the area offset values of the first nozzle 1361-1.

Subsequently, when the board camera 140 is measured as shown in Fig. 37C, the board camera 140 is positioned above the component recognition camera 150, and the position of the board camera 140 is measured. The value of the position of the board camera 140 obtained through the measurement in this state is assumed to be an area offset value (Xp, Yp).

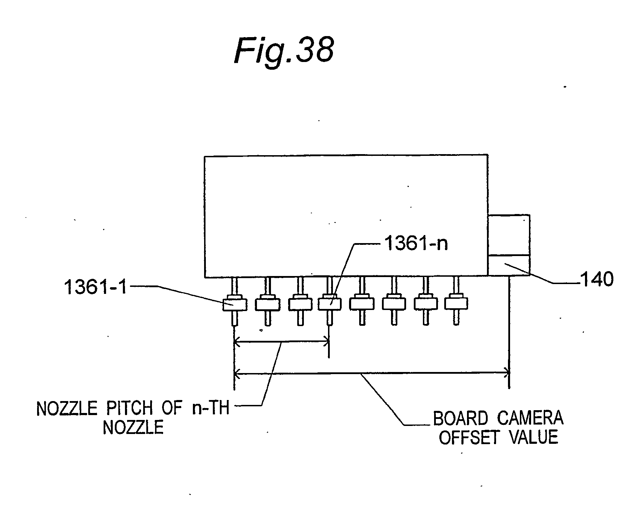

As shown in Fig. 38, the offset value of the board camera and the nozzle pitch are given as distances from the first nozzle 1361-1. Therefore, when the area offset value is reflected, difference between the board camera offset value or the area offset value during the nozzle pitch measurement and the area offset value during the measurement of the position of the first nozzle 1361-1 are reflected in each operation.

For example, reference is made to Fig. 38, assuming that the area offset value during the measurement of the position of the first nozzle 1361-1 in the camera calibration stage is (X1, Y1), the area offset value during the nozzle pitch measurement of the n-th nozzle 1361-n in the camera calibration stage is (Xn, Yn), and the area offset value during the board camera offset value measurement in the camera calibration stage is (Xp, Yp), then the area offset value to be reflected in the "board camera offset value" in each operation becomes (Xp-X1, Yp-Y1). Further, the area offset values reflected in the "nozzle pitch" of the n-th nozzle 1361-n during the component placing operation become (Xn-X1, Yn-Y1).

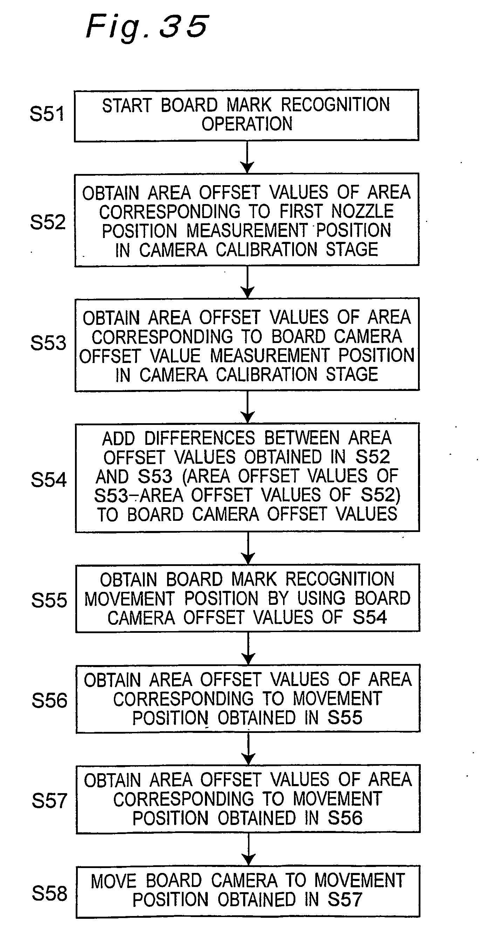

As shown in the flowchart of Fig. 35, an area offset value corresponding to the positional measurement position of the first nozzle 1361-1 in the camera calibration stage is obtained in step S51 during the reference mark recognition operation.

Further, an area offset value corresponding to the board camera offset value measurement position in the camera calibration stage is obtained in step S52.

Next, when the area offset value is reflected in the board camera offset value in step S53, then the movement position of the head 136 is obtained, and the area offset value corresponding to the movement position of the head 136 is obtained in step S22 (Fig. 25). Further, an area offset value corresponding to the position in which the first nozzle (the nozzle of which the position becomes the reference position of the nozzle pitch and the board camera offset value) 1361-1 is located above the recognition camera is obtained in step S23 (Fig. 25), and an area offset value corresponding to the position in which the board camera 140 is located above the recognition camera is obtained in step S24 (Fig. 25). The area offset value obtained in step S22 during the reference mark recognition operation is reflected in step S25, and difference between the area offset value obtained in step S23 and the area offset value obtained in step S24 (area offset value obtained by subtracting the area offset value obtained in step S23 from the area offset values obtained in step S24) is reflected in step S54. Concretely, difference between the area offset value obtained in step S52 and the area offset value obtained in step S53 (area offset value obtained by subtracting the area offset values of step S52 from the area offset value of step S53) is added to the board camera offset value in step S54. Next, the board mark recognition movement position is obtained in step S55 by using the board camera offset value of step S54. Next, an area offset value corresponding to the movement position obtained in step S55 is obtained in step S56. Next, an area offset value corresponding to the movement position obtained in step S56 is added in step S57. Next, the board camera is moved in step S58 to the movement position obtained in step S57.

With this arrangement, the area offset value due to the distortion of the X-Y robot operation contained in the nozzle pitch and the board camera offset value can be reflected, allowing the placing to be achieved with higher accuracy.

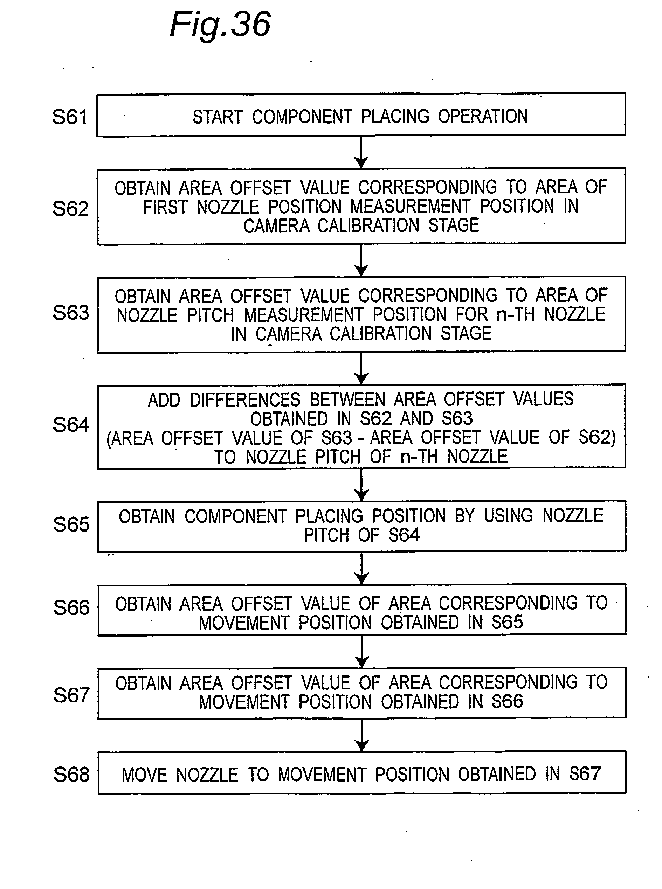

The flowchart of Fig. 36 shows a procedure for carrying out the component placing operation by reflecting the area offset value in the nozzle pitch measurement position.

First of all, the area offset values of the first nozzle and the n-th nozzle in the camera calibration stage are obtained as described above in steps S62 and S63. That is, an area offset value of the area corresponding to the positional measurement position of the first nozzle in the camera calibration stage is obtained in step S62. Next, an area offset value corresponding to the area of the n-th nozzle pitch measurement position in the camera calibration stage is obtained in step S63.

Next, difference between the area offset values obtained in steps S62 and S63 (area offset value obtained by subtracting the area offset value of step S62 from the area offset value of step S63) is added to the n-th nozzle pitch in step S64.

Next, the component placing position is obtained in step S65 by using the nozzle pitch of step S64.

Next, an area offset value corresponding to the movement position obtained in step S65 is obtained in step S66.

Next, an area offset value of the area corresponding to the movement position obtained in step S66 is added in step S67.

Next, the nozzle is moved in step S68 to the movement position obtained in step S67.


(Second Embodiment)

The present invention is not limited to the above-described embodiment and may be embodied in other various forms. A component mounting method and apparatus according to a second embodiment of the present invention will be described below.

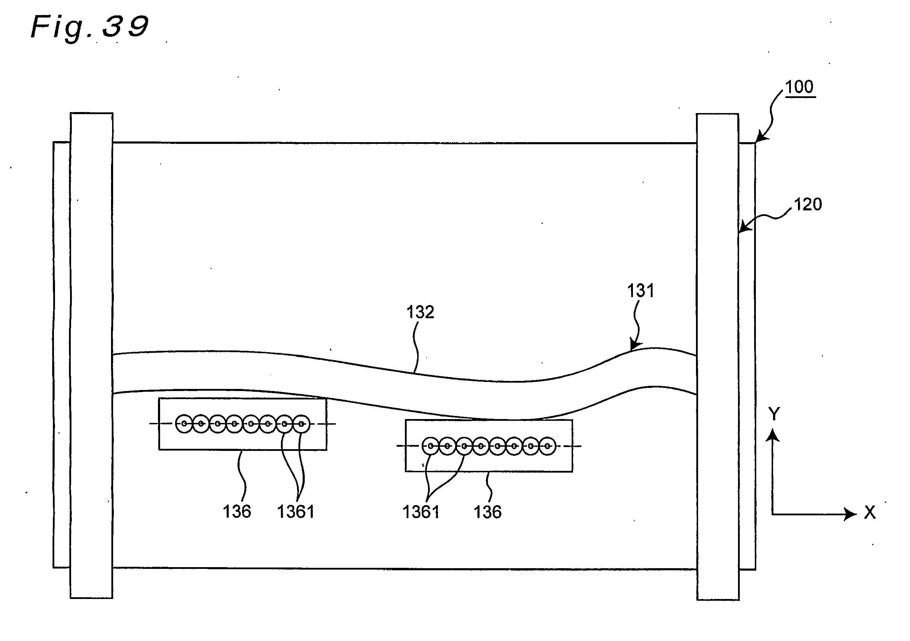

In the component-placing-position correction method for component mounting described in the foregoing first embodiment, it is assumed that the posture of the component placing head 136 does not change during the move by the X-Y robot 120. More specifically, for example, in the case where the component placing head 136 supported by the X-axis robot 131 is moved from position A to position B along the X-axis direction as viewed in the figure by the X-axis robot 131 as shown in the schematic plan view of the component mounting apparatus 100 of Fig. 39, it is assumed that the component placing head 136 is moved while it is constantly held in its posture generally parallel to the X-axis frame 132 of the X-axis robot 131.

However, the X-axis frame 132, more particularly, the linear guide (not shown) that is a guide member attached to the X-axis frame 132 to guide the back-and-forth movement of the component placing head 136 also the X-axis direction in the figure, although formed with high accuracy so as to be capable of moving linearly, yet is hard to form into a perfectly linear form, actually. In particular, when both end portions serve as movement ends by the Y-axis robot 121 as in the X-axis frame 132, the linear guide becomes harder to hold in the linear form. Therefore, as shown in Fig. 39, the movement locus, along the X-axis direction as in the figure, of the component placing head 136 guided by the linear guide of the X-axis frame 132 results in a locus curved along the linear guide other than a linear one. In consideration of such circumstances, the correction method of the first embodiment is based on an assumption that even if the component placing head 136 is moved so as to draw a curved locus as described above, the posture of the component placing head 136 is held parallel to the X-axis direction in the figure at individual movement positions.

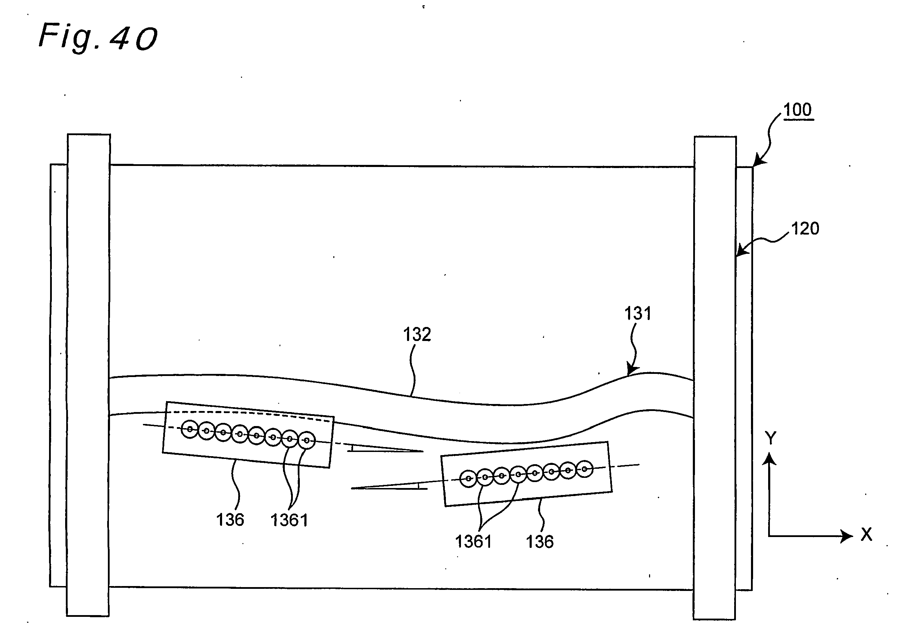

However, as shown in the schematic view of the component mounting apparatus of Fig. 40, the curved movement locus of the component placing head 136 causes the component placing head 136 as well to change in posture at the individual movement positions. That is, the posture (inclination with respect to the X-axis direction) of the component placing head 136 changes at a movement position C and a movement position D, which are arbitrary movement positions of the component placing head 136, so that the component placing head 136, while changing in its inclination, is moved back and forth along the X-axis direction as viewed in the figure by the X-axis robot 131. As the inclination of the component placing head 136 changes depending on its movement positions, the position of each component suction nozzle 1361 also yields to a displacement. To solve such a displacement is the object of the component mounting method of this second embodiment, which will be described in detail below. The component mounting method of the second embodiment is based on the component mounting method of the foregoing first embodiment, and so its overlapping parts in processing operation and construction are omitted in the description and possible to be understood with reference to the description of the first embodiment. In the construction of the component mounting apparatus described below, component parts and the like having the same construction as those of the component mounting apparatus 100 of the first embodiment are designated by like reference numerals for an easier understanding of the description.

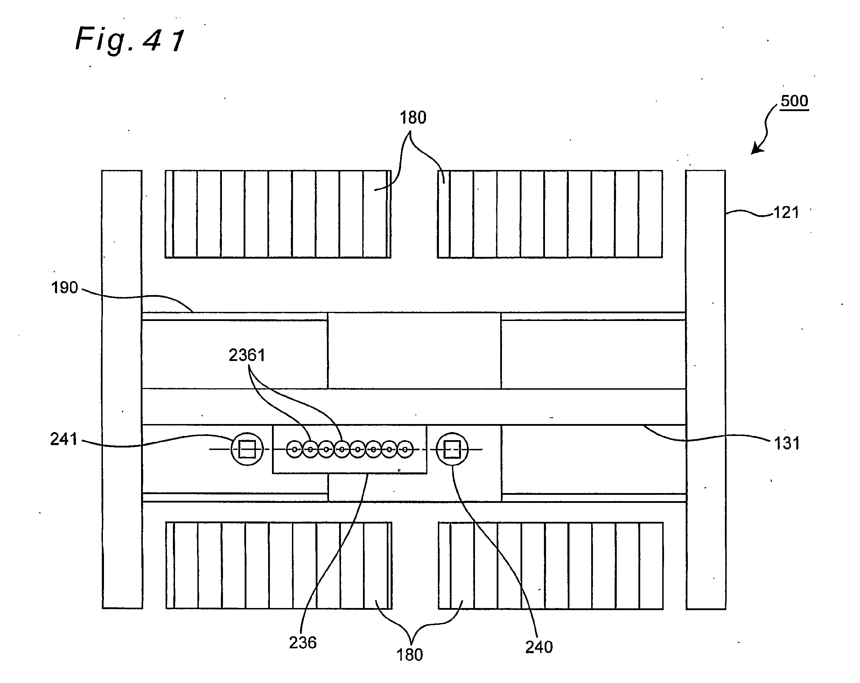

First, a schematic plan view showing a schematic construction of a component mounting apparatus 500 of the second embodiment is shown in Fig. 41. As shown in Fig. 41, the component mounting apparatus 500, although having a construction generally similar to that of the component mounting apparatus 100 of the first embodiment, differs therefrom in that a component placing head 236 has two cameras. More specifically, the component placing head 236 has a board recognition camera 240, which is an example of a first board recognition device for recognizing a recognition object on the board, and a correction camera 241, which is an example of a second board recognition device similarly for recognizing a recognition object on the board.

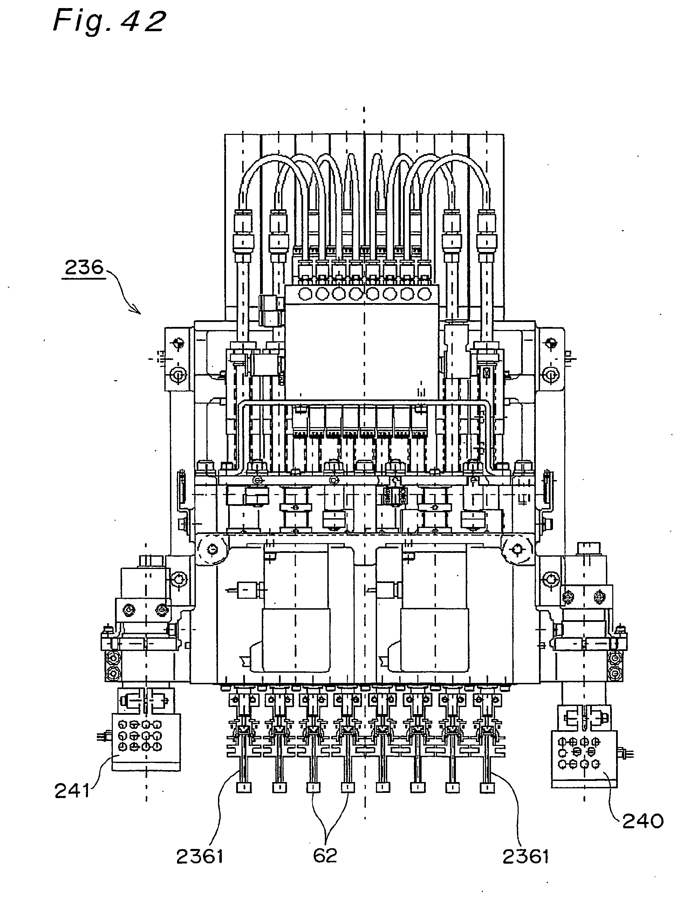

A side view of the component placing head 236 is shown in Fig. 42. As shown in Fig. 42, the component placing head 236 is generally similar in construction to the component placing head 136 of the first embodiment except that the correction camera 241 is additionally provided. The component placing head 236 has, for example, eight component suction nozzles 2361, which are an example of the component holding member, where the component suction nozzles 2361 are provided with their individual up/down motion axes arrayed on a line.

In the component placing head 236, the board recognition camera 240 is provided at a right end in the figure, and the correction camera 241 is located at a left end in the figure. An optical axis of image-picking up for recognition of the board recognition camera 240 and an optical axis of image-picking up for recognition of the correction camera 241 are placed on one identical straight line in the line array of the individual component suction nozzles 2361.

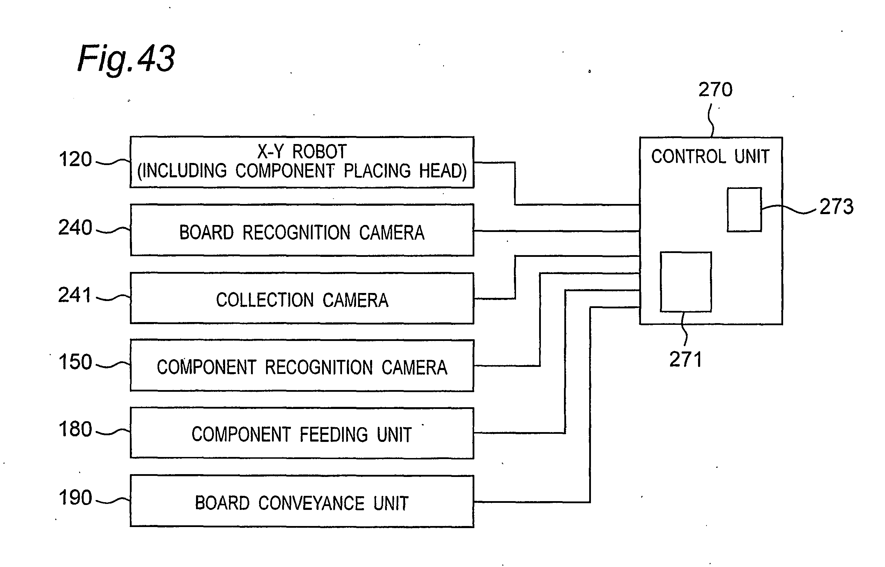

The component mounting apparatus 500 includes a control unit 270 for performing operation control of individual constituent parts. As shown in Fig. 43, the control unit 270 is connected to the X-Y robot 120, the correction camera 241, the component recognition camera 150, the component feeding unit 180 and the board conveyance unit 190, and performs operation control of these members to control the mounting operation of an electronic component 62 onto the circuit board 61. The control unit 270 includes a storage section 273 for storing programs necessary for the mounting operations and the like, mounting data such as mounting data, recognition information by the board recognition camera 240 and the correction camera 241, calculation results in a later-described calculation section 271 and so on, and includes the calculation section 271 for executing calculation of correction amounts for component mounting positions and the like based on the mounting information and the recognition information. Correction operation for the component placing position to be executed by the control unit 270 constructed as described above will be described in detail below.

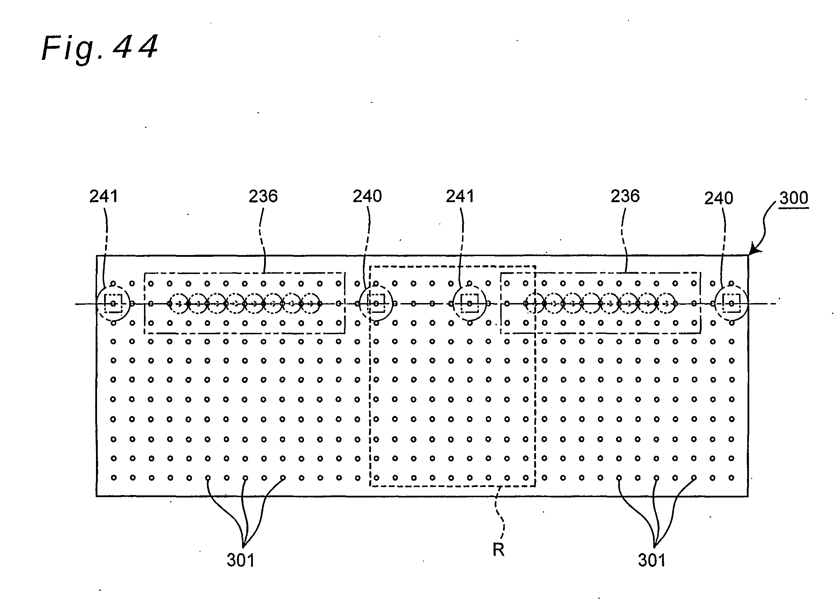

The correction method of the second embodiment is one including the contents of the operations carried out in the correction method of the first embodiment and, in addition to this, recognition operations by the correction camera 241 additionally provided in the component placing head 236, and calculation operations by the use of the recognition results. First, a schematic plan view of a glass board 300, which is an example of the reference-mark-recognizing reference board to be used in such a correction method, is shown in Fig. 44.

As shown in Fig. 44, in the glass board 300, a plurality of reference marks 301 formed in a grid state at specified intervals with a pitch of, for example, 10 mm as in the glass board 200 used in the first embodiment. However, there is a difference from the glass board 200 of the first embodiment that the glass board 300 is formed longer than the glass board 200 in a left-and-right direction (i.e., X-direction) in the figure. The formation of the glass board 300 being longer in the X-direction as shown above is intended for, in the recognition of the individual reference marks 301 positioned within a region corresponding to the component placing region on the glass board 300 by the board recognition camera 240, performing the recognition of those reference marks 301 positioned within the visual field of the correction camera 241, which is another camera, by the correction camera 241.

That is, in the correction method of the second embodiment, in addition to the operation of calculating an offset value (an area offset value) by recognition of a reference mark 301 done by the board recognition camera 240 (i.e., corresponding to the correction method of the first embodiment), another reference mark 301 (which is a differed-reference mark 301 different form the foregoing reference mark 301) is recognized by the correction camera 241 while the component placing head 236 is placed during the above recognition by the board recognition camera 240, by which a degree of inclination (i.e., inclination with respect to the X-direction) of the component placing head 236 is calculated according to position coordinates of the simultaneously recognized two reference marks 301, and then the correction of the component placing position is performed with the use of the calculation result and the offset value. Therefore, as shown in Fig. 44, the glass board 300 is so formed that in such a placement of the component placing head 236 that the component suction nozzles 2361 are positioned within the component placing region R, when each of the reference marks 301 positioned on the glass board 300 is recognized by the board recognition camera 240, another reference mark 301 can be recognized simultaneously also by the correction camera 241. It is noted that the component placing region R is a region into which the component suction nozzles 2361 included in the component placing head 236 can be positioned, and moreover into which the board recognition camera 240 can be positioned. Accordingly, the glass board 300 is formed into such a size that, for example, when a reference mark 301 positioned at the left end of the component placing region R as viewed in the figure is recognized by the board recognition camera 240, the reference mark 301 positioned at the left end of the glass board 300 as viewed in the figure can be recognized by the correction camera 241, and moreover that when a component suction nozzle 2361 positioned at the left end of the component placing head 236 as viewed in the figure is positioned at the right end of the component placing region R, the reference mark 301 positioned at the right end of the glass board 300 as viewed in the figure can be recognized by the board recognition camera 240.

The reference mark recognition board preferably has such a size as described above in principle. However, as described also in the first embodiment, when such a size cannot be ensured, it is also possible to use a synthesis method (image synthesis method) to virtually ensure the size.

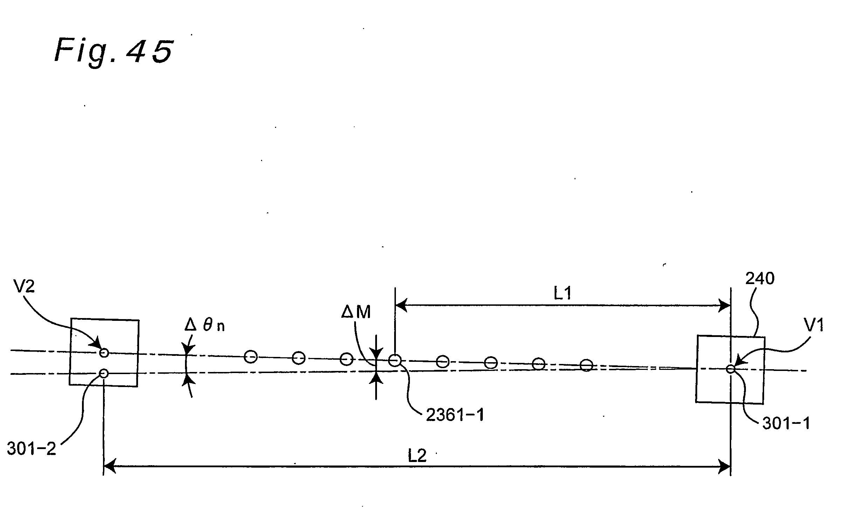

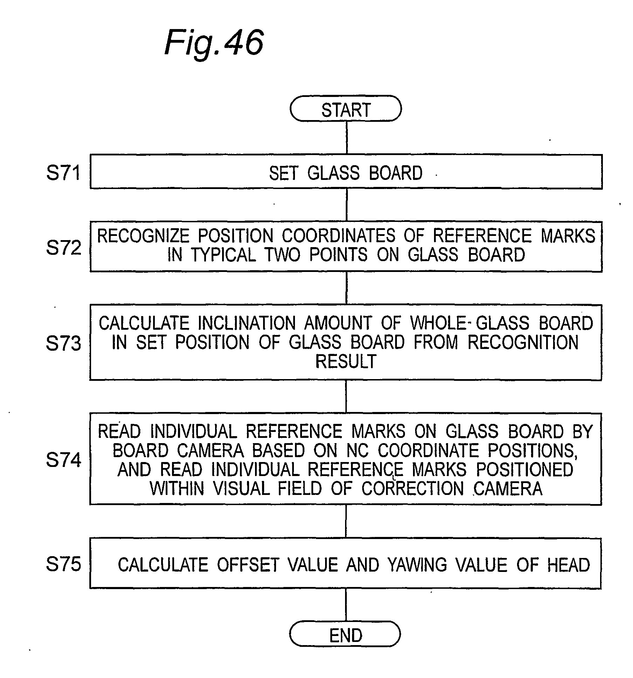

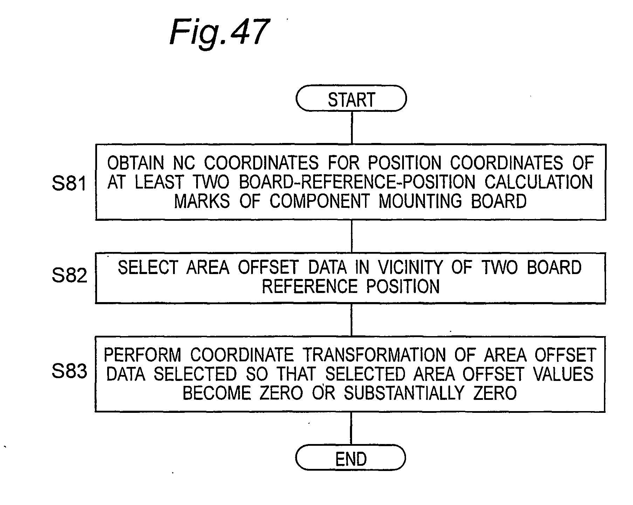

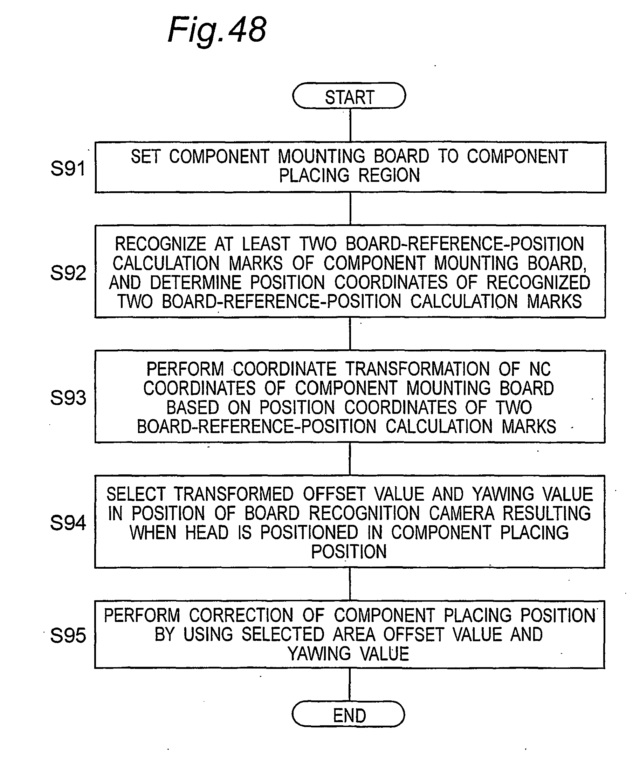

Next, the direction of correction in the second embodiment will be described in detail below with reference to a schematic explanatory view for explaining an inclination of the component placing head 236 by way of the relation between the individual cameras 240, 241 and the reference marks 301 shown in Fig. 45, as well as to a flowchart of the operation procedures shown in Figs. 46 to 48. It is noted that the procedure shown in the flowchart of Fig. 46 is a calibration process in the correction operation procedure, the procedure shown in the flowchart of Fig. 47 is a production preparation process, and the procedure shown in the flowchart of Fig. 48 is a production process. Also, the following operation control in each procedure in each flowchart is performed by the control unit 270 of the component mounting apparatus 500, each calculation is performed by the calculation section 271 of the control unit 270, and information including results of the calculation, NC coordinate data to be used for the calculation and the like are readably stored in the storage section 273.

(Calibration Process)

First, the calibration process is explained with reference to the flowchart of Fig. 46.

In step S71 of Fig. 46, the glass board 300 is held by the conveyance table 165 and positioned in the component placing region. This positioning is performed so that a portion of the glass board 300 corresponding to the component placing region R generally coincides with the component placing region as shown in Fig. 44.

Next, in step S72 of Fig. 46, position coordinates of reference marks 301 of at least two points, e.g. typical two points, out of the reference marks 301 arranged in the grid state at specified intervals on the glass board 300 held by the conveyance table 165 are recognized by the board recognition camera 240 of the component placing head 236.

A comparison is made between position coordinates of the two-point reference marks 301 recognized in this way and NC coordinates of the two-point reference marks 301 previously stored in the control unit 270. From a result of the comparison, an inclination amount $\theta_A$ of the whole glass board 300 (i.e., inclination amount of positioning posture of the glass board 300) is calculated (step S73). The calculation of such an inclination amount $\theta_A$ is fulfilled by determining a difference between the position coordinates of the recognized two-point reference marks and their individual NC coordinates, and then determining a rotational amount (rotational angle) of a graph derived from interconnection of the two reference marks 301 required to make the individual differences zero or substantially zero (where the graph is given by a straight line segment having the two reference marks 301 as its end points).

Next, in step S74 of Fig. 46, on the basis of the NC coordinates of the respective reference marks 301, the board recognition camera 240 of the component placing head 236 is moved so as to be located above the respective reference marks 301, and when located above the respective reference marks 301, recognizes position coordinates of the respective reference marks 301. In this recognition of the position coordinates of the individual reference marks 301 by the board recognition camera 240, position coordinates of the individual reference marks 301 located within the visual field of the correction camera 241 as well are recognized by the correction camera 241 simultaneously. More specifically, as shown in Fig. 44, position coordinates of the individual reference marks 301 arranged within the component placing region R on the glass board 300 are recognized in succession by the board recognition camera 240, where the position coordinates of each reference mark 301 positioned under (i.e., within the visual field of) the correction camera 241 are recognized in succession by the correction camera 241 at each time of the recognition. In addition, position coordinates of a reference mark 301 recognized by the board recognition camera 240 and position coordinates of another reference mark 301 recognized by the correction camera 241 are generally simultaneously recognized, and stored and held in a state that data of those recognition results are associated with each other.

Next, in step S75, differences between the position coordinate recognition result of the individual reference marks 301 by the board recognition camera 240 and the NC coordinates of the individual reference marks 301 are determined as correction values, and these correction values are stored and held as offset values. Such offset values can be stored and held as area offset values determined in the first embodiment. As the procedures for determining the area offset values as shown here, the procedures used in the first embodiment may be applied.

Further, in this step S75, the use of the position coordinate of the reference mark 301 recognized by the board recognition camera 240 and the position coordinate of the another reference mark 301 recognized by the correction camera 241 makes it possible to determine an inclination of the component placing head 236, i.e., an angular displacement (yawing) of the posture of the component placing head 236 with respect to the X-axis direction. More specifically, as shown in the schematic explanatory view of Fig. 45, a difference between position coordinate of a reference mark 301-1 recognized by the board recognition camera 240 and position coordinate of another reference mark 301-2 recognized by the correction camera 241 simultaneously with the foregoing recognition is calculated, by which an inclination angle $\theta_n$ between the two positions with respect to the X-axis direction is calculated. Then, a difference between the resulting inclination angle $\theta_n$ and the calculated inclination amount $\theta_A$ of the glass board 300 is determined, by which an inclination of the component placing head 236 with respect to the X-axis direction, i.e. a yawing value $\Delta\theta_n$ can be determined. That is, the yawing value $\Delta\theta_n$ is calculated by Equation (13):

$$\Delta\theta_n = \theta_n - \theta_A$$

The calculated individual yawing values $\Delta\theta_n$, which are to be stored in association with offset values of their corresponding reference marks 301, are stored in association with their corresponding area offset values in this second embodiment. Thus, the calibration process is completed.

(Production Preparation Process)

Next, production preparation process in the component mounting apparatus 500 is explained with reference to the flowchart of Fig. 47.

In step S81 of Fig. 47, NC coordinates of at least two board-reference-position calculation marks 202-1, 202-2 of the component mounting board 61 to be used in the component mounting apparatus 500 are read out in the control unit 270.

Thereafter, in step S82, areas on the glass board 300 in which NC coordinates of those two (at least two) board-reference-position calculation marks 202-1, 202-2 are placed are selected, and moreover area offset values for those areas are read out.

Further, in step S83, these area offset values are subjected to coordinate transformation so that the acquired area offset values become zero or substantially zero. It is noted that the procedures of steps S81 - S83 are similar to those of the first embodiment, respectively. Thus, the production preparation process is completed.

(Production process)

Next, production process (final production process) will be explained with reference to the flowchart of Fig. 48.

First, in step S91, the component mounting board 61 is positioned and held in the component placing region of the board conveyance unit 190. Thereafter, the board recognition camera 240 is moved to above the two board-reference-position calculation marks 202-1, 202-2 of the board 61, where position coordinates of each of the board-reference-position calculation marks 202-1, 202-2 are recognized (step S92).

Further thereafter, NC coordinates of the component mounting board 61 are subjected to coordinate transformation on the basis of the position coordinates of the recognized two board-reference-position calculation marks 202-1, 202-2 (step S93).

Next, the transformed NC coordinates are read out as NC coordinates of a component mounting position to which the component is to be mounted. In the areas of the glass board 300, an area to which the component placing position is located is selected, and an area offset value subjected to the coordinate transformation and associated with this area as well as a yawing value are read out (step S94).

Thereafter, with the readout area offset value, correction of position coordinates of the component placing position is performed (step S95). Besides this, from among the component suction nozzles 2361 included in the component placing head 236, a component suction nozzle 2361 to perform the mounting operation of the component onto the component placing position is subjected to a correction of movement position, i.e. a correction of displacement of movement position due to an inclination of the component placing head 236 is performed on the basis of the yawing value $\Delta\theta_n$ acquired in the foregoing correction.

More specifically, as shown in Fig. 45, among the individual component suction nozzles 2361 included in the component placing head 236, the correction amount $\Delta M$ of displacement of movement position can be calculated by Equation (14) with the use of a distance L1 between the axial center position (nozzle center position) of the component suction nozzle 2361-1 that performs the component placing and an optical axis V1 of the board recognition camera 240, a distance L2 between the optical axis V1 of the board recognition camera 240 and an optical axis V2 of the correction camera 241, and the yawing value $\Delta\theta_n$:

Equation (14):

$$\Delta M = \Delta\theta n \times L1/L2$$

It is noted that the distances L1 and L2 are preset and extractably stored in the control unit 270.

Such a correction operation is iteratively performed for the individual component placing positions, and components are placed to their corresponding corrected component placing positions.

In addition, with regard to the placement relation between the board recognition camera 240 and the correction camera 241 included in the component placing head 236, the distance L2 between their optical axes V1 and V2 is preferably an integral multiple of the placement pitch of the reference marks 301 of the glass board 300. With such a setting, when the optical axis V1 of the board recognition camera 240 is placed above one reference mark 301, another reference mark 301 can be placed in the vicinity of the optical axis V2 of the correction camera 241, making it less likely that the another reference mark 301 may be placed outside the visual field of the correction camera 241. In addition, in the case where it is decided that the another reference mark 301 is not placed within the visual field of the correction camera 241, an alarm for positioning abnormalities of the glass board 300 and the like is outputted, and the glass board 300 is relocated once again, where the correction operation is performed.

Further, the component placing head 236 needs to include the board recognition camera 240 and the correction camera 241 for the calibration process in the above-described sequence of correction operation. However, for the production preparation process and the production process to be performed after the calibration process, since the correction camera 241 is not used, it may be the case that the correction camera 241 is removed from the component placing head 236 after the completion of the calibration process. In addition, in a case where the calibration process is executed again for maintenance of the component mounting apparatus 500 or the like, the correction camera 241 that has once been removed may be provided again for execution of the process, so that the inclination of the component placing head 236 can be determined. Also, at the place where the correction camera 241 is provided, another kind of board recognition camera having a different visual field or resolution may be provided instead of the correction camera 241 so as to allow the component mounting to be carried out.

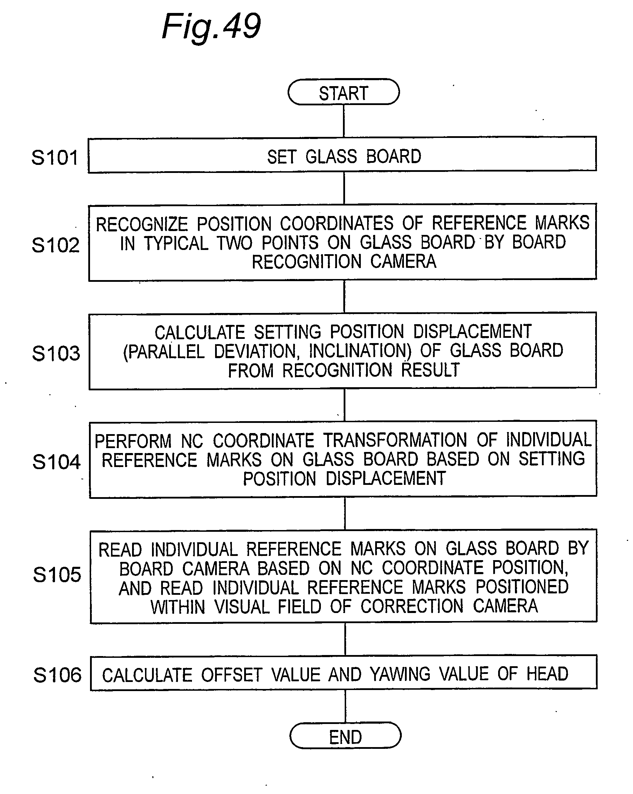

The calibration process has been described above on a case where individual offset values are calculated without considering any setting position displacement (parallelism displacement or angular displacement) of the glass board 300. However, the case may be that such setting position displacement is taken into consideration. With such a consideration, even if a large setting position displacement of the glass board 300 is involved, the individual reference marks 301 can be positioned reliably within the visual field of the board recognition camera 240 so that occurrence of recognition errors can be prevented. A concrete procedure for such a case is shown in the flowchart of Fig. 49 as a modification working example of the second embodiment.

Next, as shown in Fig. 49, after the positioning of the glass board 300 in step S101, position coordinates of reference marks 301 of at least two points, for example, typical two points from among the reference marks 301 arranged in a grid state at specified intervals on the glass board 300 held by the conveyance table 165 are recognized by the board recognition camera 240 of the component placing head 236 in step S102.

A comparison is made between position coordinates of the two-point reference marks 301 recognized in this way and NC coordinates of the two-point reference marks 301 previously stored in the control unit 270. From a result of the comparison, displacement amounts (i.e., parallelism displacement and inclination amount $\theta_A$) of the positioning of the glass board 300 are calculated (step S103). Calculation of such displacement amounts is fulfilled by determining differences between the position coordinates of the recognized two reference marks and their NC coordinates, respectively. Further, the NC coordinate of the individual reference marks 301 on the glass board 300 is subjected to coordinate transformation by rotating or shifting a graph derived from interconnection of the two reference marks 301 (where the graph is given by a line segment on a straight line having the two reference marks 301 as its end points) so that those differences become zero or substantially zero, respectively (step S104). In this case, since the glass board 300 is referenced for all the requirements, the expansion/contraction rate E is assumed to be 1. It is noted that such a technique for coordinate transformation is similar to that described in detail in the first embodiment.

Next, in step S105 of Fig. 49, on the basis of the NC coordinates of the reference marks 301 subjected to the coordinate transformation, the board recognition camera of the component placing head 236 is moved so as to be positioned above each of the reference marks 301 and, when being positioned above each of the reference marks 301, performs the recognition of the position coordinate of each reference mark 301 while the recognition of each another reference mark 301 is performed by the correction camera 241. Thereafter, in step S106, calculation of the area offset value and yawing value $\Delta\theta_n$ is performed. It is noted that the method of calculation of this yawing value $\Delta\theta_n$ is similar to that of step S75 of Fig. 46 described above. Thus, the calibration process is completed. After that, the above-described production preparation process and the production process can be carried out.

According to the second embodiment, in addition to the correction operation for the component placing position with the area offset value according to the first embodiment, any displacement of the end portion of each component suction nozzle 2361 due to an inclination of the component placing head 236 itself can be corrected with a yawing value which is calculated by performing the simultaneous recognition of position coordinates of reference marks 301 with the two cameras of the board recognition camera 240 and the correction camera 241. Therefore, higher accuracy correction operation can be performed, so that higher accuracy component mounting can be fulfilled.

As a result of the fulfilment that such displacement due to an inclination of the component placing head 236, for example, to an inclination caused by machining accuracy of the linear guide of the X-axis frame 132 can be corrected, a high mounting (placing) position accuracy can be obtained without increasing the machining accuracy of the linear guide. Thus, the component mounting apparatus that is capable of obtaining high mounting position accuracy can be made lower in manufacturing cost, being enabled to meet both low cost and high accuracy.

It is to be noted that, by properly combining the arbitrary embodiments of the aforementioned various embodiments, the effects possessed by them can be produced.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

Industrial Applicability

In the component mounting method and apparatus according to the present invention, the reference marks 201 arranged at specified intervals on the glass board 200 are recognized, and from its recognition.results, offset values for individual areas matching the board size are determined as numerical values for correction use, and further corresponding offset values for individual movement positions of the component placing head 136 are reflected as numerical values for correction use in the operation of mounting position correction, mark recognition correction, or measurement of mounting position offset values, respectively. Thus, the component mounting method and apparatus are capable of enhancing the mounting accuracy and they are great useful for component mounting.

**Claims**

1. A component mounting method for placing a component held by a component holding member included in a component placing head, which is movable relative to a board holding device, onto a component placing position of a component mounting board held by the board holding device, the method comprising:

   recognizing respective reference marks arranged at specified intervals on a reference-mark-recognizing reference board by a first board recognition device included in the component placing head, with the reference board held on the board holding device and positioned in a component placing region, and recognizing respective differed-reference marks each of which is correspondingly different from each of the foregoing reference marks and positioned individually within a visual field of a second board recognition device provided at a position different from a position of the first board recognition device by the second board recognition device during the recognition of the reference marks by the first board recognition device, and then determining position coordinates of the reference marks and the differed-reference marks, respectively;
   calculating inclination of the component placing head with respect to a direction for the movement of the head at each recognition position for the reference marks and the differed-reference marks, by using the individual position coordinates of the reference marks recognized by the first board recognition device and the individual position coordinates of the differed-reference marks recognized by the second board recognition device;
   determining a position correction value of the component holding member from the inclination of the component placing head; and
   performing a correction of a movement position of the component holding member toward the component placing position by using the position correction value, and then placing the component onto the component placing position at the corrected movement position.

2. The component mounting method as defined in Claim 1, further comprising:

   recognizing at least two of the reference marks on the reference-mark-recognizing reference board by the first board recognition device after positioning the reference board in the component placing region, and then determining position coordinates of the two reference marks; and
   calculating an inclination of positioning posture for the reference board by NC coordinates of the two reference marks and the position coordinates;
   wherein, in the step of calculation for the inclination of the component placing head, inclination of the head at each recognition position is calculated by using the individual position coordinates of the reference marks recognized by the first board recognition device, the individual position coordinates of the differed-reference marks recognized by the second board recognition device, and the inclination of positioning posture of the reference board.

3. The component mounting method as defined in Claim 1, further comprising:

determining differences between the position coordinates of the individual reference marks recognized by the first board recognition device and the individual NC coordinates as correction values, respectively;

obtaining respective NC coordinates of at least two board-reference-position calculation marks of the component mounting board;

selecting respective reference marks located near to the two board-reference-position calculation marks from among the recognized reference marks;

determining respective offset values at the individual selected reference marks by performing coordinate transformation of the selected position coordinates of the reference marks so that the correction values for the selected reference marks become zero or substantially zero;

recognizing at least two board-reference-position calculation marks on the component mounting board by the first board recognition device, and then determining respective position coordinates of the two board-reference-position calculation marks, in a state that the component mounting board is held on the board holding device and positioned in the component placing region instead of the reference-mark-recognizing reference board;

correcting the NC coordinates of the two board-reference-position calculation marks based on the position coordinates of the two board-reference-position calculation marks, respectively; and

correcting position coordinates of the component placing position based on the offset value of the reference mark nearest to the first component recognition device and the position correction value of the component holding member derived from the inclination of the component placing head at the position of the relevant reference mark when the component held by the component holding member of the component placing head is positioned above each component placing position of the component mounting board, and then performing the placing of the component to the each component placing position based on the corrected position coordinates of the component placing position.

4.  The component mounting method as defined in Claim 3, wherein

    in the step of determining offset values at the individual selected reference marks located near to the two board-reference-position calculation marks, by performing coordinate transformation of the position coordinates of the selected reference marks so that the correction values for the selected reference marks become zero or substantially zero,

    the offset values at the individual selected reference marks located near to the two board-reference-position calculation marks are determined, by performing coordinate transformation of the position coordinates of the selected reference marks by rotating and shifting a graph derived from interconnection of the selected reference marks so that the correction values for the selected reference marks become zero or substantially zero.

5.  The component mounting method as defined in Claim 3, wherein

    in the step of determining offset values at the individual selected reference marks located near to the two board-reference-position calculation marks, by performing coordinate transformation of the position coordinates of the selected reference marks so that the correction values for the selected reference marks become zero or substantially zero,

    the offset values at the individual selected reference marks located near to the two board-reference-position calculation marks are determined, by calculating correction values of at least one direction out of an X-direction and a Y-direction orthogonal to the X-direction of the board holding device from the selected reference marks, by determining an inclination of the reference board, and by performing coordinate transformation of the position coordinates of the selected reference marks so that the correction values for the selected reference marks become zero or substantially zero.

6.  The component mounting method as defined in any one of Claims 1 to 5, further comprising:

    recognizing at least two of the reference marks of the reference-mark-recognizing reference board by the first board recognition device after the positioning of the reference board to the board holding device, and then determining position coordinates of the two reference marks,

    determining differences between NC coordinates of the two reference marks and the position coordinates thereof, and performing coordinate transformation of the NC coordinates of the individual reference marks on the reference board by rotating or shifting a graph derived from interconnection of the two reference marks so that the individual differences become zero or substantially zero;

    thereafter, performing alignment between the first board recognition device and the individual reference marks based on the coordinate-transformed NC coordinates of the individual reference marks, and then determining position coordinates of the individual reference marks and the individual differed-reference marks by performing recognition of the individual marks; and

determining an inclination of the component placing head at each recognition positions with respect to the movement direction by calculating differences between the position coordinates of the individual reference marks and the individual differed-reference marks.

7. A component mounting apparatus for mounting a component held by a component holding member included in a component placing head, which is movable relative to a board holding device, onto a component placing position of a component mounting board held by the board holding device, the apparatus comprising:

a first board recognition device and a second board recognition device both of which are included in the component placing head and both of which serve for, with a reference-mark-recognizing reference board held on the board holding device and positioned in a component placing region, recognizing position coordinates of reference marks arranged at specified intervals on the reference board; and
a control unit for determining position coordinates of the reference marks recognized by the first board recognition device from recognition results of the reference marks, determining position coordinates of respective differed-reference marks recognized by the second board recognition device from recognition results of the differed-reference marks at positions of the component placing head where the recognition of the reference mark by the first board recognition device is performed, calculating inclination of the component placing head with respect to a direction of the movement of the head at each recognition position by using the individual position coordinates of the reference marks recognized by the first board recognition device and the individual position coordinates of the differed-reference marks recognized by the second board recognition device, determining a position correction value of the component holding member included in the head from the calculated inclination of the head, performing correction of a movement position of the component holding member to the component placing position by using the determined position correction value, and then placing the component onto the component placing position at the corrected movement position.

8. The component mounting apparatus as defined in Claim 7, wherein the component placing head includes a plurality of component holding members arranged between the first board recognition device and the second board recognition device.

9. The component mounting apparatus as defined in Claim 8, wherein
the first board recognition device and the second board recognition device are operable to obtain image-picking ups of the reference marks on the reference-mark-recognizing reference board along optical axes thereof so that position coordinates of the reference mark can be recognized, and
in the component placing head, the optical axis of the first board recognition device, the optical axis of the second board recognition device, and up/down optical axes of the individual component holding members are arrayed in a generally identical straight line.

10. The component mounting apparatus as defined in Claim 7, further comprising:

an X-Y robot for moving the component placing head back and forth along an X-axis direction or a Y-axis direction, these directions being ones extending roughly along a surface of the component mounting board held by the component holding member and generally orthogonal to each other,

wherein an inclination of the component placing head includes an inclination of posture of the component placing head with respect to the X-axis direction or the Y-axis direction caused by movement of the component placing head along the X-axis direction or the Y-axis direction by the X-Y robot.

11. The component mounting apparatus as defined in Claim 7, wherein
after positioning of the reference-mark-recognizing reference board to the board holding device, the control unit is operable to perform operations for recognizing at least two of the reference marks of the reference board by the first board recognition device to determine position coordinates of the two reference marks, calculating an inclination of positioning posture of the reference board by NC coordinates of the two reference marks and the position coordinates, and calculating inclination of the head at each recognition position by using the individual position coordinates of the reference marks recognized by the first board recognition device, the individual position coordinates of the differed-reference marks recognized by the second board recognition device, and the inclination of positioning posture of the reference board.

12. The component mounting apparatus as defined in Claim 7, wherein

the control unit is operable to perform operations for determining differences between position coordinates of the individual reference marks recognized by the first board recognition device and the individual NC coordinates as correction values, obtaining NC coordinates of at least two board-reference-position calculation marks of the component mounting board; selecting reference marks located near to the two board-reference-position calculation marks from among the recognized reference marks, determining respective offset values at the individual selected reference marks by performing coordinate transformation of the position coordinates of the selected reference marks so that the correction values for the selected reference marks become zero or substantially zero; recognizing the at least two board-reference-position calculation marks of the component mounting board by the first board recognition device, to determine respective position coordinates of the two board-reference-position calculation marks, in a state that the component mounting board is held on the board holding device and positioned in the component placing region instead of the reference-mark-recognizing reference board, correcting the NC coordinates of the two board-reference-position calculation marks based on the position coordinates of the two board-reference-position calculation marks, and correcting position coordinates of the component placing position based on the offset value of the reference mark nearest to the first component recognition device and the position correction value of the component holding member derived from the inclination of the component placing head at the position of the relevant reference mark when the component held by the component holding member of the component placing head is positioned above each component mounting position of the component mounting board, and then performing the placing of the component to the component placing position based on the corrected position coordinates of the component placing position.

13. The component mounting apparatus as defined in any one of Claims 7 to 12, wherein
the control unit is operable to perform operations for recognizing at least two of the reference marks of the reference-mark-recognizing reference board by the first board recognition device to determine position coordinates of the two reference marks after the positioning of the reference board to the board holding device, determining differences between NC coordinates of the two reference marks and the position coordinates thereof, performing coordinate transformation of the NC coordinates of the individual reference marks on the reference board by rotating or shifting a graph derived from interconnection of the two reference marks so that the individual differences become zero or substantially zero, performing alignment between the first board recognition device and the individual reference marks based on the coordinate-transformed NC coordinates of the individual reference marks and performing recognition of the individual reference marks and their correspondingly differed-reference marks to determine the position coordinates thereof, and determining differences between the position coordinates of the individual reference marks and the correspondingly differed-reference marks, thereby an inclination of the component placing head at each of the recognition positions with respect to the movement direction is calculated.

**Patentansprüche**

1. Bauteilmontageverfahren zum Platzieren eines Bauteils, das von einem Bauteilhalteelement gehalten wird, dass in einem Bauteilplatzierungskopf enthalten ist, welcher relativ zu einer Leiterplattenhaltevorrichtung beweglich ist, auf einer Bauteilplatzierungsposition der Bauteilmontageleiterplatte, die von der Leiterplattenhaltevorrichtung gehalten wird, wobei das Verfahren umfasst:

Erkennen entsprechender Referenzmarken, die in spezifizierten Intervallen auf einer Referenzmarkenerkennungs-Referenzleiterplatte angeordnet sind, mittels einer ersten Leiterplattenerkennungsvorrichtung, die im Bauteilplatzierungskopf enthalten ist, wobei die Referenzleiterplatte auf der Leiterplattenhaltevorrichtung gehalten und in einem Bauteilplatzierungsbereich positioniert ist, und Erkennen entsprechender andersartiger Referenzmarken, die jeweils entsprechend von den jeweiligen vorangehenden Referenzmarken verschieden sind und individuell innerhalb eines Sichtfeldes einer zweiten Leiterplattenerkennungsvorrichtung positioniert sind, die an einer Position verschieden von einer Position der ersten Leiterplattenerkennungsvorrichtung vorgesehen ist, durch die zweite Leiterplattenerkennungsvorrichtung während des Erkennens der Referenzmarken mittels der ersten Leiterplattenerkennungsvorrichtung, und anschließendes Bestimmen von Positionskoordinaten der Referenzmarken bzw. der andersartigen Referenzmarken;
Berechnen der Neigung des Bauteilplatzierungskopfes bezüglich einer Richtung für die Bewegung des Kopfes an jeder Erkennungsposition für die Referenzmarken und die andersartigen Referenzmarken durch Verwenden der individuellen Positionskoordinaten der von der ersten Platinenerkennungsvorrichtung erkannten Referenzmarken und der individuellen Positionskoordinaten der von der zweiten Platinenerkennungsvorrichtung erkannten andersartigen Referenzmarken;
Bestimmen eines Positionskorrekturwertes des Bauteilhalteelements aus der Neigung des Bauteilplatzierungskopfes; und

Ausführen einer Korrektur einer Bewegungsposition des Bauteilhalteelements in Richtung zur Bauteilplatzierungsposition unter Verwendung des Positionskorrektunivertes, und anschließendes Platzieren des Bauteils auf der Bauteilplatzierungsposition bei der korrigierten Bewegungsposition.

**2.** Bauteilmontageverfahren nach Anspruch 1, ferner umfassend:

Erkennen von wenigstens zwei der Referenzmarken auf der Referenzmarkenerkennungs-Referenzleiterplatte mittels der ersten Leiterplattenerkennungsvorrichtung nach dem Positionieren der Referenzleiterplatte im Bauteilplatzierungsbereich, und anschließendes Bestimmen von Positionskoordinaten der zwei Referenzmarken; und

Berechnen einer Neigung einer Positionierungslage für die Referenzleiterplatte mittels NC-Koordinaten der zwei Referenzmarken und der Positionskoordinaten;

wobei im Schritt der Berechnung der Neigung des Bauteilplatzierungskopfes die Neigung des Kopfes bei jeder Erkennungsposition berechnet wird unter Verwendung der individuellen Positionskoordinaten der von der ersten Leiterplattenerkennungsvorrichtung erkannten Referenzmarken, der individuellen Positionskoordinaten der von der zweiten Leiterplattenerkennungsvorrichtung erkannten andersartigen Referenzmarken, sowie der Neigung der Positionierungslage der Referenzleiterplatte.

**3.** Bauteilmontageverfahren nach Anspruch 1, ferner umfassend:

Bestimmen der Differenzen zwischen den Positionskoordinaten der von der ersten Leiterplattenerkennungsvorrichtung erkannten individuellen Referenzmarken und den individuellen NC-Koordinaten als Korrekturwerte;

Erhalten entsprechender NC-Koordinaten von wenigstens zwei Leiterplattenreferenzposition-Berechnungsmarken der Bauteilmontageleiterplatte;

Auswählen entsprechender Referenzmarken, die nahe den zwei Leiterplattenreferenzposition-Berechnungsmarken angeordnet sind, aus den erkannten Referenzmarken;

Bestimmen entsprechender Versatzwerte an den individuellen ausgewählten Referenzmarken durch Ausführen einer Koordinatentransformation der ausgewählten Positionskoordinaten der Referenzmarken, so dass die Korrekturwerte für die ausgewählten Referenzmarken gleich 0 oder im Wesentlichen gleich 0 werden;

Erkennen von wenigstens zwei Leiterplattenreferenzposition-Berechnungsmarken auf der Bauteilmontageleiterplatte mittels der ersten Leiterplattenerkennungsvorrichtung, und anschließendes Bestimmen entsprechender Positionskoordinaten der zwei Leiterplattenreferenzposition-Berechnungsmarken in einem Zustand, in dem die Bauteilmontageplatine anstelle der Referenzmarkierungserkennungs-Referenzplatine auf der Bauteilhaltevorrichtung gehalten wird und im Bauteilplatzierungsbereich positioniert ist;

Korrigieren der NC-Koordinaten der zwei Leiterplattenreferenzposition-Berechnungsmarken auf der Grundlage der Positionskoordinaten der zwei Leiterplattenreferenzposition-Berechnungsmarken; und

Korrigieren der Positionskoordinaten der Bauteilplatzierungsposition auf der Grundlage des Versatzwertes der Referenzmarke, die der ersten Bauteilerkennungsvorrichtung am nächsten liegt, und des Positionskorrekturwertes des Bauteilhalteelements, der aus der Neigung des Bauteilplatzierungskopfes an der Position der relevanten Referenzmarke hergeleitet wird, wenn das vom Bauteilhalteelement des Bauteilplatzierungskopfes gehaltene Bauteil über der jeweiligen Bauteilplatzierungsposition der Bauteilmontageplatine positioniert ist, und anschließendes Durchführen der Platzierung des Bauteils an der jeweiligen Bauteilplatzierungsposition auf der Grundlage der korrigierten Positionskoordinaten der Bauteilplatzierungsposition.

**4.** Bauteilmontageverfahren nach Anspruch 3, wobei
im Schritt des Bestimmens der Versatzwerte an den individuellen ausgewählten Referenzmarken, die nahe den zwei Leiterplattenreferenzposition-Berechnungsmarken angeordnet sind, durch Ausführen der Koordinatentransformation der Positionskoordinaten der ausgewählten Referenzmarken, so dass die Korrekturwerte der ausgewählten Referenzmarken gleich 0 oder im Wesentlichen gleich 0 werden,
die Versatzwerte an den individuellen ausgewählten Referenzmarken, die nahe den zwei Leiterplattenreferenzposition-Berechnungsmarken angeordnet sind, bestimmt werden durch Ausführen einer Koordinatentransformation der Positionskoordinaten der ausgewählten Referenzmarken durch Rotieren und Verschieben eines Graphen, der aus einer Verbindung der ausgewählten Referenzmarken hergeleitet wird, so dass die Korrekturwerte für die ausgewählten Referenzmarken gleich 0 oder im Wesentlichen gleich 0 werden.

**5.** Bauteilmontageverfahren nach Anspruch 3, wobei
im Schritt des Bestimmens der Versatzwerte an den individuellen ausgewählten Referenzmarken, die nahe den zwei Leiterplattenreferenzposition-Berechnungsmarken angeordnet sind, durch Ausführen der Koordinatentransformation der Positionskoordinaten der ausgewählten Referenzmarken, so dass die Korrekturwerte der ausgewählten Referenzmarken gleich 0 oder im Wesentlichen gleich 0 werden,

die Versatzwerte an den individuellen ausgewählten Referenzmarken, die nahe den zwei Leiterplattenreferenzposition-Berechnungsmarken angeordnet sind, bestimmt werden durch Berechnen von Korrekturwerten von wenigstens einer Richtung aus einer X-Richtung und einer Y-Richtung orthogonal zur X-Richtung der Leiterplattenhaltevorrichtung aus den ausgewählten Referenzmarken, durch Bestimmen einer Neigung der Referenzleiterplatte, und durch Ausführen einer Koordinatentransformation der Positionskoordinaten der ausgewählten Referenzmarken, so dass die Korrekturwerte für die ausgewählten Referenzmarken gleich 0 oder im Wesentlichen gleich 0 werden.

6. Bauteilmontageverfahren nach irgendeinem der Ansprüche 1 bis 5, ferner umfassend:

Erkennen von wenigstens zwei der Referenzmarken der Referenzmarkenerkennungs-Referenzleiterplatte mittels der ersten Leiterplattenerkennungsvorrichtung nach dem Positionieren der Referenzleiterplatte auf der Leiterplattenhaltevorrichtung, und anschließendes Bestimmen von Positionskoordinaten der zwei Referenzmarken,

Bestimmen von Differenzen zwischen NC-Koordinaten der zwei Referenzmarken und den Positionskoordinaten derselben, und Ausführen einer Koordinatentransformation der NC-Koordinaten der individuellen Referenzmarken auf der Referenzleiterplatte durch Rotieren oder Verschieben eines Graphen, der aus der Verbindung der zwei Referenzmarken hergeleitet wird, so dass die individuellen Differenzen gleich 0 oder im Wesentlichen gleich 0 werden;

anschließendes Ausführen einer Ausrichtung zwischen der ersten Leiterplattenerkennungsvorrichtung und den individuellen Referenzmarken auf der Grundlage der koordinatentransformierten NC-Koordinaten der individuellen Referenzmarken, und anschließendes Bestimmen von Positionskoordinaten der individuellen Referenzmarken und der individuellen andersartigen Referenzmarken durch Ausführen einer Erkennung der individuelle Marken; und

Bestimmen einer Neigung des Bauteilplatzierungskopfes bei jeder Erkennungsposition mit Bezug auf die Bewegungsrichtung durch Berechnen von Differenzen zwischen den Positionskoordinaten der individuellen Referenzmarken und der individuellen andersartigen Referenzmarken.

7. Bauteilmontagevorrichtung zur Montage eines Bauteils, das von einem Bauteilhalteelement gehalten wird, das in einem Bauteilplatzierungskopf enthalten ist, welcher relativ zu einer Leiterplattenhaltevorrichtung beweglich ist, auf einer Bauteilplatzierungsposition einer Bauteilmontageleiterplatte, die von der Leiterplattenhaltevorrichtung gehalten wird, wobei die Vorrichtung umfasst:

eine erste Leiterplattenerkennungsvorrichtung und eine zweite Leiterplattenerkennungsvorrichtung, die beide im Bauteilplatzierungskopf enthalten sind und beide dazu dienen, mit einer Referenzmarkenerkennungs-Referenzleiterplatte, die auf der Leiterplattenhaltevorrichtung gehalten wird und in einem Bauteilplatzierungsbereich positioniert ist, die Positionskoordinaten von Referenzmarken, die in spezifischen Intervallen auf der Referenzleiterplatte angeordnet sind, zu erkennen; und

eine Steuereinheit zum Bestimmen von Positionskoordinaten der von der ersten Leiterplattenerkennungsvorrichtung erkannten Referenzmarken aus den Erkennungsergebnissen der Referenzmarken, Bestimmen von Positionskoordinaten der von der zweiten Leiterplattenerkennungsvorrichtung erkannten jeweiligen andersartigen Referenzmarken aus den Erkennungsergebnissen der andersartigen Referenzmarken an Positionen des Bauteilplatzierungskopfes, wo die Erkennung der Referenzmarken mittels der ersten Leiterplattenerkennungsvorrichtung durchgeführt wird, Berechnen der Neigung des Bauteilplatzierungskopfes bezüglich einer Richtung der Bewegung des Kopfes bei jeder Erkennungsposition unter Verwendung der individuellen Positionskoordinaten der von der ersten Leiterplattenerkennungsvorrichtung erkannten Referenzmarken und der individuellen Positionskoordinaten der von der zweiten Leiterplattenerkennungsvorrichtung erkannten andersartigen Referenzmarken, Bestimmen eines Positionskorrekturwertes des Bauteilhalteelements, das im Kopf enthalten ist, aus der berechneten Neigung des Kopfes, Ausführen einer Korrektur einer Bewegungsposition des Bauteilhalteelements zu der Bauteilplatzierungsposition unter Verwendung des bestimmten Positionskorrekturwertes, und anschließendes Platzieren des Bauteils auf der Bauteilplatzierungsposition an der korrigierten Bewegungsposition.

8. Bauteilmontagevorrichtung nach Anspruch 7, wobei der Bauteilplatzierungskopf mehrere Bauteilhalteelemente enthält, die zwischen der ersten Leiterplattenerkennungsvorrichtung und der zweiten Leiterplattenerkennungsvorrichtung angeordnet sind.

**9.** Bauteilmontagevorrichtung nach Anspruch 8, wobei
die erste Leiterplattenerkennungsvorrichtung und die zweite Leiterplattenerkennungsvorrichtung so betreibbar sind, dass sie Bildaufnahmen der Referenzmarken auf der Referenzmarkenerkennungs-Referenzleiterplatte längs deren optischer Achsen erhält, so dass Positionskoordinaten der Referenzmarken erkannt werden können, und
im Bauteilplatzierungskopf die optische Achse der ersten Leiterplattenerkennungsvorrichtung, die optische Achse der zweiten Leiterplattenerkennungsvorrichtung und Aufwärts/Abwärts-Optikachsen der individuellen Bauteilhalteelemente auf einer im Allgemeinen identischen geraden Linie angeordnet sind.

**10.** Bauteilmontagevorrichtung nach Anspruch 7, ferner umfassend:

einen X-Y-Roboter zum Bewegen des Bauteilplatzierungskopfes rückwärts und vorwärts längs einer X-Achsen-Richtung oder einer Y-Achsen-Richtung, wobei diese Richtungen diejenigen sind, die sich grob längs einer Oberfläche der vom Bauteilhalteelement gehaltenen Bauteilmontageplatine erstrecken und im Allgemeinen senkrecht zueinander sind,
wobei eine Neigung des Bauteilplatzierungskopfes eine Neigung der Lage des Bauteilplatzierungskopfes bezüglich der X-Achsen-Richtung oder der Y-Achsen-Richtung enthält, die durch eine Bewegung des Bauteilplatzierungskopfes längs der X-Achsen-Richtung oder der Y-Achsen-Richtung mittels des X-Y-Roboters hervorgerufen wird.

**11.** Bauteilmontagevorrichtung nach Anspruch 7, wobei
nach dem Positionieren der Referenzmarkenerkennungs-Referenzleiterplatte an der Leiterplattenhaltevorrichtung die Steuereinheit so betreibbar ist, dass sie Operationen durchführt zum Erkennen wenigstens von zwei der Referenzmarken der Referenzleiterplatte mittels der ersten Leiterplattenerkennungsvorrichtung, um Positionskoordinaten der zwei Referenzmarken zu bestimmen, Berechnen einer Neigung der Positionierungslage der Referenzleiterplatte mittels NC-Koordinaten der zwei Referenzmarken und der Positionskoordinaten, und Berechnen der Neigung des Kopfes an jeder Erkennungsposition unter Verwendung der individuellen Positionskoordinaten der von der ersten Leiterplattenerkennungsvorrichtung erkannten Referenzmarken, der individuellen Positionskoordinaten der von der zweiten Leiterplattenerkennungsvorrichtung erkannten andersartigen Referenzmarken, sowie der Neigung der Positionierungslage **der Referenzleiterplatte.**

**12.** Bauteilmontagevorrichtung nach Anspruch 7, wobei
die Steuereinheit so betreibbar ist, dass sie Operationen durchführt zum Bestimmen von Differenzen zwischen Positionskoordinaten der individuellen Referenzmarken, die von der ersten Leiterplattenerkennungsvorrichtung erkannt worden sind, und der individuellen NC-Koordinaten als Korrekturwerte, Erhalten von NC-Koordinaten von wenigstens zwei Leiterplattenreferenzposition-Berechnungsmarken der Bauteilmontageleiterplatte; Auswählen von Referenzmarken, die nahe dem zwei Leiterplattenreferenzposition-Berechnungsmarken angeordnet sind, aus den erkannten Referenzmarken, Bestimmen entsprechender Versatzwerte an den individuell ausgewählten Referenzmarken durch Ausführen einer Koordinatentransformation der Positionskoordinaten der ausgewählten Referenzmarken, so dass die Korrekturwerte für die ausgewählten Referenzmarken gleich 0 oder im Wesentlichen gleich 0 werden; Erkennen von wenigstens zwei Leiterplattenreferenzposition-Berechnungsmarken der Bauteilmontageleiterplatte mittels der ersten Leiterplattenerkennungsvorrichtung, um entsprechende Positionskoordinaten der zwei Leiterplattenreferenzposition-Berechnungsmarken zu bestimmen, in einem Zustand, in dem die Bauteilmontageleiterplatte anstelle der Referenzmarkenerkennungs-Referenzleiterplatte auf der Leiterplattenhaltevorrichtung gehalten wird und im Bauteilplatzierungsbereich positioniert ist, Korrigieren der NC-Koordinaten der zwei Leiterplattenreferenzposition-Berechnungsmarken auf der Grundlage der Positionskoordinaten der zwei Leiterplattenreferenzposition-Berechnungsmarken, und Korrigieren der Positionskoordinaten der Bauteitptazierungsposition auf der Grundlage des Versatzwertes der Referenzmarke, die der ersten Bauteilerkennungsvorrichtung am nächsten ist, und des Positionskorrekturwertes des Bauteilhalteelements, der aus der Neigung des Bauteilplatzierungskopfes an der Position der relevanten Referenzmarke hergeleitet wird, wenn das vom Bauteilhalteelement des Bauteilplatzierungskopfes gehaltene Bauteil über der jeweiligen Bauteilmontageposition der Bauteilmontageleiterplatte positioniert ist, und anschließendes Ausführen der Platzierung des Bauteils an der Bauteilplatzierungsposition auf der Grundlage der korrigierten Positionskoordinaten der Bauteilplatzierungsposition.

**13.** Bauteilmontagevorrichtung nach irgendeinem der Ansprüche 7 bis 12, wobei
die Steuereinheit so betreibbar ist, dass sie Operationen ausführt zum Erkennen von wenigstens zwei der Referenzmarken der Referenzmarkenerkennungs-Referenzleiterplatte mittels der ersten Leiterplattenerkennungsvorrichtung, um Positionskoordinaten der zwei Referenzmarken nach dem Positionieren der Referenzleiterplatte auf der Leiterplattenhaltevorrichtung zu bestimmen, Bestimmen von Differenzen zwischen NC-Koordinaten der zwei Referenzmarken und ihrer Positionskoordinaten, Ausführen einer Koordinatentransformation der NC-Koordinaten der individuellen Referenzmarken auf der Referenzleiterplatte durch Rotieren oder Verschieben des Graphen, der aus einer Verbindung der zwei Referenzmarken hergeleitet wird, so dass die individuellen Differenzen gleich 0 oder im Wesentlichen gleich 0 werden, Ausführen einer Ausrichtung zwischen der ersten Leiterplattenerkennungsvorrichtung und den individuellen Referenzmarken auf der Grundlage der koordinatentransformierten NC-Koordinaten der individuellen Referenzmarken, und Ausführen einer Erkennung der individuellen Referenzmarken und ihrer entsprechenden andersartigen Referenzmarken, um deren Positionskoordinaten zu bestimmen, und Bestimmen von Differenzen zwischen den Positionskoordinaten der individuellen Referenzmarken und der entsprechenden andersartigen Referenzmarken, um somit eine Neigung des Bauteilplatzierungskopfes an jeder der Erkennungspositionen bezüglich der Bewegungsrichtung zu berechnen.

## Revendications

1. Procédé de montage d'un composant pour placer un composant maintenu par un élément de maintien de composant inclus dans une tête de placement de composant, qui est mobile par rapport à un dispositif de maintien de panneau, sur une position de placement de composant d'un panneau de montage de composant maintenu par le dispositif de maintien de panneau, le procédé comprenant :

   la reconnaissance des marques de référence respectives agencées à des intervalles spécifiés sur un panneau de référence de reconnaissance de marque de référence par un premier dispositif de reconnaissance de panneau inclus dans la tête de placement de composant, avec le panneau de référence maintenu sur le dispositif de maintien de panneau et positionné dans une région de placement de composant, et la reconnaissance des marques de référence différenciées respectives, chacune étant en correspondance différente de chacune des marques de référence précédentes et positionnée individuellement dans un champ visuel d'un second dispositif de reconnaissance de panneau prévu à une position différente d'une position du premier dispositif de reconnaissance de panneau par le second dispositif de reconnaissance de panneau pendant la reconnaissance des marques de référence par le premier dispositif de reconnaissance de panneau, et ensuite la détermination des coordonnées de la position des marques de référence et des marques de référence différenciées respectivement ;
   le calcul de l'inclinaison de la tête de placement de composant par rapport à une direction pour le mouvement de la tête dans chaque position de reconnaissance pour les marques de référence et les marques de référence différenciées, en utilisant des coordonnées de position individuelles des marques de référence reconnues par le premier dispositif de reconnaissance de panneau et les coordonnées de position individuelles des marques de référence différenciées reconnues par le second dispositif de reconnaissance de panneau ;
   la détermination d'une valeur de correction de position de l'élément de maintien de composant à partir de l'inclinaison de la tête de placement de composant ; et
   la réalisation d'une correction de position du mouvement de l'élément de maintien de composant vers la position de placement de composant en utilisant la valeur de correction de position, puis le placement du composant sur la position de placement de composant à la position de mouvement corrigée.

2. Procédé de montage de composant selon la revendication 1, comprenant en outre :

   la reconnaissance d'au moins deux des marques de référence sur le panneau de référence de reconnaissance de marques de référence par le premier dispositif de reconnaissance de panneau après le positionnement du panneau de référence dans la région de placement du Composant, puis la détermination des coordonnées de position des deux marques de référence ; et
   le calcul d'une inclinaison de la posture de positionnement du panneau de référence par les coordonnées de commande numérique des deux marques de référence et les coordonnées de position ;
   dans lequel, dans l'étape de calcul de l'inclinaison de la tête de placement de composant, l'inclinaison de la tête dans chaque position de reconnaissance est calculée à l'aide des coordonnées de position individuelles des marques de référence reconnues par le premier dispositif de reconnaissance de panneau, les coordonnées de position individuelles des marques de référence différenciées reconnues par le second dispositif de reconnaissance de panneau, et l'inclinaison de la posture de positionnement du panneau de référence.

3. Procédé de montage de composant selon la revendication 1, comprenant en outre :

   la détermination des différences entre les coordonnées de position des marques de référence individuelles reconnues par le premier dispositif de reconnaissance de panneau et les coordonnées individuelles de commande numérique en tant que valeurs de correction, respectivement ;

l'obtention des coordonnées respectives de commande numérique d'au moins deux marques de calcul de position de référence de panneau du panneau de montage de composant ;

la sélection des marques de référence respectives situées à proximité des deux marques de calcul de position de référence de panneau parmi les marques de référence reconnues ;

la détermination des valeurs décalées respectives aux marques de référence sélectionnées individuelles en réalisant la transformée de coordonnées des coordonnées de position sélectionnées des marques de référence, de sorte que les valeurs de correction des marques de référence sélectionnées deviennent nulles ou sensiblement nulles ;

la reconnaissance d'au moins deux marques de calcul de position de référence de panneau sur le panneau de montage de composant par le premier dispositif de reconnaissance de panneau, puis la détermination des coordonnées de position respectives des deux marques de calcul de position de référence de panneau, dans un état dans lequel le panneau de montage de composant est maintenu sur le dispositif de maintien de panneau et est positionné dans la région de placement de composant au lieu du panneau de référence de reconnaissance des marques de référence ;

la correction des coordonnées de commande numérique des deux marques de calcul de position de référence de panneau basées sur les coordonnées de position des deux marques de calcul de position de référence de panneau, respectivement ; et

la correction des coordonnées de position de la position de placement de composant basée sur la valeur décalée de la marque de référence la plus proche du premier dispositif de reconnaissance de composant, et la valeur de correction de position de l'élément de maintien de composant dérivée de l'inclinaison de la tête de placement de composant dans la position de la marque de référence pertinente, lorsque le composant maintenu par l'élément de maintien de composant de la tête de placement de composant est positionné au-dessus de chaque position de placement de composant du panneau de montage de composant, puis la réalisation du positionnement du composant dans chaque position de placement de composant basée sur les coordonnées de position corrigées de la position de placement du composant.

4. Procédé de montage de composant selon la revendication 3, dans lequel

dans l'étape consistant à déterminer les valeurs décalées sur les marques de référence sélectionnées individuelles situées à proximité des deux marques de calcul de position de référence de panneau, en réalisant la transformée de coordonnées des coordonnées de position des marques de référence sélectionnées, de sorte que les valeurs de correction pour les marques de référence sélectionnées deviennent nulles ou sensiblement nulles,

les valeurs décalées sur les marques de référence sélectionnées individuelles situées à proximité des deux marques de calcul de position de référence de panneau sont déterminées, en effectuant la transformée de coordonnées des coordonnées de position des marques de référence sélectionnées en tournant et en décalant un graphe dérivé de l'interconnexion des marques de référence sélectionnées, de sorte que les valeurs de correction pour les marques de référence sélectionnées deviennent nulles ou sensiblement nulles.

5. Procédé de montage de composant selon la revendication 3, dans lequel

dans l'étape consistant à déterminer les valeurs décalées sur les marques de référence sélectionnées individuelles situées à proximité des deux marques de calcul de position de référence de panneau, en effectuant la transformée de coordonnées des coordonnées de la position des marques de référence sélectionnées, de sorte que les valeurs de correction pour les marques de référence sélectionnées deviennent nulles ou sensiblement nulles,

les valeurs décalées sur les marques de référence sélectionnées individuelles situées à proximité des deux marques de calcul de position de référence de panneau sont déterminées, en calculant des valeurs de correction d'au moins une direction depuis une direction X et d'une direction Y orthogonales à la direction X du dispositif de maintien de panneau à partir des marques de référence sélectionnées, en déterminant une inclinaison du panneau de référence, et en effectuant la transformée de coordonnées des coordonnées de position des marques de référence sélectionnées, de sorte que les valeurs de correction pour les marques de référence sélectionnées deviennent nulles ou sensiblement nulles.

6. Procédé de montage de composant selon l'une quelconque des revendications 1 à 5, comprenant en outre :

la reconnaissance d'au moins deux des marques de référence du panneau de référence de reconnaissance des marques de référence par le premier dispositif de reconnaissance de panneau après le positionnement du panneau de référence sur le dispositif de maintien de panneau, puis détermination des coordonnées de position des deux marques de référence,

la détermination des différences entre les coordonnées de commande numérique des deux marques de référence et des coordonnées de position de celles-ci, et réalisation de la transformée de coordonnées des coordonnées de commande numérique des marques de référence individuelles sur le panneau de référence en tournant ou en décalant un graphe dérivé de l'interconnexion des deux marques de référence, de sorte que les différences individuelles deviennent nulles ou sensiblement nulles ;

par la suite, la réalisation de l'alignement entre le premier dispositif de reconnaissance de panneau et les marques de référence individuelles sur la base des coordonnées de commande numérique de transformée de coordonnées des marques de référence individuelles, puis la détermination des coordonnées de position des marques de référence individuelles et des marques de référence différenciées individuelles en effectuant la reconnaissance des marques individuelles ; et

la détermination d'une inclinaison de la tête de placement de composant dans chaque position de reconnaissance par rapport à la direction de mouvement en calculant les différences entre les coordonnées de position des marques de référence individuelles et des marques de référence différenciées individuelles.

7. Appareil de montage de composant pour le montage d'un composant maintenu par un élément de maintien de composant inclus dans une tête de placement de composant, qui est mobile par rapport à un dispositif de maintien de panneau, dans une position de placement de composant d'un panneau de montage de composant maintenu par le dispositif de maintien de panneau, l'appareil comprenant :

un premier dispositif de reconnaissance de panneau et un second dispositif de reconnaissance de panneau, les deux étant inclus dans la tête de placement de composant et les deux étant utilisés, avec un panneau de référence de reconnaissance de marques de référence maintenu sur le dispositif de maintien de panneau et positionné dans une région de placement de composant, pour reconnaître les coordonnées de position des marques de référence disposées à des intervalles spécifiés sur le panneau de référence ; et

une unité de commande pour déterminer les coordonnées de position des marques de référence reconnues par le premier dispositif de reconnaissance de panneau à partir des résultats de reconnaissance des marques de référence, pour déterminer les coordonnées de position des marques de référence différenciées respectives reconnues par le second dispositif de reconnaissance de panneau à partir des résultats de reconnaissance des marques de référence différenciées dans des positions de la tête de placement de composant, la reconnaissance de la marque de référence par le premier dispositif de reconnaissance de panneau étant effectuée, pour calculer l'inclinaison de la tête de placement de composant par rapport à une direction du mouvement de la tête dans chaque position de reconnaissance à l'aide des coordonnées de position individuelles des marques de référence reconnues par le premier dispositif de reconnaissance de panneau et les coordonnées de position individuelles des marques de référence différenciées reconnues par le second dispositif de reconnaissance de panneau, pour déterminer une valeur de correction de position de l'élément de maintien de composant inclus dans la tête à partir de l'inclinaison calculée de la tête, réaliser la correction d'une position de mouvement de l'élément de maintien de composant vers la position de placement de composant à l'aide de la valeur de correction de position déterminée, puis placer le composant sur la position de placement de composant dans la position de mouvement corrigée.

8. Appareil de montage de composant selon la revendication 7, dans lequel la tête de placement du composant comprend une pluralité d'éléments de maintien de composant disposés entre le premier dispositif de reconnaissance de panneau et le second dispositif de reconnaissance de panneau.

9. Appareil de montage de composant selon la revendication 8, dans lequel
le premier dispositif de reconnaissance de panneau et le second dispositif de reconnaissance de panneau sont opérationnels pour obtenir des relevés d'image des marques de référence sur le panneau de référence de reconnaissance de marques de référence le long des axes optiques de celui-ci, de sorte que les coordonnées de position de la marque de référence peuvent être reconnues, et
dans la tête de placement de composant, l'axe optique du premier dispositif de reconnaissance de panneau, l'axe optique du second dispositif de reconnaissance de panneau, et les axes optiques haut/bas des éléments de maintien de composant individuels sont groupés dans une ligne droite généralement identique.

10. Appareil de montage de composant selon la revendication 7, comprenant en outre :

un robot X-Y pour déplacer la tête de placement de composant vers l'arrière et vers l'avant le long d'une direction d'axe X ou d'une direction d'axe Y, ces directions étant celles s'étendant approximativement le long d'une surface du panneau de montage de composant maintenu par l'élément de maintien de composant et généralement orthogonales les unes aux autres,

dans lequel une inclinaison de la tête de placement de composant comprend une inclinaison de position de la tête de placement de composant par rapport à la direction d'axe X ou à la direction d'axe Y provoquée par le mouvement de la tête de placement de composant le long de la direction d'axe X ou de la direction d'axe Y par le robot X-Y.

11. Appareil de montage de composant selon la revendication 7, dans lequel

après le positionnement du panneau de référence de reconnaissance des marques de référence sur le dispositif de maintien de panneau, l'unité de commande est opérationnelle pour exécuter des opérations pour reconnaître au moins deux des marques de référence du panneau de référence par le premier dispositif de reconnaissance de panneau pour déterminer les coordonnées de position des deux marques de référence, pour calculer une inclinaison de la posture de positionnement du panneau de référence par des coordonnées de commande numérique des deux marques de référence et des coordonnées de position, et pour calculer l'inclinaison de la tête dans chaque position de reconnaissance à l'aide des coordonnées de position individuelles des marques de référence reconnues par le premier dispositif de reconnaissance de panneau, les coordonnées de position individuelles des marques de référence différenciées reconnues par le second dispositif de reconnaissance de panneau, et l'inclinaison de la posture de positionnement du panneau de référence.

12. Appareil de montage de composant selon la revendication 7, dans lequel

l'unité de commande est opérationnelle pour exécuter les opérations pour déterminer les différences entre des coordonnées de position des marques de référence individuelles reconnues par le premier dispositif de reconnaissance de panneau et les coordonnées individuelles de commande numérique en tant que valeurs de correction, pour obtenir des coordonnées de commande numérique d'au moins deux marques de calcul de position de référence de panneau du panneau de montage de composant ; pour sélectionner les marques de référence situées à proximité des deux marques de calcul de position de référence de panneau parmi les marques de référence reconnues, pour déterminer les valeurs décalées respectives sur les marques de référence sélectionnées individuelles en effectuant la transformée de coordonnées des coordonnées de position des marques de référence sélectionnées, de sorte que les valeurs de correction pour les marques de référence sélectionnées deviennent nulles ou sensiblement nulles ; pour reconnaître au moins deux marques de calcul de la position de référence de panneau du panneau de montage de composant par le premier dispositif de reconnaissance de panneau, pour déterminer les coordonnées de position respectives des deux marques de calcul de la position de référence de panneau, dans un état dans lequel le panneau de montage de composant est maintenu sur le dispositif de maintien de panneau et positionné dans la région de placement de composant au lieu du panneau de référence de reconnaissance de marque de référence, pour corriger les coordonnées de commande numérique des deux marques de calcul de la position de référence de panneau basées sur les coordonnées de position des deux marques de calcul de la position de référence de panneau, et corriger les coordonnées de position de la position de placement de composant basée sur la valeur décalée de la marque de référence la plus proche du premier dispositif de reconnaissance de composant et la valeur de correction de position de l'élément de maintien de composant dérivée de l'inclinaison de la tête de placement de composant dans la position de la marque de référence pertinente, lorsque le composant maintenu par l'élément de maintien de composant de la tête de placement de composant est positionné au-dessus de chaque position de montage de composant du panneau de montage de composant, puis réaliser le positionnement du composant dans la position de placement du composant basée sur les coordonnées de position corrigées de la position de placement du composant.

13. Appareil de montage de composant selon l'une quelconque des revendications 7 à 12, dans lequel

l'unité de commande est opérationnelle pour exécuter des opérations pour reconnaître au moins deux des marques de référence du panneau de référence de reconnaissance des marques de référence par le premier dispositif de reconnaissance de panneau pour déterminer les coordonnées de position des deux marques de référence après le positionnement du panneau de référence sur le dispositif de maintien de panneau, pour déterminer les différences entre les coordonnées de commande numérique des deux marques de référence et des coordonnées de position de celles-ci, pour réaliser la transformée de coordonnées des coordonnées de commande numérique des marques de référence individuelles sur le panneau de référence en tournant ou en décalant un graphe dérivé de l'interconnexion des deux marques de référence, de sorte que les différences individuelles deviennent nulles ou sensiblement nulles, pour réaliser l'alignement entre le premier dispositif de reconnaissance de panneau et les marques de référence individuelles sur la base des coordonnées de commande numérique de transformée de coordonnées des marques de référence individuelles et pour réaliser la reconnaissance des marques de référence individuelles et leurs marques de référence différenciées de manière correspondante pour déterminer les coordonnées de position de celles-ci, et déterminer les différences entre les coordonnées de position des marques de référence individuelles et leurs marques de référence différenciées en correspondance, en calculant ainsi une inclinaison de la tête de placement de composant dans chacune des positions de reconnaissance par rapport à la direction de mouvement.

Fig. 1

EP 1 671 525 B1

*Fig.2*

*Fig. 3*

EP 1 671 525 B1

Fig. 4

EP 1 671 525 B1

## Fig. 5

*Fig. 6*

| | |
|---|---|
| 120 — X-Y ROBOT (INCLUDING COMPONENT PLACING HEAD) | |
| 140 — BOARD RECOGNITION CAMERA | 170 |
| 150 — COMPONENT RECOGNITION CAMERA | CONTROL UNIT — 173 |
| 180 — COMPONENT FEEDING UNIT | 171 |
| 190 — BOARD CONVEYANCE UNIT | |

*Fig. 7*

136    131

1361

*Fig. 8*

136

1361    121

## Fig.9

136 140
1361 121
61
REFERENCE MARK
POSITIONING DISPLACEMENT

## Fig.10

480mm
201 200

NUMBER OF REFERENCE MARKS :
25×23=575

440mm
460mm
201
20mm

201
510mm
20mm

## Fig.11

```
                        (  START  )
                            |
S1  |  POSITION REFERENCE-MARK-RECOGNIZING REFERENCE BOARD  |
                            |
S2  |  RECOGNIZE POSITION COORDINATE OF REFERENCE MARKS  |
                            |
S3  |  OBTAIN POSITION COORDINATES OF RECOGNIZED REFERENCE MARKS  |
                            |
S4  |  OBTAIN DIFFERENCE BETWEEN NC COORDINATES AND POSITION
       COORDINATES OF REFERENCE MARKS AS CORRECTION VALUES  |
                            |
S5  |  OBTAIN NC COORDINATES FOR POSITION COORDINATES OF AT LEAST
       TWO BOARD-REFERENCE-POSITION CALCULATION MARKS OF
       COMPONENT MOUNTING BOARD  |
                            |
S6  |  EXTRACT REFERENCE MARK LOCATED NEAR TO TWO
       BOARD-REFERENCE-POSITION CALCULATION MARKS  |
                            |
S7  |  OBTAIN OFFSET VALUE OF REFERENCE MARK BY SUBJECTING
       POSITION COORDINATE OF EXTRACTED REFERENCE MARK TO
       COORDINATE TRANSFORMATION SO THAT CORRECTION VALUE OF
       EXTRACTED REFERENCE MARK BECOME ZERO OR SUBSTANTIALLY
       ZERO  |
                            |
S8  |  POSITION COMPONENT MOUNTING BOARD IN COMPONENT
       PLACING REGION  |
                            |
S9  |  RECOGNIZE AT LEAST TWO BOARD-REFERENCE-POSITION
       CALCULATION MARKS OF COMPONENT MOUNTING BOARD AND
       OBTAIN POSITION COORDINATES OF RECOGNIZED TWO
       BOARD-REFERENCE-POSITION CALCULATION MARKS  |
                            |
S10 |  CORRECT NC COORDINATES OF TWO BOARD-REFERENCE-POSITION
       CALCULATION MARKS BASED ON POSITION COORDINATES OF OBTAINED
       TWO BOARD-REFERENCE-POSITION CALCULATION MARKS  |
                            |
S11 |  CORRECT COMPONENT PLACING POSITION BASED ON OFFSET VALUES
       OF REFERENCE MARK LOCATED NEAREST TO RECOGNIZING DEVICE
       PROVIDED FOR COMPONENT PLACING HEAD  |
                            |
S12 |  PLACING COMPONENT IN COMPONENT PLACING POSITION  |
                            |
                        (   END   )
```

## Fig. 12

## Fig. 13

*Fig.14*

*Fig.15*

# Fig. 16

ORIGINAL DATA OF AREA OFFSET

*Fig.17*

201

## Fig.18

AREA OFFSET DATA AFTER CONVERSION

*Fig.19*

202-1  61S  202-2

*Fig.20*

AREA OFFSET DATA AFTER CONVERSION

Fig. 21

202-1   61L                202-2

Fig. 22

## Fig. 23

## Fig. 24

| S13A | SELECT TYPE PROGRAM FOR AREA OFFSET MEASUREMENT |
| S13B | SET GLASS BOARD |
| S13C | START REFERENCE MARK RECOGNITION OPERATION |

# Fig. 25

| | |
|---|---|
| S21 | SELECT TYPE (TRANSFER PROGRAM) |
| S22 | CALCULATE REFERENCE MARK POSITION BY CORRESPONDING PROGRAM |
| S23 | EXTRACT REFERENCE MARKS (TWO POINTS) LOCATED NEAREST TO BOARD MARK POSITION FROM GRID ON GLASS BOARD |
| S24 | OBTAIN PARALLEL DEVIATION AND INCLINATION FROM RECOGNITION RESULTS OF REFERENCE MARKS AT TWO POINTS |
| S25 | CORRECT RECOGNITION RESULTS OF REFERENCE MARKS IN POSITIONS INCLUDING BOARD AREAS BY PARALLEL DEVIATION AND INCLINATION AND STORE RESULTS |

# Fig. 26

| | |
|---|---|
| S31 | OBTAIN MARK RECOGNITION MOVEMENT POSITION AND PLACING POSITION |
| S32 | ADD OFFSET VALUES OF AREA CORRESPONDING TO MOVEMENT POSITION OF STEP S31 |

*Fig. 27*

*Fig.28*

*Fig.29*

Fig.30

| · ANGLE 0° |
| · ANGLE 90° |
| · ANGLE 180° |
| · ANGLE 270° |

AMOUNT OF PLACING DISPLACEMENT

AMOUNT OF PLACING DISPLACEMENT

Fig.31

*Fig.32*

*Fig.33*

Fig. 34

VISUAL FIELD CENTER
OF CAMERA

## Fig. 35

S51 | START BOARD MARK RECOGNITION OPERATION

S52 | OBTAIN AREA OFFSET VALUES OF AREA CORRESPONDING TO FIRST NOZZLE POSITION MEASUREMENT POSITION IN CAMERA CALIBRATION STAGE

S53 | OBTAIN AREA OFFSET VALUES OF AREA CORRESPONDING TO BOARD CAMERA OFFSET VALUE MEASUREMENT POSITION IN CAMERA CALIBRATION STAGE

S54 | ADD DIFFERENCES BETWEEN AREA OFFSET VALUES OBTAINED IN S52 AND S53 (AREA OFFSET VALUES OF S53-AREA OFFSET VALUES OF S52) TO BOARD CAMERA OFFSET VALUES

S55 | OBTAIN BOARD MARK RECOGNITION MOVEMENT POSITION BY USING BOARD CAMERA OFFSET VALUES OF S54

S56 | OBTAIN AREA OFFSET VALUES OF AREA CORRESPONDING TO MOVEMENT POSITION OBTAINED IN S55

S57 | OBTAIN AREA OFFSET VALUES OF AREA CORRESPONDING TO MOVEMENT POSITION OBTAINED IN S56

S58 | MOVE BOARD CAMERA TO MOVEMENT POSITION OBTAINED IN S57

# Fig.36

| | |
|---|---|
| S61 | START COMPONENT PLACING OPERATION |
| S62 | OBTAIN AREA OFFSET VALUE CORRESPONDING TO AREA OF FIRST NOZZLE POSITION MEASUREMENT POSITION IN CAMERA CALIBRATION STAGE |
| S63 | OBTAIN AREA OFFSET VALUE CORRESPONDING TO AREA OF NOZZLE PITCH MEASUREMENT POSITION FOR n-TH NOZZLE IN CAMERA CALIBRATION STAGE |
| S64 | ADD DIFFERENCES BETWEEN AREA OFFSET VALUES OBTAINED IN S62 AND S63 (AREA OFFSET VALUE OF S63 - AREA OFFSET VALUE OF S62) TO NOZZLE PITCH OF n-TH NOZZLE |
| S65 | OBTAIN COMPONENT PLACING POSITION BY USING NOZZLE PITCH OF S64 |
| S66 | OBTAIN AREA OFFSET VALUE OF AREA CORRESPONDING TO MOVEMENT POSITION OBTAINED IN S65 |
| S67 | OBTAIN AREA OFFSET VALUE OF AREA CORRESPONDING TO MOVEMENT POSITION OBTAINED IN S66 |
| S68 | MOVE NOZZLE TO MOVEMENT POSITION OBTAINED IN S67 |

## Fig. 37A

## Fig. 37B

## Fig. 37C

# Fig.38

1361-n

1361-1

140

NOZZLE PITCH OF n-TH
NOZZLE

BOARD CAMERA
OFFSET VALUE

Fig. 39

EP 1 671 525 B1

# Fig. 40

EP 1 671 525 B1

EP 1 671 525 B1

*Fig. 41*

*Fig. 42*

Fig.43

EP 1 671 525 B1

Fig. 44

Fig. 45

# Fig.46

```
                          ( START )
                             |
S71  |          SET GLASS BOARD                    |
                             |
S72  | RECOGNIZE POSITION COORDINATES OF REFERENCE MARKS |
     |     IN TYPICAL TWO POINTS ON GLASS BOARD          |
                             |
S73  | CALCULATE INCLINATION AMOUNT OF WHOLE-GLASS BOARD |
     | IN SET POSITION OF GLASS BOARD FROM RECOGNITION   |
     |                    RESULT                         |
                             |
S74  | READ INDIVIDUAL REFERENCE MARKS ON GLASS BOARD BY |
     |  BOARD CAMERA BASED ON NC COORDINATE POSITIONS,   |
     |  AND READ INDIVIDUAL REFERENCE MARKS POSITIONED   |
     |    WITHIN VISUAL FIELD OF CORRECTION CAMERA       |
                             |
S75  |  CALCULATE OFFSET VALUE AND YAWING VALUE OF HEAD  |
                             |
                          (  END  )
```

# Fig.47

```
                    (  START  )
                         |
┌────────────────────────────────────────────────────┐
│      OBTAIN NC COORDINATES FOR POSITION COORDINATES OF │
│ S81  AT LEAST TWO BOARD-REFERENCE-POSITION CALCULATION │
│          MARKS OF COMPONENT MOUNTING BOARD           │
└────────────────────────────────────────────────────┘
                         |
┌────────────────────────────────────────────────────┐
│      SELECT AREA OFFSET DATA IN VICINITY OF TWO BOARD │
│ S82               REFERENCE POSITION                 │
└────────────────────────────────────────────────────┘
                         |
┌────────────────────────────────────────────────────┐
│      PERFORM COORDINATE TRANSFORMATION OF AREA OFFSET │
│ S83  DATA SELECTED SO THAT SELECTED AREA OFFSET VALUES │
│           BECOME ZERO OR SUBSTANTIALLY ZERO          │
└────────────────────────────────────────────────────┘
                         |
                    (   END   )
```

# Fig.48

```
                    ( START )
                         │
    ┌────────────────────────────────────────────┐
S91 │     SET COMPONENT MOUNTING BOARD TO COMPONENT │
    │              PLACING REGION                   │
    └────────────────────────────────────────────┘
                         │
    ┌────────────────────────────────────────────┐
    │  RECOGNIZE AT LEAST TWO BOARD-REFERENCE-POSITION │
S92 │  CALCULATION MARKS OF COMPONENT MOUNTING BOARD,  │
    │  AND DETERMINE POSITION COORDINATES OF RECOGNIZED│
    │  TWO BOARD-REFERENCE-POSITION CALCULATION MARKS  │
    └────────────────────────────────────────────┘
                         │
    ┌────────────────────────────────────────────┐
    │     PERFORM COORDINATE TRANSFORMATION OF NC     │
    │     COORDINATES OF COMPONENT MOUNTING BOARD     │
S93 │        BASED ON POSITION COORDINATES OF TWO     │
    │   BOARD-REFERENCE-POSITION CALCULATION MARKS    │
    └────────────────────────────────────────────┘
                         │
    ┌────────────────────────────────────────────┐
    │ SELECT TRANSFORMED OFFSET VALUE AND YAWING VALUE│
    │ IN POSITION OF BOARD RECOGNITION CAMERA RESULTING│
S94 │    WHEN HEAD IS POSITIONED IN COMPONENT PLACING │
    │                  POSITION                      │
    └────────────────────────────────────────────┘
                         │
    ┌────────────────────────────────────────────┐
    │ PERFORM CORRECTION OF COMPONENT PLACING POSITION│
S95 │     BY USING SELECTED AREA OFFSET VALUE AND     │
    │                 YAWING VALUE                   │
    └────────────────────────────────────────────┘
                         │
                    ( END )
```

# Fig.49

```
                    ┌─────────────────┐
                    │      START       │
                    └─────────────────┘
                             │
S101  ┌──────────────────────────────────────────────────────┐
      │                  SET GLASS BOARD                       │
      └──────────────────────────────────────────────────────┘
                             │
S102  ┌──────────────────────────────────────────────────────┐
      │ RECOGNIZE POSITION COORDINATES OF REFERENCE MARKS      │
      │ IN TYPICAL TWO POINTS ON GLASS BOARD BY BOARD          │
      │ RECOGNITION CAMERA                                     │
      └──────────────────────────────────────────────────────┘
                             │
S103  ┌──────────────────────────────────────────────────────┐
      │ CALCULATE SETTING POSITION DISPLACEMENT                │
      │ (PARALLEL DEVIATION, INCLINATION) OF GLASS BOARD       │
      │ FROM RECOGNITION RESULT                                │
      └──────────────────────────────────────────────────────┘
                             │
S104  ┌──────────────────────────────────────────────────────┐
      │ PERFORM NC COORDINATE TRANSFORMATION OF INDIVIDUAL     │
      │ REFERENCE MARKS ON GLASS BOARD BASED ON SETTING        │
      │ POSITION DISPLACEMENT                                  │
      └──────────────────────────────────────────────────────┘
                             │
S105  ┌──────────────────────────────────────────────────────┐
      │ READ INDIVIDUAL REFERENCE MARKS ON GLASS BOARD BY      │
      │ BOARD CAMERA BASED ON NC COORDINATE POSITION,          │
      │ AND READ INDIVIDUAL REFERENCE MARKS POSITIONED         │
      │ WITHIN VISUAL FIELD OF CORRECTION CAMERA               │
      └──────────────────────────────────────────────────────┘
                             │
S106  ┌──────────────────────────────────────────────────────┐
      │ CALCULATE OFFSET VALUE AND YAWING VALUE OF HEAD        │
      └──────────────────────────────────────────────────────┘
                             │
                    ┌─────────────────┐
                    │       END        │
                    └─────────────────┘
```